# EUROPEAN PATENT SPECIFICATION

(11) **EP 3 630 918 B1**
(45) Date of publication and mention of the grant of the patent: **10.05.2023**
(21) Application number: 18727816.3
(22) Date of filing: 01.06.2018
(51) Int. Cl.: C09K 11/02, H01L 33/50, C09K 11/88, C09K 11/70, C09K 11/06, C09K 11/56

(54) **LUMINESCENT PARTICLES COMPRISING ENCAPSULATED NANOPARTICLES AND USES THEREOF**
LUMINESZIERENDE PARTIKEL ENTHALTEND VERKAPSELTE NANOPARTIKEL UND VERWENDUNGEN DAVON
NANOPARTICULES ENCAPSULÉES DE MANIÈRE UNIFORME ET LEURS UTILISATIONS

(30) Priority: 02.06.2017 US 201762514297 P; 02.06.2017 US 201762514422 P; 02.06.2017 US 201762514601 P; 22.09.2017 EP 17306246; 22.09.2017 EP 17306247; 22.09.2017 EP 17306248; 22.09.2017 EP 17306241; 22.09.2017 EP 17306249; 11.12.2017 EP 17206479; 22.12.2017 US 201762609932 P; 16.02.2018 US 201862710298 P; 13.03.2018 US 201862642370 P
(43) Date of publication of application: 08.04.2020
(73) Proprietor: Nexdot, 93230 Romainville (FR)
(72) Inventor: D'AMICO, Michele, 93230 Romainville (FR); KUNTZMANN, Alexis, 93230 Romainville (FR); FAIDEAU, Robin, 78800 Houilles (FR)
(74) Representative: Icosa
(86) International application number: PCT/EP2018/064440
(87) International publication number: WO 2018/220166

(56) References cited:
- US-A1- 2010 224 831
- US-A1- 2011 068 321
- US-A1- 2013 075 692
- US-A1- 2016 139 137
- US-A1- 2017 096 599

## Description

### FIELD OF INVENTION

The present invention pertains to the field of luminescent particles. In particular, the invention relates to luminescent particles comprising particles encapsulating luminescent nanoparticles in an inorganic material.

### BACKGROUND OF INVENTION

To represent the colors in all their variety, one proceeds typically by additive synthesis of at least three complementary colors, especially red, green and blue. In a chromaticity diagram, the subset of available colors obtained by mixing different proportions of these three colors is formed by the triangle formed by the three coordinates associated with the three colors red, green and blue. This subset constitutes what is called a gamut. The majority of color display devices operate on this three-color principle: each pixel consists of three sub-pixels, one red, one green and one blue, whose mixture with different intensities can reproduce a colorful impression.

A luminescent or backlit display such as a computer LCD screen has to present the widest possible gamut for an accurate color reproduction. For this, the composing sub-pixels must be of the most saturated colors possible in order to describe the widest possible gamut. A sub-pixel has a saturated color if it is close to a monochromatic color. From a spectral point of view, this means that the light emitted by the source is comprised of a single narrow fluorescence band of wavelengths. A highly saturated shade has a vivid, intense color while a less saturated shade appears rather bland and gray.

It is therefore important to have sub-pixels whose emission spectra are narrow and with saturated colors.

Luminescent inorganic nanoparticles, especially semiconductor nanoparticles, commonly called "quantum dots", are known as emissive material. Semiconductor nanoparticles have a narrow fluorescence spectrum, approximately 30 nm full width at half maximum, and offer the possibility to emit in the entire visible spectrum as well as in the infrared with a single excitation source in the ultraviolet. Luminescent inorganic nanoparticles, especially semiconductor nanoparticles, are currently used in display devices as phosphors.

However, there is a real need for materials to be used in display devices and lighting devices, these materials having a high stability in time and in temperature, under a high photon flux. In addition, there is a need for materials having a high stability for long term use when deposited on diodes, or Light Emitting Diodes (LED).

To ensure a high long term stability, further chemical reaction between the surface of nanoparticles and environmental deteriorating species such as water, oxygen or other harmful compounds, must be prevented during their use. However, the ligands commonly used to functionalize the surface of quantum dots do not protect efficiently said surface against reactions with deteriorating species or harmful compounds and thus do not enable the long-term performance required for display or lighting devices.

It is known to coat nanoparticles with a protective shell, i.e. to encapsulate nanoparticles in another material, to prevent deteriorating species or harmful compounds from reaching said nanoparticles surface. Silica is known to be an insulating protective material for nanoparticles. Furthermore, particles encapsulating nanoparticles in an insulating protective material can act as scatterers in the sub-pixels. This results in the scattering of the light emitted by the light source in all parts of the sub-pixels and then the scattering of the light emitted by sub-pixels so that said light can be emitted in all directions.

For example, US patent US 9,425,365 discloses the encapsulation of quantum dots, including a nanocrystalline core and a nanocrystalline shell, in mesoporous silica using a reverse micellar method. The obtained particles are mesoporous silica nanoparticles, each comprising only one quantum dot. However, said particles are mesoporous which means that they comprise a porous network of silica that allows access to the quantum dots surface for deteriorating species, like water and oxygen, or other harmful compounds. The protection of said surface is thus ineffective and does not enable a long-term stability in time and temperature. Patent application US 2011/068321 discloses secondary particles comprising a secondary matrix material, wherein the secondary particles comprise a plurality of primary particles comprising a primary matrix material and quantum dots.

Gui et al. discloses the encapsulation of multiple PbSe quantum dots in silica particles using a base-catalyzed sol-gel method (Analyst, 2013, 138, 5956). However, said PbSe quantum dots are aggregated in the silica particles, resulting in a decrease of the photoluminescence quantum yield.

The silica particles are porous, allowing access to the quantum dots surface for deteriorating species, like water, oxygen or other harmful compounds.

Patent application KR20130043442 discloses quantum dots encapsulated in silica using aerosol. However, the resulting particles are not well defined and are aggregated, resulting in a silica matrix-like material comprising quantum dots. Said material will not allow for a good dispersion in a host material in view of an application as a sub-pixel.

The protection of nanoparticles from deteriorating species or harmful compounds will be more effective if said nanoparticles are protected by more than one inorganic material. Indeed, a double encapsulation, i.e. encapsulating nanoparticles in an inorganic material and dispersing the resulting particle in another inorganic material, will better prevent the diffusion of deteriorating species or harmful compounds to the surface of the nanoparticles as each inorganic material can act as a barrier against said deteriorating species or harmful compounds.

It is therefore an object of the present invention to provide luminescent particles comprising first material and at least one particle comprising a second material and at least one nanoparticle dispersed in said second material.

The encapsulated particles that may not be spherical, which is a drawback for many applications, can be rendered spherical by their encapsulation in a bigger particle.

Said luminescent particles having one or more of the following advantages: coupling the properties of different particles encapsulated in the same luminescent particle; preventing a decrease of the properties of encapsulated nanoparticles; enhanced stability over temperature, environment variations and deteriorating species like water and oxygen, or other harmful compounds attacks; capable of scattering the light emitted by a light source and the light resulting from the excitation of said luminescent particles, enhanced photoluminescence quantum yield, enhanced resistance to photobleaching and enhanced resistance to photon flux.

Said luminescent particles can also easily comply with ROHS requirements depending on the first and second materials selected. It is a great advantage to have ROHS compliant particles while preserving the properties of encapsulated nanoparticles. that may not be ROHS compliant themselves.

Furthermore, said luminescent particles are tailored to be air processable allowing an easy manipulation, transport and use of said luminescent particle in a device such as an optoelectronic device.

### SUMMARY

The present invention relates to a luminescent particle comprising a first material, wherein the luminescent particle comprises a plurality of particles comprising a second material and at least one nanoparticle dispersed in said second material; wherein the first material and the second material have a bandgap superior or equal to 3 eV; wherein the plurality of particles is dispersed in the first material, wherein the first material and the second material are selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, iridium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof, wherein the at least one nanoparticle is a luminescent nanoparticle, and wherein the loading charge of particles in said luminescent particle is at least 10%, said loading charge being the mass ratio between the mass of particles comprised in a luminescent particle and the mass of said luminescent particle. In one embodiment, the second material is selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, iridium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof. In one embodiment, the first material prevents the diffusion of outer molecular species or fluids (liquid or gas) into said first material. In one embodiment, the first material has a density ranging from 1 g/cm³ to 10 g/cm³. In one embodiment, the first material has a density superior or equal to the density of the second material. In one embodiment, the first material has a thermal conductivity at standard conditions of at least 0.1 W/(m.K). In one embodiment, the at least one nanoparticle is a semiconductor nanocrystal. In one embodiment, the semiconductor nanocrystal comprises a core comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0. In one embodiment, the semiconductor nanocrystal comprises at least one shell comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0. In one embodiment, the semiconductor nanocrystal comprises at least one crown comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0. In one embodiment, the semiconductor nanocrystal is a semiconductor nanoplatelet.

The present invention also relates to a light emitting material comprising at least one host material and at least one luminescent particle, wherein said at least one luminescent particle is dispersed in the at least one host material. In one embodiment, the host material comprises an inorganic material, a polymer such as a co-polymer, a block co-polymer, or a silicone-based polymer, a resin such as an epoxy resin or a mixture thereof. In one embodiment, the host material has a thermal conductivity at standard conditions of at least 0.1 W/(m.K).

The present invention also relates to a support supporting at least one luminescent particle or a light emitting material. In one embodiment, the support is a LED chip or microsized LED.

The present invention also relates to an optoelectronic device comprising at least one luminescent particle or a light emitting material.

### DEFINITIONS

In the present invention, the following terms have the following meanings:
- **"Array"** refers to a series, a matrix, an assemblage, an organization, a succession, a collection or an arrangement of elements or items, wherein said elements or items are arranged in a particular way.
- **"Backlight unit"** refers to a unit comprising at least one light source configured to emit primary light and a polarizer configured to polarize said primary light. Said **"backlight unit"** is configured to provide said polarized light to the liquid crystal layer, the color filter layer and the second polarizer. As said polarized light pass through the liquid crystal layer and the color filter layer, only the selected protion of the primary light will be transmitted through the second polarizer, such that an image can be viewed by the viewer. Said **"backlight unit"** is preferably located to the back of a LCD Panel, before the liquid crystal layer.
- **"Core"** refers to the innermost space within a particle.
- **"Shell"** refers to at least one monolayer of material coating partially or totally a core.
- **"Encapsulate"** refers to a material that coats, surrounds, embeds, contains, comprises, wraps, packs, or encloses a plurality of particles.
- **"Uniformly dispersed"** refers to particles that are not aggregated, do not touch, are not in contact, and are separated by an inorganic material. Each particle is spaced from their adjacent particles by an average minimal distance.
- **"Colloidal"** refers to a substance in which particles are dispersed, suspended and do not settle or would take a very long time to settle appreciably, but are not soluble in said substance.
- **"Colloidal particles"** refers to particles that may be dispersed, suspended and which would not settle or would take a very long time to settle appreciably in another substance, typically in an aqueous or organic solvent, and which are not soluble in said substance. **"Colloidal particles"** does not refer to particles grown on substrate.
- **"Impermeable"** refers to a material that limits or prevents the diffusion of outer molecular species or fluids (liquid or gas) into said material.
- **"Permeable"** refers to a material that allows the diffusion of outer molecular species or fluids (liquid or gas) into said material.
- **"Outer molecular species or fluids (liquid or gas)"** refers to molecular species or fluids (liquid or gas) coming from outside a material or a particle.
- **"Adjacent particle"** refers to neighbouring particles in a space or a volume, without any other particle between said adjacent particles.
- **"Packing fraction"** refers to the volume ratio between the volume filled by an ensemble of objects into a space and the volume of said space. The terms packing fraction, packing density and packing factor are interchangeable in the present invention.
- **"Loading charge"** refers to the mass ratio between the mass of an ensemble of objects comprised in a space and the mass of said space.
- **"Population of particles"** refers to a statistical set of particles having the same maximum emission wavelength.
- **"Statistical set"** refers to a collection of at least 2, 3, 4, 5, 6, 7, 8, 9, 10, 11, 12, 13, 14, 15, 16, 17, 18, 19, 20, 30, 40, 50, 60, 70, 80, 90, 100, 150, 200, 250, 300, 350, 400, 450, 500, 550, 600, 650, 700, 750, 800, 850, 900, 950, or 1000 objects obtained by the strict same process. Such statistical set of objects allows determining average characteristics of said objects, for example their average size, their average size distribution or the average distance between them.
- **"Surfactant-free"** refers to a particle that does not comprise any surfactant and was not synthesized by a method comprising the use of surfactants.
- **"Optically transparent"** refers to a material that absorbs less than 10%, 5%, 2.5%, 1%, 0.99%, 0.98%, 0.97%, 0.96%, 0.95%, 0.94%, 0.93%, 0.92%, 0.91%, 0.9%, 0.89%, 0.88%, 0.87%, 0.86%, 0.85%, 0.84%, 0.83%, 0.82%, 0.81%, 0.8%, 0.79%, 0.78%, 0.77%, 0.76%, 0.75%, 0.74%, 0.73%, 0.72%, 0.71%, 0.7%, 0.69%, 0.68%, 0.67%, 0.66%, 0.65%, 0.64%, 0.63%, 0.62%, 0.61%, 0.6%, 0.59%, 0.58%, 0.57%, 0.56%, 0.55%, 0.54%, 0.53%, 0.52%, 0.51%, 0.5%, 0.49%, 0.48%, 0.47%, 0.46%, 0.45%, 0.44%, 0.43%, 0.42%, 0.41%, 0.4%, 0.39%, 0.38%, 0.37%, 0.36%, 0.35%, 0.34%, 0.33%, 0.32%, 0.31%, 0.3%, 0.29%, 0.28%, 0.27%, 0.26%, 0.25%, 0.24%, 0.23%, 0.22%, 0.21%, 0.2%, 0.19%, 0.18%, 0.17%, 0.16%, 0.15%, 0.14%, 0.13%, 0.12%, 0.11%, 0.1%, 0.09%, 0.08%, 0.07%, 0.06%, 0.05%, 0.04%, 0.03%, 0.02%, 0.01%, 0.009%, 0.008%, 0.007%, 0.006%, 0.005%, 0.004%, 0.003%, 0.002%, 0.001%, 0.0009%, 0.0008%, 0.0007%, 0.0006%, 0.0005%, 0.0004%, 0.0003%, 0.0002%, 0.0001%, or 0% of light at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.
- **"Roughness"** refers to a surface state of a particle. Surface irregularities can be present at the surface of particles and are defined as peaks or cavities depending on their relative position respect to the average particle surface. All said irregularities constitute the particle roughness. Said roughness is defined as the height difference between the highest peak and the deepest cavity on the surface. The surface of a particle is smooth if they are no irregularities on said surface, i.e. the roughness is equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said particle.
- **"Polydisperse"** refers to particles or droplets of varied sizes, wherein the size difference is superior or equal to 20%.
- **"Monodisperse"** refers to particles or droplets, wherein the size difference is inferior than 20%, 15%, 10%, preferably 5%.
- **"Narrow size distribution"** refers to a size distribution of a statistical set of particles less than 1%, 2%, 3%, 4%, 5%, 6%, 7%, 8%, 9%, 10%, 15%, 20%, 25%, 30%, 35%, or 40% of the average size.
- **"Partially"** means incomplete. In the case of a ligand exchange, partially means that 5%, 10%, 15%, 20%, 25%, 30%, 35%, 40%, 45%, 50%, 55%, 60%, 65%, 70%, 75%, 80%, 85%, 90%, 95% of the ligands at the surface of a particle have been successfully exchanged.
- The terms **"Film", "Layer"** or **"Sheet"** are interchangeable in the present invention.
- **"Nanoplatelet"** refers to a 2D shaped nanoparticle, wherein the smallest dimension of said nanoplatelet is smaller than the largest dimension of said nanoplatelet by a factor (aspect ratio) of at least 1.5, at least 2, at least 2.5, at least 3, at least 3.5, at least 4, at least 4.5, at least 5, at least 5.5, at least 6, at least 6.5, at least 7, at least 7.5, at least 8, at least 8.5, at least 9, at least 9.5 or at least 10.
- **"Free of oxygen"** refers to a formulation, a solution, a film, or a composition that is free of molecular oxygen, O₂, i.e. wherein molecular oxygen may be present in said formulation, solution, film, or composition in an amount of less than about 10 ppm, 5 ppm, 4 ppm, 3 ppm, 2 ppm, 1 ppm, 500 ppb, 300 ppb or in an amount of less than about 100 ppb in weight.
- **"Free of water"** refers to a formulation, a solution, a film, or a composition that is free of molecular water, H₂O, i.e. wherein molecular water may be present in said formulation, solution, film, or composition in an amount of less than about 100 ppm, 50 ppm, 10 ppm, 5 ppm, 4 ppm, 3 ppm, 2 ppm, 1 ppm, 500 ppb, 300 ppb or in an amount of less than about 100 ppb in weight.
- **"Pixel pitch"** refers to the distance from the center of a pixel to the center of the next pixel.
- **"Curvature"** refers to the reciprocal of the radius.
- **"ROHS compliant"** refers to a material compliant with Directive 2011/65/EU of the European Parliament and of the Council of 8 June 2011 on the restriction of the use of certain hazardous substances in electrical and electronic equipment.
- **"Standard conditions"** refers to the standard conditions of temperature and pressure, i.e. 273.15 K and 10⁵ Pa respectively.
- **"Display apparatus"** refers to an apparatus or a device that displays an image signal. Display devices or display apparatus include all devices that display an image, a succession of pictures or a video such as, non-limitatively, a LCD display, a television, a projector, a computer monitor, a personal digital assistant, a mobile phone, a laptop computer, a tablet PC, an MP3 player, a CD player, a DVD player, a Blu-Ray player, a head mounted display, glasses, a helmet, a headgear, a headwear, a smart watch, a watch phone or a smart device.
- **"Primary light"** refers to the light supplied by a light source. For example, primary light refers to the light supplied to the light emitting material by the light source.
- **"Secondary light"** refers to the light emitted by a material in response to an excitation. Said excitation is generally provided by the light source, i.e. the excitation is the incident light. For example, secondary light refers to the light emitted by the luminescent particles, the light emitting material or the color conversion layer in response to an excitation of the particles comprised in said luminescent particles.
- **"Resulting light"** refers to the light supplied by a material after excitation by an incident light and emission of a secondary light. For example, resulting light refers to the light supplied by the luminescent particles, the light emitting material or the color conversion layer and is a combination of a part of the incident light and the secondary light.
- **"Surrounding medium"** refers to the medium in which the luminescent particles of the present invention are dispersed, or the medium which surrounds partially or totally said luminescent particles. It may be a fluid (liquid, gas) or a solid host material.

### DETAILED DESCRIPTION

The following detailed description will be better understood when read in conjunction with the drawings. For the purpose of illustrating, the particle is shown in the preferred embodiments. It should be understood, however that the application is not limited to the precise arrangements, structures, features, embodiments, and aspect shown. The drawings are not drawn to scale and are not intended to limit the scope of the claims to the embodiments depicted. Accordingly it should be understood that where features mentioned in the appended claims are followed by reference signs, such signs are included solely for the purpose of enhancing the intelligibility of the claims and are in no way limiting on the scope of the claims.

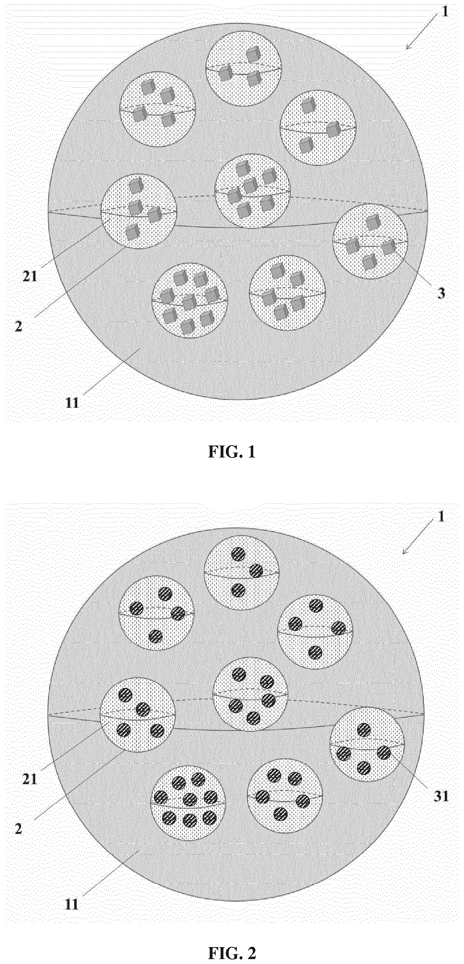

This invention relates to a particle **1,** as illustrated in Fig. 1, comprising a first material **11,** wherein the particle **1** comprises a plurality of particles **2** comprising a second material **21** and at least one luminescent nanoparticle **3** dispersed in said second material **21;** wherein the first material **11** and the second material **21** have a bandgap superior or equal to 3 eV, wherein the plurality of particles **2** is dispersed in the first material **11**, wherein the first material **11** and the second material **21** are selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, iridium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof, wherein the at least one nanoparticle **3** is a luminescent nanoparticle, and wherein the loading charge of particles **2** in said luminescent particle **1** is at least 10%, said loading charge being the mass ratio between the mass of particles **2** comprised in a luminescent particle **1** and the mass of said luminescent particle **1.**

The encapsulation of the at least one particle **2** in the first material **11** allows for an increased protection of the at least one nanoparticle **3** regarding the diffusion of outer molecular species or fluids (liquid or gas), especially deteriorating species like O₂ and H₂O to the surface of said nanoparticle **3.** The first material **11** acts as a supplementary barrier against outer molecular species or fluids that could impair the properties of the at least one nanoparticle **3.**

Having a bandgap superior or equal to 3eV, the first material **11** and the second material **21** are optically transparent to UV and blue light.

The "double encapsulation" of nanoparticles **3** have several advantages: i) it allows a passivation of nanoparticles **3** surface, thus a better protection of said nanoparticles **3** from temperature, environment variations and deteriorating species like water and oxygen therefore preventing the degradation of said nanoparticles 3; ii) in the case of luminescent nanoparticles **3** it helps preventing photoluminescence quantum yield decrease and photoluminescence decrease due to interaction with the environment; iii) it allows the scattering of the light emitted by a light source and the light resulting from the excitation of said nanoparticles **3.**

Luminescent particles **1** of the invention are also particularly interesting as they can easily comply with ROHS requirements depending on the first and second materials **(11, 21)** selected. It is then possible to have ROHS compliant particles while preserving the properties of nanoparticles **3.** that may not be ROHS compliant themselves.

According to one embodiment, the luminescent particle **1** is air processable. This embodiment is particularly advantageous for the manipulation or the transport of said luminescent particle **1** and for the use of said luminescent particle **1** in a device such as an optoelectronic device.

According to one embodiment, the luminescent particle **1** is compatible with standard lithography processes. This embodiment is particularly advantageous for the use of said luminescent particle **1** in a device such as an optoelectronic device.

According to one embodiment, the luminescent particle **1** is a colloidal particle.

According to one embodiment, the luminescent particle **1** does not comprise a spherical porous bead, preferably the luminescent particle **1** does not comprise a central spherical porous bead.

According to one embodiment, the luminescent particle **1** does not comprise a spherical porous bead, wherein nanoparticles **3** are linked to the surface of said spherical porous bead.

According to one embodiment, the luminescent particle **1** does not comprise a bead and nanoparticles **3** having opposite electronic charges.

According to one embodiment, the luminescent particle **1** is dispersible in aqueous solvents, organic solvents and/or mixture thereof.

According to one embodiment, the luminescent particle **1** does not comprise organic molecules or polymer chains.

According to one embodiment, the luminescent particle **1** is fluorescent.

According to one embodiment, the luminescent particle **1** is phosphorescent.

According to one embodiment, the luminescent particle **1** is electroluminescent.

According to one embodiment, the luminescent particle **1** is chemiluminescent.

According to one embodiment, the luminescent particle **1** is triboluminescent.

According to one embodiment, the features of the light emission of luminescent particle **1** are sensible to external pressure variations. In this embodiment, "sensible" means that the features of the light emission can be modified by external pressure variations.

According to one embodiment, the wavelength emission peak of luminescent particle **1** is sensible to external pressure variations. In this embodiment, "sensible" means that the wavelength emission peak can be modified by external pressure variations, i.e. external pressure variations can induce a wavelength shift.

According to one embodiment, the FWHM of luminescent particle **1** is sensible to external pressure variations. In this embodiment, "sensible" means that the FWHM can be modified by external pressure variations, i.e. FWHM can be reduced or increased.

According to one embodiment, the PLQY of luminescent particle **1** is sensible to external pressure variations. In this embodiment, "sensible" means that the PLQY can be modified by external pressure variations, i.e. PLQY can be reduced or increased.

According to one embodiment, the features of the light emission of luminescent particle **1** are sensible to external temperature variations.

According to one embodiment, the wavelength emission peak of luminescent particle **1** is sensible to external temperature variations. In this embodiment, "sensible" means that the wavelength emission peak can be modified by external temperature variations, i.e. external temperature variations can induce a wavelength shift.

According to one embodiment, the FWHM of luminescent particle **1** is sensible to external temperature variations. In this embodiment, "sensible" means that the FWHM can be modified by external temperature variations, i.e. FWHM can be reduced or increased.

According to one embodiment, the PLQY of luminescent particle **1** is sensible to external temperature variations. In this embodiment, "sensible" means that the PLQY can be modified by external temperature variations, i.e. PLQY can be reduced or increased.

According to one embodiment, the features of the light emission of luminescent particle **1** are sensible to external variations of pH.

According to one embodiment, the wavelength emission peak of luminescent particle **1** is sensible to external variations of pH. In this embodiment, "sensible" means that the wavelength emission peak can be modified by external variations of pH, i.e. external variations of pH can induce a wavelength shift.

According to one embodiment, the FWHM of luminescent particle **1** is sensible to e external variations of pH. In this embodiment, "sensible" means that the FWHM can be modified by external variations of pH, i.e. FWHM can be reduced or increased.

According to one embodiment, the PLQY of luminescent particle **1** is sensible to external variations of pH. In this embodiment, "sensible" means that the PLQY can be modified by external variations of pH, i.e. PLQY can be reduced or increased.

According to one embodiment, the luminescent particle **1** comprise at least one particle **2** wherein the wavelength emission peak is sensible to external temperature variations; and at least one particle **2** wherein the wavelength emission peak is not or less sensible to external temperature variations. In this embodiment, "sensible" means that the wavelength emission peak can be modified by external temperature variations, i.e. wavelength emission peak can be reduced or increased. This embodiment is particularly advantageous for temperature sensor applications.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 400 nm to 50 µm.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 400 nm to 500 nm. In this embodiment, the luminescent particle **1,** the particles **2,** the luminescent nanoparticle and/or the light emitting material **7,** emit blue light.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 500 nm to 560 nm, more preferably ranging from 515 nm to 545 nm. In this embodiment, the luminescent particle **1,** the particles **2,** the luminescent nanoparticle and/or the light emitting material **7,** emit green light.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 560 nm to 590 nm. In this embodiment, the luminescent particle **1,** the particles **2,** the luminescent nanoparticle and/or the light emitting material **7,** emit yellow light.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 590 nm to 750 nm, more preferably ranging from 610 nm to 650 nm. In this embodiment, the luminescent particle **1,** the particles **2,** the luminescent nanoparticle and/or the light emitting material **7,** emit red light.

According to one embodiment, the luminescent particle **1,** the particles **2,** the luminescent nanoparticle and/or the light emitting material **7,** exhibit an emission spectrum with at least one emission peak, wherein said emission peak has a maximum emission wavelength ranging from 750 nm to 50 µm. In this embodiment, the luminescent particle **1,** the particles **2,** the luminescent nanoparticle and/or the light emitting material **7,** emit near infra-red, mid-infra-red, or infra-red light.

According to one embodiment, the luminescent particle **1,** the particles **2,** the luminescent nanoparticle and/or the light emitting material **7,** exhibit emission spectra with at least one emission peak having a full width half maximum lower than 90 nm, 80 nm, 70 nm, 60 nm, 50 nm, 40 nm, 30 nm, 25 nm, 20 nm, 15 nm, or 10 nm.

According to one embodiment, the luminescent particle **1,** the particles **2,** the luminescent nanoparticle and/or the light emitting material **7,** exhibit emission spectra with at least one emission peak having a full width half maximum strictly lower than 40 nm, 30 nm, 25 nm, 20 nm, 15 nm, or 10 nm.

According to one embodiment, the luminescent particle **1,** the particles **2,** the luminescent nanoparticle and/or the light emitting material **7,** exhibit emission spectra with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

According to one embodiment, the luminescent particle **1,** the particles **2,** the luminescent nanoparticle and/or the light emitting material **7,** exhibit emission spectra with at least one emission peak having a full width at quarter maximum strictly lower than 90 nm, 80 nm, 70 nm, 60 nm, 50 nm, 40 nm, 30 nm, 25 nm, 20 nm, 15 nm, or 10 nm.

According to one embodiment, the luminescent particle **1,** the particles **2,** the luminescent nanoparticle and/or the light emitting material **7,** have a photoluminescence quantum yield (PLQY) of at least 5%, 10%, 15%, 20%, 25%, 30%, 35%, 40%, 45%, 50%, 55%, 60%, 65%, 70%, 75%, 80%, 85%, 90%, 95%, 99% or 100%.

According to one embodiment, the luminescent particle **1,** the particles **2,** the luminescent nanoparticle, the first material **11,** the second material **21,** and/or the light emitting material **7,** absorb the incident light with wavelength lower than 50 µm, 40 µm, 30 µm, 20 µm, 10 µm, 1 µm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, or lower than 200 nm.

According to one embodiment, the luminescent particle **1,** the particles **2,** and/or the luminescent nanoparticle, have an average fluorescence lifetime of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, or 1 µsecond.

In one embodiment, the luminescent particle **1,** the particles **2,** the luminescent nanoparticle and/or the light emitting material **7,** exhibit photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the luminescent particle **1,** the particles **2,** the luminescent nanoparticle and/or the light emitting material **7,** exhibit photoluminescence quantum yield (PQLY) decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the luminescent particle **1,** the particles **2,** the luminescent nanoparticle and/or the light emitting material **7,** exhibit FCE decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light with an average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one preferred embodiment, the luminescent particle **1,** the particles **2,** and/or the luminescent nanoparticle, exhibit FCE decrease of less than 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under pulsed light or continuous light with an average peak pulse power or photon flux of at least 1 mW.cm⁻² 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the luminescent particle **1** has a size above 50 nm.

According to one embodiment, the luminescent particle **1** has a size of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, a statistical set of luminescent particles **1** has an average size of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the luminescent particle **1** has a largest dimension of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the luminescent particle **1** has a smallest dimension of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the luminescent particle **1** is smaller than the largest dimension of said luminescent particle **1** by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100, at least 150, at least 200, at least 250, at least 300, at least 350, at least 400, at least 450, at least 500, at least 550, at least 600, at least 650, at least 700, at least 750, at least 800, at least 850, at least 900, at least 950, or at least 1000.

According to one embodiment, the luminescent particles **1** have an average size of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the luminescent particle **1** has a smallest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹, 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹, 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹,

According to one embodiment, the luminescent particle **1** has a largest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹, 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹, 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, in a statistical set of luminescent particles **1,** said luminescent particles **1** are polydisperse.

According to one embodiment, in a statistical set of luminescent particles **1,** said luminescent particles **1** are monodisperse.

According to one embodiment, in a statistical set of luminescent particles **1,** said luminescent particles **1** have a narrow size distribution.

According to one embodiment, the surface roughness of the luminescent particle **1** is less or equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said luminescent particle **1,** meaning that the surface of said luminescent particle **1** is completely smooth.

According to one embodiment, the surface roughness of the luminescent particle **1** is less or equal to 0.5% of the largest dimension of said luminescent particle **1,** meaning that the surface of said luminescent particle **1** is completely smooth.

According to one embodiment, the luminescent particle **1** has a spherical shape, an ovoid shape, a discoidal shape, a cylindrical shape, a faceted shape, a hexagonal shape, a triangular shape, a cubic shape, or a platelet shape.

According to one embodiment, the luminescent particle **1** has a raspberry shape, a prism shape, a polyhedron shape, a snowflake shape, a flower shape, a thorn shape, a hemisphere shape, a cone shape, a urchin shape, a filamentous shape, a biconcave discoid shape, a worm shape, a tree shape, a dendrite shape, a necklace shape, a chain shape, or a bush shape.

According to one embodiment, the luminescent particle **1** has a spherical shape, or the luminescent particle **1** is a bead.

According to one embodiment, the luminescent particle **1** does not have a core/shell structure.

According to one embodiment, the luminescent particle **1** has a core/shell structure as described hereafter.

According to one embodiment, the spherical luminescent particle **1** has a diameter of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, a statistical set of spherical luminescent particles 1 has an average diameter of at least 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the average diameter of a statistical set of spherical luminescent particles 1 may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 20%, 30%, 40%, 50%, 60%, 70%, 80%, 85%, 90%, 95%, 100%, 105%, 110%, 115%, 120%, 125%, 130%, 135%, 140%, 145%, 150%, 155%, 160%, 165%, 170%, 175%, 180%, 185%, 190%, 195%, or 200%.

According to one embodiment, a statistical set of the spherical luminescent particles **1** has an average unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the curvature of the spherical luminescent particle **1** has no deviation, meaning that said luminescent particle **1** has a perfect spherical shape. A perfect spherical shape prevents fluctuations of the intensity of the scattered light.

According to one embodiment, the unique curvature of the spherical luminescent particle **1** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% along the surface of said luminescent particle **1.**

Luminescent particle **1** with an average size less than 1 µm have several advantages compared to bigger particles comprising the same number of particles **2:** i) increasing the light scattering compared to bigger particles; ii) obtaining more stable colloidal suspensions compared to bigger particles, when they are dispersed in a solvent; iii) having a size compatible with pixels of at least 100 nm.

Luminescent particle **1** with an average size larger than 1 µm have several advantages compared to smaller particles comprising the same number of particles **2:** i) reducing light scattering compared to smaller particles; ii) having whispering-gallery wave modes; iii) having a size compatible with pixels larger than or equal to 1 µm; iv) increasing the average distance between nanoparticles **3** comprised in the at least one particle **2** comprised in the luminescent particle **1,** resulting in a better heat draining; v) increasing the average distance between nanoparticles **3** comprised in the at least one particle **2** comprised in the luminescent particle **1** and the surface of said luminescent particles **1,** thus better protecting the nanoparticles **3** against oxidation, or delaying oxidation resulting from a chemical reaction with chemical species coming from the outer space of said luminescent particles **1;** vi) increasing the mass ratio between the luminescent particle **1** and nanoparticle **3** comprised in said at least one particle **2** comprised in the luminescent particle **1** compared to smaller luminescent particles **1,** thus reducing the mass concentration of chemical elements subject to ROHS standards, making it easier to comply with ROHS requirements.

According to one embodiment, the luminescent particle **1,** the particles **2,** the luminescent nanoparticle and/or the light emitting material **7,** are ROHS compliant.

According to one embodiment, the luminescent particle **1,** the particles **2,** the luminescent nanoparticle and/or the light emitting material **7,** comprise less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm in weight of cadmium.

According to one embodiment, the luminescent particle **1,** the particles **2,** the luminescent nanoparticle and/or the light emitting material **7,** comprise less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of lead.

According to one embodiment, the luminescent particle **1,** the particles **2,** the luminescent nanoparticle and/or the light emitting material **7,** comprise less than 10 ppm, less than 20 ppm, less than 30 ppm, less than 40 ppm, less than 50 ppm, less than 100 ppm, less than 150 ppm, less than 200 ppm, less than 250 ppm, less than 300 ppm, less than 350 ppm, less than 400 ppm, less than 450 ppm, less than 500 ppm, less than 550 ppm, less than 600 ppm, less than 650 ppm, less than 700 ppm, less than 750 ppm, less than 800 ppm, less than 850 ppm, less than 900 ppm, less than 950 ppm, less than 1000 ppm, less than 2000 ppm, less than 3000 ppm, less than 4000 ppm, less than 5000 ppm, less than 6000 ppm, less than 7000 ppm, less than 8000 ppm, less than 9000 ppm, less than 10000 ppm in weight of mercury.

According to one embodiment, the luminescent particle **1,** the particles **2,** the luminescent nanoparticle and/or the light emitting material **7,** comprise heavier chemical elements than the main chemical element present in the first and/or second materials **(1, 2).** In this embodiment, said heavy chemical elements in the luminescent particle **1** will lower the mass concentration of chemical elements subject to ROHS standards, allowing said luminescent particle **1** to be ROHS compliant.

According to one embodiment, examples of heavy chemical elements include but are not limited to B, C, N, F, Na, Mg, Al, Si, P, S, Cl, K, Ca, Sc, Ti, V, Cr, Mn, Fe, Co, Ni, Cu, Zn, Ga, Ge, As, Se, Br, Rb, Sr, Y, Zr, Nb, Mo, Tc, Ru, Rh, Pd, Ag, Cd, In, Sn, Sb, Te, I, Cs, Ba, La, Hf, Ta, W, Re, Os, Ir, Pt, Au, Hg, Tl, Pb, Bi, Po, At, Ce, Pr, Nd, Pm, Sm, Eu, Gd, Tb, Dy, Ho, Er, Tm, Yb, Lu or a mixture of thereof.

According to one embodiment, the luminescent particle **1** is hydrophobic.

According to one embodiment, the luminescent particle **1** is hydrophilic.

According to one embodiment, the luminescent particle **1** is surfactant-free. In this embodiment, the surface of the luminescent particle **1** will be easy to functionalize as said surface will not be blocked by any surfactant molecule.

According to one embodiment, the luminescent particle **1** is not surfactant-free.

According to one embodiment, the luminescent particle **1** is amorphous.

According to one embodiment, the luminescent particle **1** is crystalline.

According to one embodiment, the luminescent particle **1** is totally crystalline.

According to one embodiment, the luminescent particle **1** is partially crystalline.

According to one embodiment, the luminescent particle **1** is monocrystalline.

According to one embodiment, the luminescent particle **1** is polycrystalline. In this embodiment, the luminescent particle **1** comprises at least one grain boundary.

According to one embodiment, the luminescent particle **1** is not porous.

According to one embodiment, the luminescent particle **1** does not comprise pores or cavities.

According to one embodiment, the luminescent particle **1** is considered non-porous when the quantity adsorbed by the said luminescent particle **1** determined by adsorption-desorption of nitrogen in the Brunauer-Emmett-Teller (BET) theory is less than 20 cm³/g, 15 cm³/g, 10 cm³/g, 5 cm³/g at a nitrogen pressure of 650 mmHg, preferably 700 mmHg.

According to one embodiment, the luminescent particle **1** is permeable.

According to one embodiment, the permeable luminescent particle **1** has an intrinsic permeability to fluids higher or equal to 10⁻¹¹ cm², 10⁻¹⁰ cm², 10⁻⁹ cm², 10⁻⁸ cm², 10⁻⁷ cm², 10⁻⁶ cm², 10⁻⁵ cm², 10⁻⁴ cm², or 10⁻³ cm².

According to one embodiment, the luminescent particle **1** is impermeable to outer molecular species, gas or liquid. In this embodiment, outer molecular species, gas or liquid refers to molecular species, gas or liquid external to said luminescent particle **1.**

According to one embodiment, the impermeable luminescent particle **1** has an intrinsic permeability to fluids less or equal to 10⁻¹¹ cm², 10⁻¹² cm², 10⁻¹³ cm², 10⁻¹⁴ cm², or 10⁻¹⁵ cm².

According to one embodiment, the luminescent particle **1** has an oxygen transmission rate ranging from 10⁻⁷ to 10 cm³.m⁻².day⁻¹, preferably from 10⁻⁷ to 1 cm³.m⁻².day⁻¹, more preferably from 10⁻⁷ to 10⁻¹ cm³.m⁻².day⁻¹, even more preferably from 10⁻⁷ to 10⁻⁴ cm³.m⁻².day⁻¹ at room temperature.

According to one embodiment, the luminescent particle **1** has a water vapor transmission rate ranging from 10⁻⁷ to 10 g.m⁻².day⁻¹, preferably from 10⁻⁷ to 1 g.m⁻².day⁻¹, more preferably from 10⁻⁷ to 10⁻¹ g.m⁻².day⁻¹, even more preferably from 10⁻⁷ to 10⁻⁴ g.m⁻².day⁻¹ at room temperature. A water vapor transmission rate of 10⁻⁶ g.m⁻².day⁻¹ is particularly adequate for a use on LED.

According to one embodiment, the luminescent particle **1** is optically transparent, i.e. the luminescent particle **1** is transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the luminescent particle **1** is a homostructure.

According to one embodiment, the luminescent particle **1** is not a core/shell structure wherein the core does not comprise particles **2** and the shell comprises particles **2.**

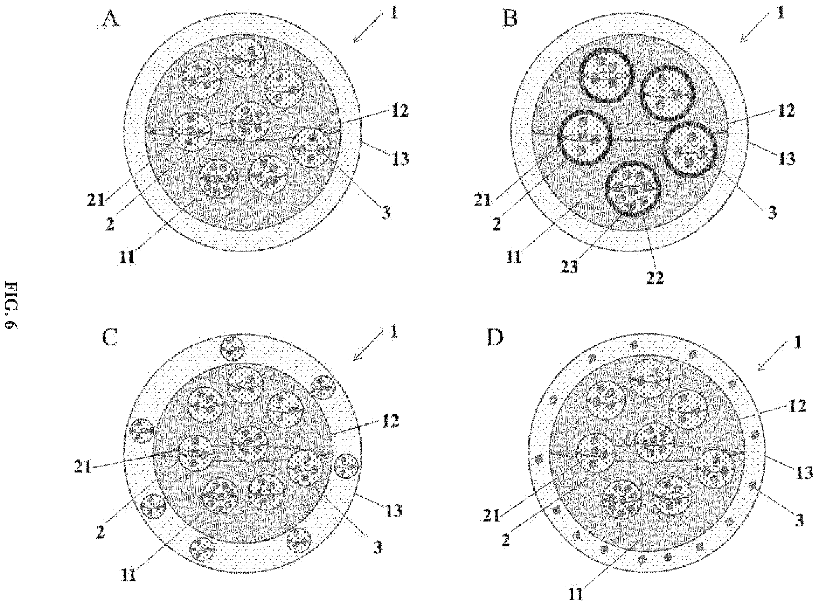

According to one embodiment as illustrated in Fig. 6A-D, the luminescent particle **1** is a heterostructure, comprising a core **12** and at least one shell **13.**

According to one embodiment, the shell **13** of the core/shell luminescent particle **1** comprises an inorganic material. In this embodiment, said inorganic material is the same or different than the first material **11** comprised in the core **12** of the core/shell luminescent particle **1.**

According to one embodiment, the shell **13** of the core/shell luminescent particle **1** consists of an inorganic material. In this embodiment, said inorganic material is the same or different than the first material **11** comprised in the core **12** of the core/shell luminescent particle **1.**

According to one embodiment illustrated in Fig. 6A, the core **12** of the core/shell luminescent particle **1** comprises at least one particle **2** as described herein and the shell **13** of the core/shell luminescent particle **1** does not comprise particles **2.**

According to one embodiment illustrated in Fig. 6C, the core **12** of the core/shell luminescent particle **1** comprises at least one particle **2** as described herein and the shell **13** of the core/shell luminescent particle **1** comprises at least one particle **2.**

According to one embodiment illustrated in Fig. 6D, the core **12** of the core/shell luminescent particle **1** comprises at least one particle **2** as described herein and the shell **13** of the core/shell luminescent particle **1** comprises at least one nanoparticle **3.** In this embodiment, said at least one nanoparticle **3** comprised in the shell **13** may be different or identical to the at least one nanoparticle **3** dispersed in the second material **21** of the at least one particle **2** comprised in the core **12.**

According to one embodiment, the at least one particle **2** comprised in the core **12** of the core/shell luminescent particle **1** is identical to the at least one particle **2** comprised in the shell **13** of the core/shell luminescent particle **1.**

According to one embodiment, the at least one particle **2** comprised in the core **12** of the core/shell luminescent particle **1** is different to the at least one particle **2** comprised in the shell **13** of the core/shell luminescent particle **1.** In this embodiment, the resulting core/shell luminescent particle **1** will exhibit different properties.

In a preferred embodiment, the core **12** of the core/shell luminescent particle **1** and the shell **13** of the core/shell luminescent particle **1** comprise at least two different luminescent particles **2,** wherein said luminescent particles **2** emit at different emission wavelengths. This means that the core **12** comprises at least one luminescent nanoparticle and the shell **13** comprises at least one luminescent nanoparticle, said luminescent nanoparticles having different emission wavelengths.

In a preferred embodiment, the core **12** of the core/shell luminescent particle **1** and the shell **13** of the core/shell luminescent particle **1** comprise at least two different luminescent particles **2,** wherein at least one luminescent particle **2** emits at a wavelength in the range from 500 to 560 nm, and at least one luminescent particle **2** emits at a wavelength in the range from 600 to 2500 nm. In this embodiment, the core **12** of the core/shell luminescent particle **1** and the shell **13** of the core/shell luminescent particle **1** comprise at least one luminescent particle **2** emitting in the green region of the visible spectrum and at least one luminescent particle **2** emitting in the red region of the visible spectrum, thus the luminescent particle **1** paired with a blue LED will be a white light emitter.

In a preferred embodiment, the core **12** of the core/shell luminescent particle **1** and the shell **13** of the core/shell luminescent particle **1** comprise at least two different luminescent particles **2,** wherein at least one luminescent particle **2** emits at a wavelength in the range from 400 to 490 nm, and at least one luminescent particle **2** emits at a wavelength in the range from 600 to 2500 nm. In this embodiment, the core **12** of the core/shell luminescent particle **1** and the shell **13** of the core/shell luminescent particle **1** comprise at least one luminescent particle **2** emitting in the blue region of the visible spectrum and at least one luminescent particle **2** emitting in the red region of the visible spectrum, thus the luminescent particle **1** will be a white light emitter.

In a preferred embodiment, the core **12** of the core/shell luminescent particle **1** and the shell **13** of the core/shell luminescent particle **1** comprise comprises at least two different luminescent particles **2,** wherein at least one luminescent particle **2** emits at a wavelength in the range from 400 to 490 nm, and at least one luminescent particle **2** emits at a wavelength in the range from 500 to 560 nm. In this embodiment, the core **12** of the core/shell luminescent particle **1** and the shell **13** of the core/shell luminescent particle **1** comprise at least one luminescent particle **2** emitting in the blue region of the visible spectrum and at least one luminescent particle **2** emitting in the green region of the visible spectrum.

According to one embodiment, the shell **13** of the luminescent particle **1** has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the shell **13** of the luminescent particle **1** has a thickness homogeneous all along the core **12,** i.e. the shell **13** of the luminescent particle **1** has a same thickness all along the core **12.**

According to one embodiment, the shell **13** of the luminescent particle **1** has a thickness heterogeneous along the core **12,** i.e. said thickness varies along the core **12.**

According to one embodiment, the luminescent particle **1** comprises one particle **2** dispersed in the first material **11.**

According to one embodiment, the luminescent particle **1** comprises at least 1, at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88, at least 89, at least 90, at least 91, at least 92, at least 93, at least 94, at least 95, at least 96, at least 97, at least 98, at least 99, at least 100, at least 200, at least 300, at least 400, at least 500, at least 600, at least 700, at least 800, at least 900, at least 1000, at least 1500, at least 2000, at least 2500, at least 3000, at least 3500, at least 4000, at least 4500, at least 5000, at least 5500, at least 6000, at least 6500, at least 7000, at least 7500, at least 8000, at least 8500, at least 9000, at least 9500, at least 10000, at least 15000, at least 20000, at least 25000, at least 30000, at least 35000, at least 40000, at least 45000, at least 50000, at least 55000, at least 60000, at least 65000, at least 70000, at least 75000, at least 80000, at least 85000, at least 90000, at least 95000, or at least 100000 particles **2** dispersed in the first material **11.**

According to one embodiment, the luminescent particle **1** comprises a combination of at least two different particles **2.** In this embodiment, the resulting luminescent particle **1** will exhibit different properties.

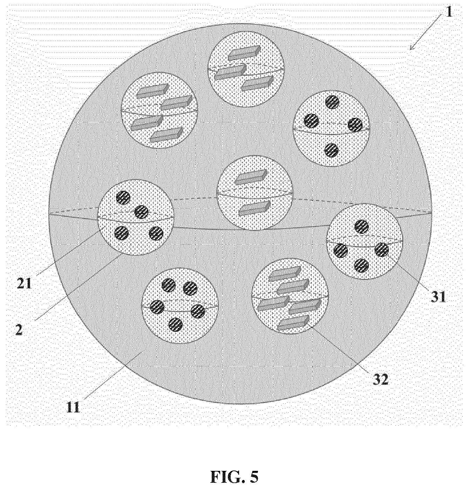

In a preferred embodiment illustrated in Fig. 5, the luminescent particle **1** comprises at least two different particles **2,** wherein at least one particle **2** emits at a wavelength in the range from 500 to 560 nm, and at least one particle **2** emits at a wavelength in the range from 600 to 2500 nm. In this embodiment, the luminescent particle **1** comprises at least one particle **2** emitting in the green region of the visible spectrum and at least one particle **2** emitting in the red region of the visible spectrum, thus the luminescent particle **1** paired with a blue LED will be a white light emitter.

In a preferred embodiment, the luminescent particle **1** comprises at least two different particles **2,** wherein at least one particle **2** emits at a wavelength in the range from 400 to 490 nm, and at least one particle **2** emits at a wavelength in the range from 600 to 2500 nm. In this embodiment, the luminescent particle **1** comprises at least one particle **2** emitting in the blue region of the visible spectrum and at least one particle **2** emitting in the red region of the visible spectrum, thus the luminescent particle **1** will be a white light emitter.

In a preferred embodiment, the luminescent particle **1** comprises at least two different particles **2,** wherein at least one particle **2** emits at a wavelength in the range from 400 to 490 nm, and at least one particle **2** emits at a wavelength in the range from 500 to 560 nm. In this embodiment, the luminescent particle **1** comprises at least one particle **2** emitting in the blue region of the visible spectrum and at least one particle **2** emitting in the green region of the visible spectrum.

In a preferred embodiment, the luminescent particle **1** comprises three different particles **2,** wherein said particles **2** emit different emission wavelengths or color.

In a preferred embodiment, the luminescent particle **1** comprises at least three different particles **2,** wherein at least one particle **2** emits at a wavelength in the range from 400 to 490 nm, at least one particle **2** emits at a wavelength in the range from 500 to 560 nm and at least one particle **2** emits at a wavelength in the range from 600 to 2500 nm. In this embodiment, the luminescent particle **1** comprises at least one particle **2** emitting in the blue region of the visible spectrum, at least one particle **2** emitting in the green region of the visible spectrum and at least one particle **2** emitting in the red region of the visible spectrum.

According to one embodiment, each particle **2** is totally surrounded by or encapsulated in the first material **11.**

According to one embodiment, each particle **2** is partially surrounded by or encapsulated in the first material **11.**

In a preferred embodiment, the luminescent particle **1** does not comprise any particle **2** on its surface. In this embodiment, the at least particle **2** is completely surrounded by the first material **11.**

According to one embodiment, the luminescent particle **1,** and/or the particles 2, exhibit a shelf life of at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the luminescent particle 1**,** the particles **2**, the luminescent nanoparticle in the second material **21** and/or the light emitting material **7**, exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

Photoluminescence refers to fluorescence and/or phosphorescence.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle in the second material **21** and/or the light emitting material 7, exhibit a degradation of its photoluminescence of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle in the second material **21** and/or the light emitting material **7,** exhibit a degradation of its photoluminescence photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle in the second material **21** and/or the light emitting material **7,** exhibit a degradation of its photoluminescence of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

In one embodiment, the luminescent particle **1,** the particles **2,** the luminescent nanoparticle in the second material **21** and/or the light emitting material **7,** exhibit photoluminescence quantum yield (PLQY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination is provided by blue, green, red, or UV light source such as laser, diode, fluorescent lamp or Xenon Arc Lamp. According to one embodiment, the photon flux or average peak pulse power of the illumination is comprised between 1 mW.cm⁻² and 100 kW.cm⁻², more preferably between 10 mW.cm⁻² and 100 W.cm⁻², and even more preferably between 10 mW.cm⁻² and 30 W.cm⁻².

According to one embodiment, the photon flux or average peak pulse power of the illumination is at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the light illumination described herein provides continuous lighting.

According to one embodiment, the light illumination described herein provides pulsed light.

This embodiment is particularly advantageous as it allows the evacuation of heat and/or electrical charges from nanoparticles 3. This embodiment is also particularly advantageous as using pulsed light allow a longer lifespan of the nanoparticles 3, thus of the luminescent particles 1, indeed under continuous light, nanoparticles 3 degrade faster than under pulsed light.

According to one embodiment, the light illumination described herein provides pulsed light. In this embodiment, if a continuous light illuminates a material with regular periods during which said material is voluntary removed from the illumination, said light may be considered as pulsed light. This embodiment is particularly advantageous as it allows the evacuation of heat and/or electrical charges from nanoparticles **3.**

According to one embodiment, said pulsed light has a time off (or time without illumination) of at least 1 µsecond, 2 µseconds, 3 µseconds, 4 µseconds, 5 µseconds, 6 µseconds, 7 µseconds, 8 µseconds, 9 µseconds, 10 µseconds, 11 µseconds, 12 µseconds, 13 µseconds, 14 µseconds, 15 µseconds, 16 µseconds, 17 µseconds, 18 µseconds, 19 µseconds, 20 µseconds, 21 µseconds, 22 µseconds, 23 µseconds, 24 µseconds, 25 µseconds, 26 µseconds, 27 µseconds, 28 µseconds, 29 µseconds, 30 µseconds, 31 µseconds, 32 µseconds, 33 µseconds, 34 µseconds, 35 µseconds, 36 µseconds, 37 µseconds, 38 µseconds, 39 µseconds, 40 µseconds, 41 µseconds, 42 µseconds, 43 µseconds, 44 µseconds, 45 µseconds, 46 µseconds, 47 µseconds, 48 µseconds, 49 µseconds, 50 µseconds, 100 µseconds, 150 µseconds, 200 µseconds, 250 µseconds, 300 µseconds, 350 µseconds, 400 µseconds, 450 µseconds, 500 µseconds, 550 µseconds, 600 µseconds, 650 µseconds, 700 µseconds, 750 µseconds, 800 µseconds, 850 µseconds, 900 µseconds, 950 µseconds, 1 msecond, 2 mseconds, 3 mseconds, 4 mseconds, 5 mseconds, 6 mseconds, 7 mseconds, 8 mseconds, 9 mseconds, 10 mseconds, 11 mseconds, 12 mseconds, 13 mseconds, 14 mseconds, 15 mseconds, 16 mseconds, 17 mseconds, 18 mseconds, 19 mseconds, 20 mseconds, 21 mseconds, 22 mseconds, 23 mseconds, 24 mseconds, 25 mseconds, 26 mseconds, 27 mseconds, 28 mseconds, 29 mseconds, 30 mseconds, 31 mseconds, 32 mseconds, 33 mseconds, 34 mseconds, 35 mseconds, 36 mseconds, 37 mseconds, 38 mseconds, 39 mseconds, 40 mseconds, 41 mseconds, 42 mseconds, 43 mseconds, 44 mseconds, 45 mseconds, 46 mseconds, 47 mseconds, 48 mseconds, 49 mseconds, or 50 mseconds.

According to one embodiment, said pulsed light has a time on (or illumination time) of at least 0.1 nanosecond, 0.2 nanosecond, 0.3 nanosecond, 0.4 nanosecond, 0.5 nanosecond, 0.6 nanosecond, 0.7 nanosecond, 0.8 nanosecond, 0.9 nanosecond, 1 nanosecond, 2 nanoseconds, 3 nanoseconds, 4 nanoseconds, 5 nanoseconds, 6 nanoseconds, 7 nanoseconds, 8 nanoseconds, 9 nanoseconds, 10 nanoseconds, 11 nanoseconds, 12 nanoseconds, 13 nanoseconds, 14 nanoseconds, 15 nanoseconds, 16 nanoseconds, 17 nanoseconds, 18 nanoseconds, 19 nanoseconds, 20 nanoseconds, 21 nanoseconds, 22 nanoseconds, 23 nanoseconds, 24 nanoseconds, 25 nanoseconds, 26 nanoseconds, 27 nanoseconds, 28 nanoseconds, 29 nanoseconds, 30 nanoseconds, 31 nanoseconds, 32 nanoseconds, 33 nanoseconds, 34 nanoseconds, 35 nanoseconds, 36 nanoseconds, 37 nanoseconds, 38 nanoseconds, 39 nanoseconds, 40 nanoseconds, 41 nanoseconds, 42 nanoseconds, 43 nanoseconds, 44 nanoseconds, 45 nanoseconds, 46 nanoseconds, 47 nanoseconds, 48 nanoseconds, 49 nanoseconds, 50 nanoseconds, 100 nanoseconds, 150 nanoseconds, 200 nanoseconds, 250 nanoseconds, 300 nanoseconds, 350 nanoseconds, 400 nanoseconds, 450 nanoseconds, 500 nanoseconds, 550 nanoseconds, 600 nanoseconds, 650 nanoseconds, 700 nanoseconds, 750 nanoseconds, 800 nanoseconds, 850 nanoseconds, 900 nanoseconds, 950 nanoseconds, 1 µsecond, 2 µseconds, 3 µseconds, 4 µseconds, 5 µseconds, 6 µseconds, 7 µseconds, 8 µseconds, 9 µseconds, 10 µseconds, 11 µseconds, 12 µseconds, 13 µseconds, 14 µseconds, 15 µseconds, 16 µseconds, 17 µseconds, 18 µseconds, 19 µseconds, 20 µseconds, 21 µseconds, 22 µseconds, 23 µseconds, 24 µseconds, 25 µseconds, 26 µseconds, 27 µseconds, 28 µseconds, 29 µseconds, 30 µseconds, 31 µseconds, 32 µseconds, 33 µseconds, 34 µseconds, 35 µseconds, 36 µseconds, 37 µseconds, 38 µseconds, 39 µseconds, 40 µseconds, 41 µseconds, 42 µseconds, 43 µseconds, 44 µseconds, 45 µseconds, 46 µseconds, 47 µseconds, 48 µseconds, 49 µseconds, or 50 µseconds.

According to one embodiment, said pulsed light has a frequency of at least 10 Hz, 11 Hz, 12 Hz, 13 Hz, 14 Hz, 15 Hz, 16 Hz, 17 Hz, 18 Hz, 19 Hz, 20 Hz, 21 Hz, 22 Hz, 23 Hz, 24 Hz, 25 Hz, 26 Hz, 27 Hz, 28 Hz, 29 Hz, 30 Hz, 31 Hz, 32 Hz, 33 Hz, 34 Hz, 35 Hz, 36 Hz, 37 Hz, 38 Hz, 39 Hz, 40 Hz, 41 Hz, 42 Hz, 43 Hz, 44 Hz, 45 Hz, 46 Hz, 47 Hz, 48 Hz, 49 Hz, 50 Hz, 100 Hz, 150 Hz, 200 Hz, 250 Hz, 300 Hz, 350 Hz, 400 Hz, 450 Hz, 500 Hz, 550 Hz, 600 Hz, 650 Hz, 700 Hz, 750 Hz, 800 Hz, 850 Hz, 900 Hz, 950 Hz, 1 kHz, 2 kHz, 3 kHz, 4 kHz, 5 kHz, 6 kHz, 7 kHz, 8 kHz, 9 kHz, 10 kHz, 11 kHz, 12 kHz, 13 kHz, 14 kHz, 15 kHz, 16 kHz, 17 kHz, 18 kHz, 19 kHz, 20 kHz, 21 kHz, 22 kHz, 23 kHz, 24 kHz, 25 kHz, 26 kHz, 27 kHz, 28 kHz, 29 kHz, 30 kHz, 31 kHz, 32 kHz, 33 kHz, 34 kHz, 35 kHz, 36 kHz, 37 kHz, 38 kHz, 39 kHz, 40 kHz, 41 kHz, 42 kHz, 43 kHz, 44 kHz, 45 kHz, 46 kHz, 47 kHz, 48 kHz, 49 kHz, 50 kHz, 100 kHz, 150 kHz, 200 kHz, 250 kHz, 300 kHz, 350 kHz, 400 kHz, 450 kHz, 500 kHz, 550 kHz, 600 kHz, 650 kHz, 700 kHz, 750 kHz, 800 kHz, 850 kHz, 900 kHz, 950 kHz, 1 MHz, 2 MHz, 3 MHz, 4 MHz, 5 MHz, 6 MHz, 7 MHz, 8 MHz, 9 MHz, 10 MHz, 11 MHz, 12 MHz, 13 MHz, 14 MHz, 15 MHz, 16 MHz, 17 MHz, 18 MHz, 19 MHz, 20 MHz, 21 MHz, 22 MHz, 23 MHz, 24 MHz, 25 MHz, 26 MHz, 27 MHz, 28 MHz, 29 MHz, 30 MHz, 31 MHz, 32 MHz, 33 MHz, 34 MHz, 35 MHz, 36 MHz, 37 MHz, 38 MHz, 39 MHz, 40 MHz, 41 MHz, 42 MHz, 43 MHz, 44 MHz, 45 MHz, 46 MHz, 47 MHz, 48 MHz, 49 MHz, 50 MHz, or 100 MHz.

According to one embodiment, the spot area of the light which illuminates the luminescent particle **1,** the particle **2,** the nanoparticles **3** and/or the light emitting material **7** is at least 10 µm², 20 µm², 30 µm², 40 µm², 50 µm², 60 µm², 70 µm², 80 µm², 90 µm²,100 µm², 200 µm², 300 µm², 400 µm², 500 µm², 600 µm², 700 µm², 800 µm², 900 µm², 10³ µm², 10⁴ µm², 10⁵ µm², 1 mm², 10 mm², 20 mm², 30 mm², 40 mm², 50 mm², 60 mm², 70 mm², 80 mm², 90 mm², 100 mm², 200 mm², 300 mm², 400 mm², 500 mm², 600 mm², 700 mm², 800 mm², 900 mm², 10³ mm², 10⁴ mm², 10⁵ mm², 1 m², 10 m², 20 m², 30 m², 40 m², 50 m², 60 m², 70 m², 80 m², 90 m², or 100 m².

According to one embodiment, the emission saturation of the luminescent particle **1,** the particle **2,** the nanoparticles **3** and/or the light emitting material **7** is reached under a pulsed light with a peak pulse power of at least 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², 100 kW.cm⁻², 200 kW.cm⁻², 300 kW.cm⁻², 400 kW.cm⁻², 500 kW.cm⁻², 600 kW.cm⁻², 700 kW.cm⁻², 800 kW.cm⁻², 900 kW.cm⁻², or 1 MW.cm⁻².

According to one embodiment, the emission saturation of the luminescent particle **1,** the particle **2,** the nanoparticles **3** and/or the light emitting material **7** is reached under a continuous illumination with a peak pulse power of at least 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², or 1 kW.cm⁻².

Emission saturation of particles under illumination with a given photon flux occurs when said particles cannot emit more photons. In other words, a higher photon flux doesn't lead to a higher number of photons emitted by said particles.

According to one embodiment, the FCE (Frequency Conversion Efficiency) of illuminated luminescent particle **1,** the particle **2,** nanoparticles **3** and/or light emitting material **7** is of at least 1%, 2%, 3%, 4%, 5%, 6%, 7%, 8%, 9%, 10%, 15%, 16%, 17%, 18%, 18%, 19%, 20%, 21%, 22%, 23%, 24%, 25%, 30%, 35%, 40%, 45%, 50%, 55%, 60%, 65%, 70%, 75%, 80%, 85%, 90%, 95%, or 100%. In this embodiment, the FCE was measured at 480 nm.

In one embodiment, the luminescent particle **1,** the particles **2,** the luminescent nanoparticle and/or the light emitting material **7,** exhibit photoluminescence quantum yield (PQLY) decrease of less than 80%, 70%, 60%, 50%, 40%, 30%, 25%, 20%, 15%, 10%, 5%, 4%, 3%, 2%, 1%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material 7, exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its photoluminescence quantum yield (PLQY) of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0%, 10%, 20%, 30%, 40%, 50%, 55%, 60%, 65%, 70%, 75%, 80%, 85%, 90%, 95%, or 99% of humidity.

According to one embodiment, the luminescent particle **1,** the particles **2,** the luminescent nanoparticle and/or the light emitting material **7,** exhibit a degradation of its FCE of less than 90%, 80%, 70%, 60%, 50%, 40%, 30%, 25%, 20%, 10%, 5%, 4%, 3%, 2%, 1%, or 0% after at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂, under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under 0%, 10%, 20%, 30%, 40%, 50%, 55%, 60%, 65%, 70%, 75%, 80%, 85%, 90%, 95%, or 99% of humidity.

According to one embodiment, the first material **11** and the second material **21** have a bandgap of at least 3.0 eV, 3.1 eV, 3.2 eV, 3.3 eV, 3.4 eV, 3.5 eV, 3.6 eV, 3.7 eV, 3.8 eV, 3.9 eV, 4.0 eV, 4.1 eV, 4.2 eV, 4.3 eV, 4.4 eV, 4.5 eV, 4.6 eV, 4.7 eV, 4.8 eV, 4.9 eV, 5.0 eV, 5.1 eV, 5.2 eV, 5.3 eV, 5.4 eV or 5.5 eV.

According to one embodiment, the first material **11** and/or the second material **21** have an extinction coefficient less or equal to 15×10⁻⁵ at 460 nm.

In one embodiment, the extinction coefficient is measured by an absorbance measuring technique such as absorbance spectroscopy or any other method known in the art.

In one embodiment, the extinction coefficient is measured by an absorbance measurement divided by the length of the path light passing through the sample.

According to one embodiment, the first material **11** and/or the second material **21** are inorganic materials.

According to one embodiment, the first material **11** and/or the second material **21** do not comprise organic molecules.

According to one embodiment, the first material **11** and/or the second material **21** do not comprise polymers.

According to one embodiment, the first material **11** and/or the second material **21** are selected from the group consisting of oxide materials, semiconductor materials, wide-bandgap semiconductor materials or a mixture thereof.

According to one embodiment, examples of semiconductor materials include but are not limited to: III-V semiconductors, II-VI semiconductors, or a mixture thereof.

According to one embodiment, examples of wide-bandgap semiconductor materials include but are not limited to: silicon carbide SiC, aluminium nitride AlN, gallium nitride GaN, boron nitride BN, or a mixture thereof.

According to one embodiment, examples of oxide materials include but are not limited to: SiO₂, Al₂O₃, TiO₂, ZrO₂, FeO, ZnO, MgO, SnO₂, Nb₂O₅, CeO₂, BeO, IrO₂, CaO, Sc₂O₃, Na₂O, BaO, K₂O, TeO₂, MnO, B₂O₃, GeO₂, As₂O₃, Ta₂O₅, Li₂O, SrO, Y₂O₃, HfO₂, MoO₂, Tc₂O₇, ReO₂, Co₃O₄, OsO, RhO₂, Rh₂O₃, CdO, HgO, Tl₂O, Ga₂O₃, In₂O₃, Bi₂O₃, Sb₂O₃, PoO₂, SeO₂, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof.

According to one embodiment, the first material **11** and/or the second material **21** are selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, iridium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof.

According to one embodiment, the first material **11** and/or the second material **21** comprise or consist of a ZrO₂/SiO₂ mixture: SiₓZr₁₋ₓO₂, wherein 0 ≤x≤ 1. In this embodiment, the first material

**11** and/or the second material **21** are able to resist to any pH in a range from 0 to 14. This allows for a better protection of the at least one nanoparticle **3.**

According to one embodiment, the first material **11** and/or the second material **21** comprise or consist Si_{0.8}Zr_{0.2}O₂.

According to one embodiment, the first material **11** and/or the second material **21** comprise or consist of a HfO₂/SiO₂ mixture: SiₓHf₁₋ₓO₂, wherein 0 ≤x≤ 1.

According to one embodiment, the first material **11** and/or the second material **21** comprise or consist Si_{0.8}Hf_{0.2}O₂.

According to one embodiment, the first material **11** and the second material **21** are independently chosen from the lists of materials cited herein.

According to one embodiment, the first material **11** and/or the second material **21** have a density ranging from 1 to 10 g/cm³, preferably the first material **11** has a density ranging from 3 to 10 g/cm³.

According to one embodiment, the first material **11** has a density superior or equal to the density of the second material **21.**

According to one embodiment, the refractive index of first material **11** and second material **21** is tuned by the first material **11** and second material **21** chosen.

According to one embodiment, the first material **11** and/or the second material **21** have a refractive index ranging from 1 to 5, from 1.2 to 2.6, from 1.4 to 2.0 at 450 nm.

According to one embodiment, the first material **11** and/or the second material **21** have a refractive index of at least 1.0, 1.1, 1.2, 1.3, 1.4, 1.5, 1.6, 1.7, 1.8, 1.9, 2.0, 2.1, 2.2, 2.3, 2.4, 2.5, 2.6, 2.7, 2.8, 2.9, 30, 3.1, 3.2, 3.3, 3.4, 3.5, 3.6, 3.7, 3.8, 3.9,4.0,4.1,4.2,4.3, 4.4, 4.5, 4.6, 4.7, 4.8, 4.9, or 5.0 at 450 nm.

According to one embodiment, the first material **11** has the same refractive index than the second material **21.**

According to one embodiment, the first material **11** has a refractive index distinct from the refractive index of the second material **21.** This embodiment allows for a wider scattering of light. This embodiment also allows to have a difference in light scattering as a function of the wavelength, in particular to increase the scattering of the excitation light with respect to the scattering of the emitted light, as the wavelength of the excitation light is lower than the wavelength of the emitted light.

According to one embodiment, the first material **11** has a refractive index superior or equal to the refractive index of the second material **21.**

According to one embodiment, the first material **11** has a refractive index inferior to the refractive index of the second material **21.**

According to one embodiment, the first material **11** has a difference of refractive index with the refractive index of the second material **21** of at least 0.02, 0.025, 0.03, 0.035, 0.04, 0.045, 0.05, 0.055, 0.06, 0.065, 0.07, 0.075, 0.08, 0.085, 0.09, 0.095, 0.1, 0.11, 0.115, 0.12, 0.125, 0.13, 0.135, 0.14, 0.145, 0.15, 0.155, 0.16, 0.165, 0.17, 0.175, 0.18, 0.185, 0.19, 0.195, 0.2, 0.25, 0.3, 0.35, 0.4, 0.45, 0.5, 0.55, 0.6, 0.65, 0.7, 0.75, 0.8, 0.85, 0.9, 0.95, 1, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, or 2 at 450 nm.

According to one embodiment, the first material **11** has a difference of refractive index with the refractive index of the second material **21** of 0.02 at 450 nm.

According to one embodiment, the first material **11** and/or the second material **21** act as a barrier against oxidation of the at least one nanoparticle **3.**

According to one embodiment, the first material **11** has a thermal conductivity at standard conditions of at least 0.1 W/(m.K).

According to one embodiment, the first material **11** and/or the second material **21** are amorphous.

According to one embodiment, the first material **11** and/or the second material **21** are crystalline.

According to one embodiment, the first material **11** and/or the second material **21** are totally crystalline.

According to one embodiment, the first material **11** and/or the second material **21** are partially crystalline.

According to one embodiment, the first material **11** and/or the second material **21** are monocrystalline.

According to one embodiment, the first material **11** and/or the second material **21** are polycrystalline. In this embodiment, the first material **11** and/or the second material **21** comprise at least one grain boundary.

According to one embodiment, the first material **11** and/or the second material **21** are hydrophobic.

According to one embodiment, the first material **11** and/or the second material **21** are hydrophilic.

According to one embodiment, the first material **11** and/or the second material **21** are impermeable to outer molecular species, gas or liquid. In this embodiment, the first material **11** and/or the second material **21** limit or prevent the degradation of the chemical and physical properties of the at least one nanoparticle **3** from molecular oxygen, water and/or high temperature.

According to one embodiment, the impermeable first material **11** and/or the second material **21** have an intrinsic permeability to fluids less or equal to 10⁻¹¹ cm², 10⁻¹² cm², 10⁻¹³ cm², 10⁻¹⁴ cm², 10⁻¹⁵ cm², 10⁻¹⁶ cm², 10⁻¹⁷ cm², 10⁻¹¹ cm², 10⁻¹¹ cm², or 10⁻²⁰ cm².

According to one embodiment, the first material **11** and/or the second material **21** limit or prevent the diffusion of outer molecular species or fluids (liquid or gas) into said first material **11** and/or said second material **21.**

According to one embodiment, the first material **11** and/or the second material **21** are optically transparent, i.e. the first material **11** and/or the second material **21** are transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm. In this embodiment, the first material **11** and/or the second material **21** do not absorb all incident light allowing the at least one nanoparticle **3** to absorb all the incident light; and/or the first material **11** and/or the second material **21** do not absorb the light emitted by the at least one nanoparticle **3** allowing to said light emitted to be transmitted through the first material **11** and/or the second material **21.**

According to one embodiment, the first material **11** and/or the second material **21** are not optically transparent, i.e. the first material **11** and/or the second material **21** absorb light at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm. In this embodiment, the first material **11** and/or the second material **21** absorb part of the incident light allowing the at least one nanoparticle **3** to absorb only a part of the incident light; and/or the first material **11** and/or the second material **21** absorb part of the light emitted by the at least one nanoparticle **3** allowing said light emitted to be partially transmitted through the first material **11** and/or the second material **21.**

According to one embodiment, the first material **11** and/or the second material **21** transmit at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the first material **11** and/or the second material **21** transmit a part of the incident light and emits at least one secondary light. In this embodiment, the resulting light is a combination of the remaining transmitted incident light.

According to one embodiment, the first material **11** and/or the second material **21** absorb the incident light with wavelength lower than 460 nm.

According to one embodiment, the first material **11** and/or the second material **21** have an extinction coefficient less or equal to 1×10⁻⁵, 1.1×10⁻⁵, 1.2×10⁻⁵, 1.3×10⁻⁵, 1.4×10⁻⁵, 1.5×10⁻⁵, 1.6×10⁻⁵, 1.7×10⁻⁵, 1.8×10⁻⁵, 1.9×10⁻⁵, 2×10⁻⁵, 3×10⁻⁵, 4×10⁻⁵, 5×10⁻⁵ 6×10⁻⁵, 7×10⁻⁵, 8×10⁻⁵, 9×10⁻⁵, 10×10⁻⁵, 11×10⁻⁵, 12×10⁻⁵, 13×10⁻⁵, 14×10⁻⁵, 15×10⁻⁵, 16×10⁻⁵, 17×10⁻⁵, 18×10⁻⁵, 19×10⁻⁵, 20x10' ⁵, 21×10⁻⁵, 22×10⁻⁵, 23×10⁻⁵, 24×10⁻⁵, or 25×10⁻⁵ at 460 nm.

According to one embodiment, the first material **11** and/or the second material **21** have an attenuation coefficient less or equal to 1×10⁻² cm⁻¹, 1×10⁻¹ cm⁻¹, 0.5×10⁻¹ cm⁻¹, 0.1 cm⁻¹, 0.2 cm⁻¹, 0.3 cm⁻¹, 0.4 cm⁻¹, 0.5 cm⁻¹, 0.6 cm⁻¹, 0.7 cm⁻¹, 0.8 cm⁻¹, 0.9 cm⁻¹, 1 cm⁻¹, 1.1 cm⁻¹, 1.2 cm⁻¹, 1.3 cm⁻¹, 1.4 cm⁻¹, 1.5 cm⁻¹, 1.6 cm⁻¹, 1.7 cm⁻¹, 1.8 cm⁻¹, 1.9 cm⁻¹, 2.0 cm⁻¹, 2.5 cm⁻¹, 3.0 cm⁻¹, 3.5 cm⁻¹, 4.0 cm⁻¹, 4.5 cm⁻¹, 5.0 cm⁻¹, 5.5 cm⁻¹, 6.0 cm⁻¹, 6.5 cm⁻¹, 7.0 cm⁻¹, 7.5 cm⁻¹, 8.0 cm⁻¹, 8.5 cm⁻¹, 9.0 cm⁻¹, 9.5 cm⁻¹, 10 cm⁻¹, 15 cm⁻¹, 20 cm⁻¹, 25 cm⁻¹, or 30 cm⁻¹ at 460 nm.

According to one embodiment, the first material **11** and/or the second material **21** have an attenuation coefficient less or equal to 1×10⁻² cm⁻¹, 1×10⁻¹ cm⁻¹, 0.5×10⁻¹ cm⁻¹, 0.1 cm⁻¹, 0.2 cm⁻¹, 0.3 cm⁻¹, 0.4 cm⁻¹, 0.5 cm⁻¹, 0.6 cm⁻¹, 0.7 cm⁻¹, 0.8 cm⁻¹, 0.9 cm⁻¹, 1 cm⁻¹, 1.1 cm⁻¹, 1.2 cm⁻¹, 1.3 cm⁻¹, 1.4 cm⁻¹, 1.5 cm⁻¹, 1.6 cm⁻¹, 1.7 cm⁻¹, 1.8 cm⁻¹, 1.9 cm⁻¹, 2.0 cm⁻¹, 2.5 cm⁻¹, 3.0 cm⁻¹, 3.5 cm⁻¹, 4.0 cm⁻¹, 4.5 cm⁻¹, 5.0 cm⁻¹, 5.5 cm⁻¹, 6.0 cm⁻¹, 6.5 cm⁻¹, 7.0 cm⁻¹, 7.5 cm⁻¹, 8.0 cm⁻¹, 8.5 cm⁻¹, 9.0 cm⁻¹, 9.5 cm⁻¹, 10 cm⁻¹, 15 cm⁻¹, 20 cm⁻¹, 25 cm⁻¹, or 30 cm⁻¹ at 450 nm.

According to one embodiment, the first material **11** and/or the second material **21** have an optical absorption cross section less or equal to 1.10⁻³⁵ cm², 1.10⁻³⁴ cm², 1.10⁻³³ cm², 1.10⁻³² cm², 1.10⁻³¹ cm², 1.10⁻³⁰ cm², 1.10⁻²⁹ cm², 1.10⁻²⁸ cm², 1.10⁻²⁷ cm², 1.10⁻²⁶ cm², 1.10⁻²⁵ cm², 1.10⁻²⁴ cm², 1.10⁻²³ cm², 1.10⁻²² cm², 1.10⁻²¹ cm², 1.10⁻²⁰ cm², 1.10⁻¹⁹ cm², 1.10⁻¹⁸ cm², 1.10⁻¹⁷ cm², 1.10⁻¹⁶ cm², 1.10⁻¹⁵ cm², 1.10⁻¹⁴ cm², 1.10⁻¹³ cm², 1.10⁻¹² cm², 1.10⁻¹¹ cm², 1.10⁻¹⁰ cm², 1.10⁻⁹ cm², 1.10⁻⁸ cm², 1.10⁻⁷ cm², 1.10⁻⁶ cm², 1.10⁻⁵ cm², 1.10⁻⁴ cm², 1.10⁻³ cm², 1.10⁻² cm² or 1.10⁻¹ cm² at 460 nm.

According to one embodiment, the first material **11** and/or the second material **21** are stable under acidic conditions, i.e. at pH inferior or equal to 7. In this embodiment, the first material **11** and/or the second material **21** are sufficiently robust to withstand acidic conditions, meaning that the properties of the luminescent particle **1** are preserved under said conditions.

According to one embodiment, the first material **11** and/or the second material **21** are stable under basic conditions, i.e. at pH superior to 7. In this embodiment, the first material **11** and/or the second material **21** are sufficiently robust to withstand basic conditions, meaning that the properties of the luminescent particle **1** are preserved under said conditions.

According to one embodiment, the first material **11** and/or the second material **21** are physically and chemically stable under various conditions. In this embodiment, the first material **11** and/or the second material **21** are sufficiently robust to withstand the conditions to which the luminescent particle **1** will be subjected.

According to one embodiment, the first material **11** and/or the second material '**21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the first material **11** and/or the second material **21** are physically and chemically stable under 0%, 10%, 20%, 30%, 40%, 50%, 55%, 60%, 65%, 70%, 75%, 80%, 85%, 90%, 95%, or 99% of humidity for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the first material **11** and/or the second material **21** are physically and chemically stable under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the first material **11** and/or the second material **21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under 0%, 10%, 20%, 30%, 40%, 50%, 55%, 60%, 65%, 70%, 75%, 80%, 85%, 90%, 95%, or 99% of humidity for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the first material **11** and/or the second material **21** are physically and chemically stable under 0%, 10%, 20%, 30%, 40%, 50%, 55%, 60%, 65%, 70%, 75%, 80%, 85%, 90%, 95%, or 99% of humidity and under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the first material **11** and/or the second material **21** are physically and chemically stable under 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under 0%, 5%, 10%, 15%, 20%, 25%, 30%, 35%, 40%, 45%, 50%, 55%, 60%, 65%, 70%, 75%, 80%, 85%, 90%, 95%, or 100% of molecular O₂ for at least 1 day, 5 days, 10 days, 15 days, 20 days, 25 days, 1 month, 2 months, 3 months, 4 months, 5 months, 6 months, 7 months, 8 months, 9 months, 10 months, 11 months, 12 months, 18 months, 2 years, 2.5 years, 3 years, 3.5 years, 4 years, 4.5 years, 5 years, 5.5 years, 6 years, 6.5 years, 7 years, 7.5 years, 8 years, 8.5 years, 9 years, 9.5 years, or 10 years. In this embodiment, the first material **11** and/or the second material **21** are sufficiently robust to withstand the conditions to which the luminescent particle **1** will be subjected.

According to one embodiment, the second material **21** is the same as the first material **11** as described hereabove.

According to one embodiment, the second material **21** is different from the first material **11** as described hereabove.

According to one embodiment, the at least one particle **2** is dispersed in the first material **11.**

According to one embodiment, the at least one particle **2** is totally surrounded by or encapsulated in the first material **11.**

According to one embodiment, the at least one particle **2** is fluorescent.

According to one embodiment, the at least one particle **2** is phosphorescent.

According to one embodiment, the at least one particle **2** is electroluminescent.

According to one embodiment, the at least one particle **2** is chemiluminescent.

According to one embodiment, the at least one particle **2** is triboluminescent.

According to one embodiment, the features of the light emission of particle **2** are sensible to external pressure variations. In this embodiment, "sensible" means that the features of the light emission can be modified by external pressure variations.

According to one embodiment, the wavelength emission peak of particle **2** is sensible to external pressure variations. In this embodiment, "sensible" means that the wavelength emission peak can be modified by external pressure variations, i.e. external pressure variations can induce a wavelength shift.

According to one embodiment, the FWHM of particle **2** is sensible to external pressure variations. In this embodiment, "sensible" means that the FWHM can be modified by external pressure variations, i.e. FWHM can be reduced or increased.

According to one embodiment, the PLQY of particle **2** is sensible to external pressure variations. In this embodiment, "sensible" means that the PLQY can be modified by external pressure variations, i.e. PLQY can be reduced or increased.

According to one embodiment, the features of the light emission of particle **2** are sensible to external temperature variations.

According to one embodiment, the wavelength emission peak of particle **2** is sensible to external temperature variations. In this embodiment, "sensible" means that the wavelength emission peak can be modified by external temperature variations, i.e. external temperature variations can induce a wavelength shift.

According to one embodiment, the FWHM of particle **2** is sensible to external temperature variations. In this embodiment, "sensible" means that the FWHM can be modified by external temperature variations, i.e. FWHM can be reduced or increased.

According to one embodiment, the PLQY of particle **2** is sensible to external temperature variations. In this embodiment, "sensible" means that the PLQY can be modified by external temperature variations, i.e. PLQY can be reduced or increased.

According to one embodiment, the features of the light emission of particle **2** are sensible to external variations of pH.

According to one embodiment, the wavelength emission peak of particle **2** is sensible to external variations of pH. In this embodiment, "sensible" means that the wavelength emission peak can be modified by external variations of pH, i.e. external variations of pH can induce a wavelength shift.

According to one embodiment, the FWHM of particle **2** is sensible to e external variations of pH. In this embodiment, "sensible" means that the FWHM can be modified by external variations of pH, i.e. FWHM can be reduced or increased.

According to one embodiment, the PLQY of particle **2** is sensible to external variations of pH. In this embodiment, "sensible" means that the PLQY can be modified by external variations of pH, i.e. PLQY can be reduced or increased.

According to one embodiment, the particle **2** comprise at least one nanoparticle **3** wherein the wavelength emission peak is sensible to external temperature variations; and at least one nanoparticle **3** wherein the wavelength emission peak is not or less sensible to external temperature variations. In this embodiment, "sensible" means that the wavelength emission peak can be modified by external temperature variations, i.e. wavelength emission peak can be reduced or increased. This embodiment is particularly advantageous for temperature sensor applications.

According to one embodiment, the at least one particle **2** is a colloidal particle.

According to one embodiment, the at least one particle **2** is dispersible in aqueous solvents, organic solvents and/or mixture thereof.

According to one embodiment, the at least one particle **2** is not a metallic particle.

According to one embodiment, the at least one particle **2** comprising the second material **21** has a size above 20 nm.

According to one embodiment, the at least one particle **2** has a size of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, a statistical set of particles **2** has an average size of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the at least one particle **2** has a largest dimension of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the at least one particle **2** has a smallest dimension of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the at least one particle **2** smaller than the largest dimension of said at least one particle **2** by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100, at least 150, at least 200, at least 250, at least 300, at least 350, at least 400, at least 450, at least 500, at least 550, at least 600, at least 650, at least 700, at least 750, at least 800, at least 850, at least 900, at least 950, or at least 1000.

According to one embodiment, the particles **2** have an average size of at least 5 nm, 10 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 pm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the at least one particle 2 has a smallest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the at least one particle 2 has a largest curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the surface roughness of the at least one particle **2** is less or equal to 0%, 0.0001%, 0.0002%, 0.0003%, 0.0004%, 0.0005%, 0.0006%, 0.0007%, 0.0008%, 0.0009%, 0.001%, 0.002%, 0.003%, 0.004%, 0.005%, 0.006%, 0.007%, 0.008%, 0.009%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, 0.21%, 0.22%, 0.23%, 0.24%, 0.25%, 0.26%, 0.27%, 0.28%, 0.29%, 0.3%, 0.31%, 0.32%, 0.33%, 0.34%, 0.35%, 0.36%, 0.37%, 0.38%, 0.39%, 0.4%, 0.41%, 0.42%, 0.43%, 0.44%, 0.45%, 0.46%, 0.47%, 0.48%, 0.49%, 0.5%, 1%, 1.5%, 2%, 2.5% 3%, 3.5%, 4%, 4.5%, or 5% of the largest dimension of said at least one particle **2,** meaning that the surface of said at least one particle **2** is completely smooth.

According to one embodiment, the surface roughness of the at least one particle **2** is less or equal to 0.5% of the largest dimension of said at least one particle **2,** meaning that the surface of said at least one particle **2** is completely smooth.

According to one embodiment, the at least one particle **2** has a spherical shape, an ovoid shape, a discoidal shape, a cylindrical shape, a faceted shape, a hexagonal shape, a triangular shape, a cubic shape, or a platelet shape.

According to one embodiment, the at least one particle **2** has a raspberry shape, a prism shape, a polyhedron shape, a snowflake shape, a flower shape, a thorn shape, a hemisphere shape, a cone shape, a urchin shape, a filamentous shape, a biconcave discoid shape, a worm shape, a tree shape, a dendrite shape, a necklace shape, a chain shape, or a bush shape.

According to one embodiment, the at least one particle **2** has a spherical shape, or the at least one particle **2** is a bead.

According to one embodiment, the particle **2** does not have a core/shell structure.

According to one embodiment, the particle **2** has a core/shell structure as described hereafter.

According to one embodiment, the spherical particle **2** has a diameter of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm,

17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, a statistical set of spherical particles **2** has an average diameter of at least 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the average diameter of a statistical set of spherical particles **2** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 20%, 30%, 40%, 50%, 60%, 70%, 80%, 85%, 90%, 95%, 100%, 105%, 110%, 115%, 120%, 125%, 130%, 135%, 140%, 145%, 150%, 155%, 160%, 165%, 170%, 175%, 180%, 185%, 190%, 195%, or 200%.

According to one embodiment, a statistical set of the spherical particles **2** has an average unique curvature of at least 200 µm⁻¹, 100 µm⁻¹, 66.6 µm⁻¹, 50 µm⁻¹, 33.3 µm⁻¹, 28.6 µm⁻¹, 25 µm⁻¹, 20 µm⁻¹, 18.2 µm⁻¹, 16.7 µm⁻¹, 15.4 µm⁻¹, 14.3 µm⁻¹, 13.3 µm⁻¹, 12.5 µm⁻¹, 11.8 µm⁻¹, 11.1 µm⁻¹, 10.5 µm⁻¹, 10 µm⁻¹, 9.5 µm⁻¹, 9.1 µm⁻¹, 8.7 µm⁻¹, 8.3 µm⁻¹, 8 µm⁻¹, 7.7 µm⁻¹, 7.4 µm⁻¹, 7.1 µm⁻¹, 6.9 µm⁻¹, 6.7 µm⁻¹, 5.7 µm⁻¹, 5 µm⁻¹, 4.4 µm⁻¹, 4 µm⁻¹, 3.6 µm⁻¹, 3.3 µm⁻¹, 3.1 µm⁻¹, 2.9 µm⁻¹, 2.7 µm⁻¹, 2.5 µm⁻¹, 2.4 µm⁻¹, 2.2 µm⁻¹, 2.1 µm⁻¹, 2 µm⁻¹, 1.3333 µm⁻¹, 0.8 µm⁻¹, 0.6666 µm⁻¹, 0.5714 µm⁻¹, 0.5 µm⁻¹, 0.4444 µm⁻¹, 0.4 µm⁻¹, 0.3636 µm⁻¹, 0.3333 µm⁻¹, 0.3080 µm⁻¹, 0.2857 µm⁻¹, 0.2667 µm⁻¹, 0.25 µm⁻¹, 0.2353 µm⁻¹, 0.2222 µm⁻¹, 0.2105 µm⁻¹, 0.2 µm⁻¹, 0.1905 µm⁻¹, 0.1818 µm⁻¹, 0.1739 µm⁻¹, 0.1667 µm⁻¹, 0.16 µm⁻¹, 0.1538 µm⁻¹, 0.1481 µm⁻¹, 0.1429 µm⁻¹, 0.1379 µm⁻¹, 0.1333 µm⁻¹, 0.1290 µm⁻¹, 0.125 µm⁻¹, 0.1212 µm⁻¹, 0.1176 µm⁻¹, 0.1176 µm⁻¹, 0.1143 µm⁻¹, 0.1111 µm⁻¹, 0.1881 µm⁻¹, 0.1053 µm⁻¹, 0.1026 µm⁻¹, 0.1 µm⁻¹, 0.0976 µm⁻¹, 0.9524 µm⁻¹, 0.0930 µm⁻¹, 0.0909 µm⁻¹, 0.0889 µm⁻¹, 0.870 µm⁻¹, 0.0851 µm⁻¹, 0.0833 µm⁻¹, 0.0816 µm⁻¹, 0.08 µm⁻¹, 0.0784 µm⁻¹, 0.0769 µm⁻¹, 0.0755 µm⁻¹, 0.0741 µm⁻¹, 0.0727 µm⁻¹, 0.0714 µm⁻¹, 0.0702 µm⁻¹, 0.0690 µm⁻¹, 0.0678 µm⁻¹, 0.0667 µm⁻¹, 0.0656 µm⁻¹, 0.0645 µm⁻¹, 0.0635 µm⁻¹, 0.0625 µm⁻¹, 0.0615 µm⁻¹, 0.0606 µm⁻¹, 0.0597 µm⁻¹, 0.0588 µm⁻¹, 0.0580 µm⁻¹, 0.0571 µm⁻¹, 0.0563 µm⁻¹, 0.0556 µm⁻¹, 0.0548 µm⁻¹, 0.0541 µm⁻¹, 0.0533 µm⁻¹, 0.0526 µm⁻¹, 0.0519 µm⁻¹, 0.0513 µm⁻¹, 0.0506 µm⁻¹, 0.05 µm⁻¹, 0.0494 µm⁻¹, 0.0488 µm⁻¹, 0.0482 µm⁻¹, 0.0476 µm⁻¹, 0.0471 µm⁻¹, 0.0465 µm⁻¹, 0.0460 µm⁻¹, 0.0455 µm⁻¹, 0.0450 µm⁻¹, 0.0444 µm⁻¹, 0.0440 µm⁻¹, 0.0435 µm⁻¹, 0.0430 µm⁻¹, 0.0426 µm⁻¹, 0.0421 µm⁻¹, 0.0417 µm⁻¹, 0.0412 µm⁻¹, 0.0408 µm⁻¹, 0.0404 µm⁻¹, 0.04 µm⁻¹, 0.0396 µm⁻¹, 0.0392 µm⁻¹, 0.0388 µm⁻¹, 0.0385 µm⁻¹; 0.0381 µm⁻¹, 0.0377 µm⁻¹, 0.0374 µm⁻¹, 0.037 µm⁻¹, 0.0367 µm⁻¹, 0.0364 µm⁻¹, 0.0360 µm⁻¹, 0.0357 µm⁻¹, 0.0354 µm⁻¹, 0.0351 µm⁻¹, 0.0348 µm⁻¹, 0.0345 µm⁻¹, 0.0342 µm⁻¹, 0.0339 µm⁻¹, 0.0336 µm⁻¹, 0.0333 µm⁻¹, 0.0331 µm⁻¹, 0.0328 µm⁻¹, 0.0325 µm⁻¹, 0.0323 µm⁻¹, 0.032 µm⁻¹, 0.0317 µm⁻¹, 0.0315 µm⁻¹, 0.0312 µm⁻¹, 0.031 µm⁻¹, 0.0308 µm⁻¹, 0.0305 µm⁻¹, 0.0303 µm⁻¹, 0.0301 µm⁻¹, 0.03 µm⁻¹, 0.0299 µm⁻¹, 0.0296 µm⁻¹, 0.0294 µm⁻¹, 0.0292 µm⁻¹, 0.029 µm⁻¹, 0.0288 µm⁻¹, 0.0286 µm⁻¹, 0.0284 µm⁻¹, 0.0282 µm⁻¹, 0.028 µm⁻¹, 0.0278 µm⁻¹, 0.0276 µm⁻¹, 0.0274 µm⁻¹, 0.0272 µm⁻¹; 0.0270 µm⁻¹, 0.0268 µm⁻¹, 0.02667 µm⁻¹, 0.0265 µm⁻¹, 0.0263 µm⁻¹, 0.0261 µm⁻¹, 0.026 µm⁻¹, 0.0258 µm⁻¹, 0.0256 µm⁻¹, 0.0255 µm⁻¹, 0.0253 µm⁻¹, 0.0252 µm⁻¹, 0.025 µm⁻¹, 0.0248 µm⁻¹, 0.0247 µm⁻¹, 0.0245 µm⁻¹, 0.0244 µm⁻¹, 0.0242 µm⁻¹, 0.0241 µm⁻¹, 0.024 µm⁻¹, 0.0238 µm⁻¹, 0.0237 µm⁻¹, 0.0235 µm⁻¹, 0.0234 µm⁻¹, 0.0233 µm⁻¹, 0.231 µm⁻¹, 0.023 µm⁻¹, 0.0229 µm⁻¹, 0.0227 µm⁻¹, 0.0226 µm⁻¹, 0.0225 µm⁻¹, 0.0223 µm⁻¹, 0.0222 µm⁻¹, 0.0221 µm⁻¹, 0.022 µm⁻¹, 0.0219 µm⁻¹, 0.0217 µm⁻¹, 0.0216 µm⁻¹, 0.0215 µm⁻¹, 0.0214 µm⁻¹, 0.0213 µm⁻¹, 0.0212 µm⁻¹, 0.0211 µm⁻¹, 0.021 µm⁻¹, 0.0209 µm⁻¹, 0.0208 µm⁻¹, 0.0207 µm⁻¹, 0.0206 µm⁻¹, 0.0205 µm⁻¹, 0.0204 µm⁻¹, 0.0203 µm⁻¹, 0.0202 µm⁻¹, 0.0201 µm⁻¹, 0.02 µm⁻¹, or 0.002 µm⁻¹.

According to one embodiment, the curvature of the spherical particle **2** has no deviation, meaning that said particle **2** has a perfect spherical shape. A perfect spherical shape prevents fluctuations of the intensity of the scattered light.

According to one embodiment, the unique curvature of the spherical particle **2** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, or 10% along the surface of said particle **2.**

According to one embodiment, particles **2** in a same luminescent particle **1** are polydisperse.

According to one embodiment, particles **2** in a same luminescent particle **1** are monodisperse.

According to one embodiment, in a statistical set of particles **2,** said particles **2** have a narrow size distribution.

According to one embodiment, the at least one particle **2** represents at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99% by weight of the luminescent particle **1.**

According to one embodiment, the loading charge of the at least one particle **2** in the luminescent particle **1** is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of the at least one particle **2** in the luminescent particle **1** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the at least one particle **2** is not encapsulated in luminescent particle **1** via physical entrapment or electrostatic attraction.

According to one embodiment, the at least one particle **2** and the first material **1** are not bonded or linked by electrostatic attraction or a functionalized silane based coupling agent.

According to one embodiment, the at least one particle **2** comprised in the luminescent particle **1** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the particles **2** comprised in the same luminescent particle **1** are not aggregated.

According to one embodiment, the particles **2** comprised in the same luminescent particle **1** do not touch, are not in contact.

According to one embodiment, the particles **2** comprised in the same luminescent particle **1** are separated by first material **11.**

According to one embodiment, the at least one particle **2** comprised in the same luminescent particle **1** can be individually evidenced.

According to one embodiment, the at least one particle **2** comprised in the same luminescent particle **1** can be individually evidenced by transmission electron microscopy or fluorescence scanning microscopy, or any other characterization means known by the person skilled in the art.

According to one embodiment, the plurality of particles **2** is uniformly dispersed in the first material **11.**

The uniform dispersion of the plurality of particles **2** in the first material **11** comprised in the luminescent particle **1** prevents the aggregation of said particles **2,** thereby preventing the degradation of their properties. For example, in the case of inorganic fluorescent particles, a uniform dispersion will allow the optical properties of said particles to be preserved, and quenching can be avoided.

According to one embodiment, the particles **2** comprised in a luminescent particle **1** are uniformly dispersed within the first material **11** comprised in said luminescent particle **1.**

According to one embodiment, the dispersion of particles **2** in the first material **11** does not have the shape of a ring, or a monolayer.

According to one embodiment, each particle **2** of the plurality of particles **2** is spaced from its adjacent particle **2** by an average minimal distance.

According to one embodiment, the average minimal distance between two particles **2** is controlled.

According to one embodiment, the average minimal distance is at least 1 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two particles **2** in the same luminescent particle **1** is at least 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 300 µm, 400 µm, 500 µm, 600 µm, 700 µm, 800 µm, 900 µm, or 1 mm.

According to one embodiment, the average distance between two particles **2** in the same luminescent particle **1** may have a deviation less or equal to 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, 7%, 7.1%, 7.2%, 7.3%, 7.4%, 7.5%, 7.6%, 7.7%, 7.8%, 7.9%, 8%, 8.1%, 8.2%, 8.3%, 8.4%, 8.5%, 8.6%, 8.7%, 8.8%, 8.9%, 9%, 9.1%, 9.2%, 9.3%, 9.4%, 9.5%, 9.6%, 9.7%, 9.8%, 9.9%, 10%, 15%, 20%, 25%, 30%, 35%, 40%, 45%, or 50%.

According to one embodiment, the at least one particle **2** is hydrophobic.

According to one embodiment, the at least one particle **2** is hydrophilic.

According to one embodiment, the at least one particle **2** comprises at least 95%, 90%, 85%, 80%, 75%, 70%, 65%, 60%, 55%, 50%, 45%, 40%, 35%, 30%, 25%, 20%, 15%, 10%, 5%, 1% or 0% of nanoparticles **3** on its surface.

According to one embodiment, each nanoparticle **3** is totally surrounded by or encapsulated in the second material **21.**

According to one embodiment, the at least one particle **2** does not comprise nanoparticles **3** on its surface.

According to one embodiment, the at least one particle **2** has an oxygen transmission rate ranging from 10⁻⁷ to 10 cm³.m⁻².day⁻¹, preferably from 10⁻⁷ to 1 cm³.m⁻².day⁻¹, more preferably from 10⁻⁷ to 10⁻¹ cm³.m⁻².day⁻¹, even more preferably from 10⁻⁷ to 10⁻⁴ cm³.m⁻².day⁻¹ at room temperature.

According to one embodiment, the at least one particle **2** has a water vapor transmission rate ranging from 10⁻⁷ to 10 g.m⁻².day⁻¹, preferably from 10⁻⁷ to 1 g.m⁻².day⁻¹, more preferably from 10⁻⁷ to 10⁻¹ g.m⁻².day⁻¹, even more preferably from 10⁻⁷ to 10⁻⁴ g.m⁻².day⁻¹ at room temperature. A water vapor transmission rate of 10⁻⁶ g.m⁻².day⁻¹ is particularly adequate for a use on LED.

According to one embodiment, the at least one particle **2** is a homostructure. In this embodiment, the at least one particle **2** does not comprise a shell or a layer of a material surrounding (partially or totally) said at least one particle **2.**

According to one embodiment, the at least one particle **2** is not a core/shell structure wherein the core does not comprise nanoparticles **3** and the shell comprises nanoparticles **3.**

According to one embodiment, the at least one particle **2** does not comprise an organic shell or an organic layer. In this embodiment, the at least one particle **2** is not covered by any organic ligand or polymer shell.

According to one embodiment illustrated in Fig. 6B, the at least one particle **2** is a heterostructure, comprising a core **22** and at least one shell **23.**

According to one embodiment, the at least one shell **23** is not an organic shell. In this embodiment, the at least one particle **2** is not covered by any organic ligand or by a polymeric shell.

According to one embodiment, the at least one shell **23** does not comprise an organic layer.

According to one embodiment, the shell **23** of the core/shell at least one particle **2** comprises an inorganic material. In this embodiment, said inorganic material is the same or different than the second material **21** comprised in the core **22** of the core/shell at least one particle **2.**

According to one embodiment, the shell **23** of the core/shell at least one particle **2** consists of an inorganic material. In this embodiment, said inorganic material is the same or different than the second material **21** comprised in the core **22** of the core/shell at least one particle **2.**

According to one embodiment, the core **22** of the core/shell at least one particle **2** comprises at least one nanoparticle **3** as described herein and the shell **23** of the core/shell at least one particle **2** does not comprise nanoparticles **3.**

According to one embodiment, the core **22** of the core/shell at least one particle **2** comprises at least one nanoparticle **3** as described herein and the shell **23** of the core/shell at least one particle **2** comprises at least one nanoparticle **3.**

According to one embodiment, the at least one nanoparticle **3** comprised in the core **22** of the core/shell at least one particle **2** is identical to the at least one nanoparticle **3** comprised in the shell **23** of the core/shell at least one particle **2.**

According to one embodiment, the at least one nanoparticle **3** comprised in the core **22** of the core/shell at least one particle **2** is different to the at least one nanoparticle **3** comprised in the shell **23** of the core/shell at least one particle **2.** In this embodiment, the resulting core/shell at least one particle **2** will exhibit different properties.

In a preferred embodiment, the core **22** of the core/shell at least one particle **2** and the shell **23** of the core/shell at least one particle **2** comprise at least two different luminescent nanoparticles, wherein said luminescent nanoparticles emit at different emission wavelengths. This means that the core **22** comprises at least one luminescent nanoparticle and the shell **23** comprises at least one luminescent nanoparticle, said luminescent nanoparticles having different emission wavelengths.

In a preferred embodiment, the core **22** of the core/shell at least one particle **2** and the shell **23** of the core/shell at least one particle **2** comprise at least two different luminescent nanoparticles, wherein at least one luminescent nanoparticle emits at a wavelength in the range from 500 to 560 nm, and at least one luminescent nanoparticle emits at a wavelength in the range from 600 to 2500 nm. In this embodiment, the core **22** of the core/shell at least one particle **2** and the shell **23** of the core/shell at least one particle **2** comprise at least one luminescent nanoparticle emitting in the green region of the visible spectrum and at least one luminescent nanoparticle emitting in the red region of the visible spectrum, thus the at least one particle **2** paired with a blue LED will be a white light emitter.

In a preferred embodiment, the core **22** of the core/shell at least one particle **2** and the shell **23** of the core/shell at least one particle **2** comprise at least two different luminescent nanoparticles, wherein at least one luminescent nanoparticle emits at a wavelength in the range from 400 to 490 nm, and at least one luminescent nanoparticle emits at a wavelength in the range from 600 to 2500 nm. In this embodiment, the core **22** of the core/shell at least one particle **2** and the shell **23** of the core/shell at least one particle **2** comprise at least one luminescent nanoparticle emitting in the blue region of the visible spectrum and at least one luminescent nanoparticle emitting in the red region of the visible spectrum, thus the at least one particle **2** will be a white light emitter.

In a preferred embodiment, the core **22** of the core/shell at least one particle **2** and the shell **23** of the core/shell at least one particle **2** comprise comprises at least two different luminescent nanoparticles, wherein at least one luminescent nanoparticle emits at a wavelength in the range from 400 to 490 nm, and at least one luminescent nanoparticle emits at a wavelength in the range from 500 to 560 nm. In this embodiment, the core **22** of the core/shell at least one particle **2** and the shell **23** of the core/shell at least one particle **2** comprise at least one luminescent nanoparticle emitting in the blue region of the visible spectrum and at least one luminescent nanoparticle emitting in the green region of the visible spectrum.

According to one embodiment, the shell **23** of the at least one particle **2** has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the shell **23** of the at least one particle **2** has a thickness homogeneous all along the core **22,** i.e. the shell **23** of the at least one particle **2** has a same thickness all along the core **22.**

According to one embodiment, the shell **23** of the at least one particle **2** has a thickness heterogeneous along the core **22,** i.e. said thickness varies along the core **22.**

According to one embodiment, the photoluminescence of the at least one particle **2** is preserved after encapsulation in the luminescent particle **1.**

According to one embodiment, the specific property of the at least one particle **2** is preserved after encapsulation in the luminescent particle **1.**

According to one embodiment, the at least one nanoparticle **3** is encapsulated into the second material **21** during the formation of said second material **21.** For example, said nanoparticle **3** are not inserted in nor put in contact with the second material **21** which have been previously obtained.

According to one embodiment, the at least one nanoparticle **3** is a luminescent nanoparticle.

According to one embodiment, the luminescent nanoparticle is a fluorescent nanoparticle.

According to one embodiment, the luminescent nanoparticle is a phosphorescent nanoparticle.

According to one embodiment, the luminescent nanoparticle is a chemiluminescent particle.

According to one embodiment, the luminescent nanoparticle is a triboluminescent particle.

According to one embodiment, the luminescent nanoparticle is a semiconductor nanoparticle.

According to one embodiment, the luminescent nanoparticle is a semiconductor nanocrystal.

According to one embodiment, the ligands attached to the surface of a nanoparticle **3** is in contact with the second material **21.** In this embodiment, said nanoparticle **3** is linked to the second material **21** and the electrical charges from said nanoparticle **3** can be evacuated. This prevents reactions at the surface of the nanoparticles **3** that can be due to electrical charges.

According to one embodiment, the at least one nanoparticle **3** is hydrophobic.

According to one embodiment, the at least one nanoparticle **3** is hydrophilic.

According to one embodiment, the at least one nanoparticle **3** has an average size of at least 0.5 nm, 1 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, 21 nm, 22 nm, 23 nm, 24 nm, 25 nm, 26 nm, 27 nm, 28 nm, 29 nm, 30 nm, 31 nm, 32 nm, 33 nm, 34 nm, 35 nm, 36 nm, 37 nm, 38 nm, 39 nm, 40 nm, 41 nm, 42 nm, 43 nm, 44 nm, 45 nm, 46 nm, 47 nm, 48 nm, 49 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the largest dimension of the at least one nanoparticle 3 is at least 5 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the at least one nanoparticle 3 is at least 0.5 nm, 1 nm, 1.5 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the smallest dimension of the at least one nanoparticle **3** is smaller than the largest dimension of said nanoparticle **3** by a factor (aspect ratio) of at least 1.5; at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100, at least 150, at least 200, at least 250, at least 300, at least 350, at least 400, at least 450, at least 500, at least 550, at least 600, at least 650, at least 700, at least 750, at least 800, at least 850, at least 900, at least 950, or at least 1000.

According to one embodiment, in a statistical ensemble of nanoparticles **3,** said nanoparticles **3** are polydisperse.

According to one embodiment, in a statistical ensemble of nanoparticles **3,** said nanoparticles **3** are monodisperse.

According to one embodiment, in a statistical ensemble of nanoparticles **3,** said nanoparticles **3** have a narrow size distribution.

According to one embodiment, the size distribution for the smallest dimension of a statistical set of nanoparticles **3** is inferior than 1%, 2%, 3%, 4%, 5%, 6%, 7%, 8%, 9%, 10%, 15%, 20%, 25%, 30%, 35%, or 40% of said smallest dimension.

According to one embodiment, the size distribution for the largest dimension of a statistical set of nanoparticles **3** is inferior than 1%, 2%, 3%, 4%, 5%, 6%, 7%, 8%, 9%, 10%, 15%, 20%, 25%, 30%, 35%, or 40% of said largest dimension.

According to one embodiment, the at least one nanoparticle **3** is isotropic.

According to one embodiment, examples of shape of isotropic nanoparticle **3** include but are not limited to: sphere **31** (as illustrated in Fig. 2), faceted sphere, prism, polyhedron, or cubic shape.

According to one embodiment, the at least one nanoparticle **3** is not spherical.

According to one embodiment, the at least one nanoparticle **3** is anisotropic.

According to one embodiment, examples of shape of anisotropic nanoparticle **3** include but are not limited to: rod, wire, needle, bar, belt, cone, or polyhedron shape.

According to one embodiment, examples of branched shape of anisotropic nanoparticle **3** include but are not limited to: monopod, bipod, tripod, tetrapod, star, or octopod shape.

According to one embodiment, examples of complex shape of anisotropic nanoparticle 3 include but are not limited to: snowflake, flower, thorn, hemisphere, cone, urchin, filamentous particle, biconcave discoid, worm, tree, dendrite, necklace, or chain.

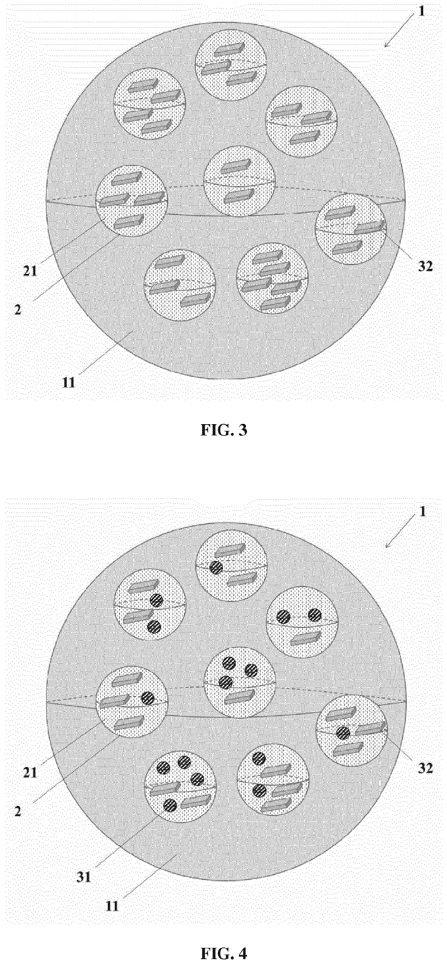

According to one embodiment, as illustrated in Fig. 3, the at least one nanoparticle **3** has a 2D shape **32.**

According to one embodiment, examples of shape of 2D nanoparticle **32** include but are not limited to: sheet, platelet, plate, ribbon, wall, plate triangle, square, pentagon, hexagon, disk or ring.

According to one embodiment, a nanoplatelet is different from a disk or a nanodisk.

According to one embodiment, nanosheets and nanoplatelets are not disks or nanodisks. In this embodiment, the section along the other dimensions than the thickness (width, length) of said nanosheets or nanoplatelets is square or rectangular, while it is circular or ovoidal for disks or nanodisks.

According to one embodiment, nanosheets and nanoplatelets are not disks or nanodisks. In this embodiment, none of the dimensions of said nanosheets and nanoplatelets can be defined as a diameter nor the size of a semi-major axis and a semi-minor axis contrarily to disks or nanodisks.

According to one embodiment, nanosheets and nanoplatelets are not disks or nanodisks. In this embodiment, the curvature at all points along the other dimensions than the thickness (length, width) of said nanosheets or nanoplatelets is below 10 µm⁻¹, while the curvature for disks or nanodisks is superior on at least one point.

According to one embodiment, nanosheets and nanoplatelets are not disks or nanodisks. In this embodiment, the curvature at at least one point along the other dimensions than the thickness (length, width) of said nanosheets or nanoplatelets is below 10 µm⁻¹, while the curvature for disks or nanodisks is superior than 10 µm⁻¹ at all points.

According to one embodiment, a nanoplatelet is different from a quantum dot, or a spherical nanocrystal. A quantum dot is spherical, thus is has a 3D shape and allow confinement of excitons in all three spatial dimensions, whereas the nanoplatelet has a 2D shape and allow confinement of excitons in one dimension and allow free propagation in the other two dimensions. This results in distinct electronic and optical properties, for example the typical photoluminescence decay time of semiconductor platelets is 1 order of magnitude faster than for spherical quantum dots, and the semiconductor platelets also show an exceptionally narrow optical feature with full width at half maximum (FWHM) much lower than for spherical quantum dots.

According to one embodiment, to obtain a ROHS compliant luminescent particle **1,** said luminescent particle **1** rather comprises semiconductor nanoplatelets than semiconductor quantum dots. Indeed, a same emission peak position is obtained for semiconductor quantum dots with a diameter d, and semiconductor nanoplatelets with a thickness d/2; thus for the same emission peak position, a semiconductor nanoplatelet comprises less cadmium in weight than a semiconductor quantum dot. Furthermore, if a CdS core is comprised in a core/shell quantum dot or a core/shell (or core/crown) nanoplatelet, then there are more possibilities of shell layers without cadmium in the case of core/shell (or core/crown) nanoplatelet; thus a core/shell (or core/crown) nanoplatelet with a CdS core may comprise less cadmium in weight than a core/shell quantum dot with a CdS core. The lattice difference between CdS and nonCadmium shells is too important for the quantum dot to sustain. Finally, semiconductor nanoplatelets have better absorption properties than semiconductor quantum dots, thus resulting in less cadmium in weight needed in semiconductor nanoplatelets.

According to one embodiment, a nanoplatelet is different from a nanorod or nanowire. A nanorod (or nanowire) has a 1D shape and allow confinement of excitons two spatial dimensions, whereas the nanoplatelet has a 2D shape and allow confinement of excitons in one dimension and allow free propagation in the other two dimensions. This results in distinct electronic and optical properties.

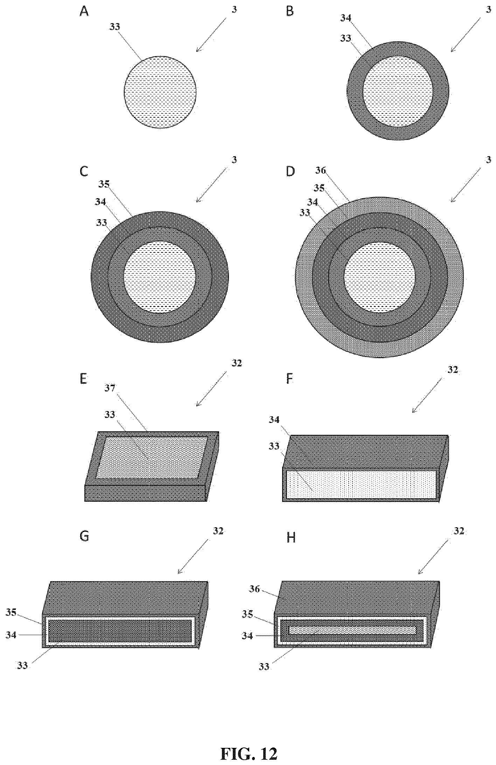

According to one embodiment, as illustrated in Fig. 12A, the at least one nanoparticle **3** is a core nanoparticle **33** without a shell.

According to one embodiment, the at least one nanoparticle **3** is atomically flat. In this embodiment, the atomically flat nanoparticle **3** may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the at least one nanoparticle **3** comprises at least one atomically flat core. In this embodiment, the atomically flat core may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence, or any other characterization means known by the person skilled in the art.

According to one embodiment, the at least one nanoparticle **3** is a core **33**/shell **34** nanoparticle, wherein the core **33** is partially or totally covered with at least one shell **34** comprising at least one layer of material.

According to one embodiment, as illustrated in Fig. 12B-C and Fig. 12F-G, the at least one nanoparticle **3** is a core **33**/shell **34** nanoparticle, wherein the core **33** is covered with at least one shell (**34**, **35**).

According to one embodiment, the at least one shell (**34**, **35**) has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the at least one nanoparticle **3** is a core **33**/shell **34** nanoparticle, wherein the core **33** and the shell **34** are composed of the same material.

According to one embodiment, the at least one nanoparticle **3** is a core **33**/shell **34** nanoparticle, wherein the core **33** and the shell **34** are composed of at least two different materials.

According to one embodiment, the at least one nanoparticle **3** is a core **33**/shell **34** nanoparticle, wherein the core **33** is a luminescent core covered with at least one shell **34** selected in the group of magnetic material, plasmonic material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a magnetic core covered with at least one shell **34** selected in the group of luminescent material, plasmonic material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a plasmonic core covered with at least one shell **34** selected in the group of magnetic material, luminescent material, dielectric material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a dielectric core covered with at least one shell **34** selected in the group of magnetic material, plasmonic material, luminescent material, piezoelectric material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a piezoelectric core covered with at least one shell **34** selected in the group of magnetic material, plasmonic material, dielectric material, luminescent material, pyro-electric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a pyro-electric core covered with at least one shell **34** selected in the group of magnetic material, plasmonic material, dielectric material, luminescent material, piezoelectric material, ferro-electric material, light scattering material, electrically insulating material, thermally insulating material or catalytic material.

According to one embodiment, the at least one nanoparticle **3** is a core **33**/shell **34** nanoparticle, wherein the core **33** is a ferro-electric core covered with at least one shell **34** selected in the group of magnetic material, plasmonic material, dielectric material, luminescent material, piezoelectric material, pyro-electric material, light scattering material, electrically insulating material, thermally insulating material or catalytic material.

According to one embodiment, the at least one nanoparticle **3** is a core **33**/shell **34** nanoparticle, wherein the core **33** is a light scattering core covered with at least one shell **34** selected in the group of magnetic material, plasmonic material, dielectric material, luminescent material, piezoelectric material, pyro-electric material, ferro-electric material, electrically insulating material, thermally insulating material or catalytic material.

According to one embodiment, the at least one nanoparticle **3** is a core **33**/shell **34** nanoparticle, wherein the core **33** is an electrically insulating core covered with at least one shell **34** selected in the group of magnetic material, plasmonic material, dielectric material, luminescent material, piezoelectric material, pyro-electric material, ferro-electric material, light scattering material, thermally insulating material or catalytic material.

According to one embodiment, the at least one nanoparticle **3** is a core **33**/shell **34** nanoparticle, wherein the core **33** is a thermally insulating core covered with at least one shell **34** selected in the group of magnetic material, plasmonic material, dielectric material, luminescent material, piezoelectric material, pyro-electric material, ferro-electric material, light scattering material, electrically insulating material or catalytic material.

According to one embodiment, the at least one nanoparticle **3** is a core **33**/shell **34** nanoparticle, wherein the core **33** is a catalytic core covered with at least one shell **34** selected in the group of magnetic material, plasmonic material, dielectric material, luminescent material, piezoelectric material, pyro-electric material, ferro-electric material, light scattering material, electrically insulating material or thermally insulating material.

According to one embodiment, the at least one nanoparticle **3** is a core **33**/shell **36** nanoparticle, wherein the core **33** is covered with an insulator shell **36.** In this embodiment, the insulator shell **36** prevents the aggregation of the cores **33.**

According to one embodiment, the insulator shell **36** has a thickness of at least 0.1 nm, 0.2 nm, 0.3 nm, 0.4 nm, 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm or 500 nm.

According to one embodiment, as illustrated in Fig. 12D and Fig. 12H, the at least one nanoparticle **3** is a core **33**/shell (**34**, **35**, **36**) nanoparticle, wherein the core **33** is covered with at least one shell (**34**, **35**) and an insulator shell **36**.

According to one embodiment, the shells (**34, 35, 36**) covering the core **33** of the at least one nanoparticle **3** may be composed of the same material.

According to one embodiment, the shells (**34, 35, 36**) covering the core **33** of the at least one nanoparticle **3** may be composed of at least two different materials.

According to one embodiment, the shells (**34, 35, 36**) covering the core **33** of the at least one nanoparticle **3** may have the same thickness.

According to one embodiment, the shells (**34, 35, 36**) covering the core **33** of the at least one nanoparticle **3** may have different thickness.

According to one embodiment, each shell (**34, 35, 36**) covering the core **33** of the at least one nanoparticle **3** has a thickness homogeneous all along the core **33,** i.e. each shell (**34, 35, 36**) has a same thickness all along the core **33.**

According to one embodiment, each shell (**34, 35, 36**) covering the core **33** of the at least one nanoparticle **3** has a thickness heterogeneous along the core **33,** i.e. said thickness varies along the core **33.**

According to one embodiment, the at least one nanoparticle **3** is a core **33**/insulator shell **36** nanoparticle, wherein examples of insulator shell **36** include but are not limited to: non-porous SiO₂, mesoporous SiO₂, non-porous MgO, mesoporous MgO, non-porous ZnO, mesoporous ZnO, non-porous Al₂O₃, mesoporous Al₂O₃, non-porous ZrO₂, mesoporous ZrO₂, non-porous TiO₂, mesoporous TiO₂, non-porous SnO₂, mesoporous SnO₂, or a mixture thereof. Said insulator shell **36** acts as a supplementary barrier against oxidation and can drain away the heat if it is a good thermal conductor.

According to one embodiment, as illustrated in Fig. 12E, the at least one nanoparticle **3** is a core **33**/crown **37** nanoparticle with a 2D structure, wherein the core **33** is covered with at least one crown **37.**

According to one embodiment, the at least one nanoparticle **3** is a core **33**/crown **37** nanoparticle, wherein the core **33** is covered with a crown **37** comprising at least one layer of material.

According to one embodiment, the at least one nanoparticle **3** is a core **33**/crown **37** nanoparticle, wherein the core **33** and the crown **37** are composed of the same material.

According to one embodiment, the at least one nanoparticle **3** is a core **33**/crown **37** nanoparticle, wherein the core **33** and the crown **37** are composed of at least two different materials.

According to one embodiment, the at least one nanoparticle **3** is a core **33**/crown **37** nanoparticle, wherein the core **33** is a luminescent core covered with at least one crown **37** selected in the group of magnetic material, plasmonic material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a magnetic core covered with at least one crown **37** selected in the group of luminescent material, plasmonic material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a plasmonic core covered with at least one crown **37** selected in the group of magnetic material, luminescent material, dielectric material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a dielectric core covered with at least one crown **37** selected in the group of magnetic material, plasmonic material, luminescent material, piezoelectric material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a piezoelectric core covered with at least one crown **37** selected in the group of magnetic material, plasmonic material, dielectric material, luminescent material, pyro-electric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a pyro-electric core covered with at least one crown **37** selected in the group of magnetic material, plasmonic material, dielectric material, luminescent material, piezoelectric material, ferro-electric material, light scattering material, electrically insulating material, thermally insulating material, or catalytic material.

According to one embodiment, the at least one nanoparticle **3** is a core **33**/crown **37** nanoparticle, wherein the core **33** is a ferro-electric core covered with at least one crown **37** selected in the group of magnetic material, plasmonic material, dielectric material, luminescent material, piezoelectric material, pyro-electric material, light scattering material, electrically insulating material, thermally insulating material, or catalytic material.

According to one embodiment, the at least one nanoparticle **3** is a core **33**/crown **37** nanoparticle, wherein the core **33** is a light scattering core covered with at least one crown **37** selected in the group of magnetic material, plasmonic material, dielectric material, luminescent material, piezoelectric material, pyro-electric material, ferro-electric material, electrically insulating material, thermally insulating material, or catalytic material.

According to one embodiment, the at least one nanoparticle **3** is a core **33**/crown **37** nanoparticle, wherein the core **33** is an electrically insulating core covered with at least one crown **37** selected in the group of magnetic material, plasmonic material, dielectric material, luminescent material, piezoelectric material, pyro-electric material, ferro-electric material, light scattering material, thermally insulating material, or catalytic material.

According to one embodiment, the at least one nanoparticle **3** is a core **33**/crown **37** nanoparticle, wherein the core **33** is a thermally insulating core covered with at least one crown **37** selected in the group of magnetic material, plasmonic material, dielectric material, luminescent material, piezoelectric material, pyro-electric material, ferro-electric material, light scattering material, electrically insulating material, or catalytic material.

According to one embodiment, the at least one nanoparticle **3** is a core **33**/crown **37** nanoparticle, wherein the core **33** is a catalytic core covered with at least one crown **37** selected in the group of magnetic material, plasmonic material, dielectric material, luminescent material, piezoelectric material, pyro-electric material, ferro-electric material, light scattering material, electrically insulating material, or thermally insulating material.

According to one embodiment, the at least one nanoparticle **3** is a core **33**/crown **37** nanoparticle, wherein the core **33** is covered with an insulator crown. In this embodiment, the insulator crown prevents the aggregation of the cores **33.**

According to one embodiment, the at least one particle **2** comprises at least two nanoparticles **3.** In this embodiment, the at least one particle **2** is not a core/shell nanoparticle wherein the core is the at least one nanoparticle **3** and the shell is the second material **21.**

According to one embodiment, the at least one particle **2** comprises a plurality of nanoparticles **3.**

According to one embodiment, the at least one particle **2** comprises more than ten nanoparticles **3.**

According to one embodiment, the at least one particle **2** comprises at least 1, at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88, at least 89, at least 90, at least 91, at least 92, at least 93, at least 94, at least 95, at least 96, at least 97, at least 98, at least 99, at least 100, at least 200, at least 300, at least 400, at least 500, at least 600, at least 700, at least 800, at least 900, at least 1000, at least 1500, at least 2000, at least 2500, at least 3000, at least 3500, at least 4000, at least 4500, at least 5000, at least 5500, at least 6000, at least 6500, at least 7000, at least 7500, at least 8000, at least 8500, at least 9000, at least 9500, at least 10000, at least 15000, at least 20000, at least 25000, at least 30000, at least 35000, at least 40000, at least 45000, at least 50000, at least 55000, at least 60000, at least 65000, at least 70000, at least 75000, at least 80000, at least 85000, at least 90000, at least 95000, or at least 100000 nanoparticles **3.**

According to one embodiment, the number of nanoparticles **3** comprised in the at least one particle **2** depends mainly on the molar ratio or the mass ratio between the chemical species allowing to produce the second material **21** and the at least one nanoparticle **3.**

According to one embodiment, the at least one nanoparticle **3** represents at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99% by weight of the luminescent particle **1.**

According to one embodiment, the loading charge of the at least one nanoparticle **3** in the at least one particle **2** is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of the at least one nanoparticle **3** in the at least one particle **2** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the nanoparticle **3** are not encapsulated in particle **2** via physical entrapment or electrostatic attraction.

According to one embodiment, the nanoparticle **3** and the second material **21** are not bonded or linked by electrostatic attraction or a functionalized silane based coupling agent.

According to one embodiment, the at least one nanoparticle **3** comprised in the at least one particle **2** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the nanoparticles **3** comprised in the at least one particle **2** are not aggregated.

According to one embodiment, the nanoparticles **3** comprised in the at least one particle **2** do not touch, are not in contact.

According to one embodiment, the nanoparticles **3** comprised in the at least one particle **2** are separated by second material **21.**

According to one embodiment, the at least one nanoparticle **3** comprised in the at least one particle **2** can be individually evidenced.

According to one embodiment, the at least one nanoparticle **3** comprised in the at least one particle **2** can be individually evidenced by transmission electron microscopy or fluorescence scanning microscopy, or any other characterization means known by the person skilled in the art.

According to one embodiment, the plurality of nanoparticles **3** is uniformly dispersed in the second material **21** comprised in the at least one particle **2.**

The uniform dispersion of the plurality of nanoparticles **3** in the second material **21** comprised in the at least one particle **2** prevents the aggregation of said nanoparticles **3,** thereby preventing the degradation of their properties. For example, in the case of inorganic fluorescent nanoparticles, a uniform dispersion will allow the optical properties of said nanoparticles to be preserved, and quenching can be avoided.

According to one embodiment, the nanoparticles **3** comprised in a luminescent particle **1** are uniformly dispersed within the second material **21** comprised in said luminescent particle **1.**

According to one embodiment, the nanoparticles **3** comprised in a luminescent particle **1** are dispersed within the second material **21** comprised in said luminescent particle **1.**

According to one embodiment, the nanoparticles **3** comprised in a luminescent particle **1** are uniformly and evenly dispersed within the second material **21** comprised in said luminescent particle **1.**

According to one embodiment, the nanoparticles **3** comprised in a luminescent particle **1** are evenly dispersed within the second material **21** comprised in said luminescent particle **1.**

According to one embodiment, the nanoparticles **3** comprised in a luminescent particle **1** are homogeneously dispersed within the second material **21** comprised in said luminescent particle **1.**

According to one embodiment, the dispersion of nanoparticles **3** in the second material **21** does not have the shape of a ring, or a monolayer.

According to one embodiment, each nanoparticle **3** of the plurality of nanoparticles **3** is spaced from its adjacent nanoparticle **3** by an average minimal distance described hereabove.

According to one embodiment, the average minimal distance between two nanoparticles **3** is controlled.

According to one embodiment, as illustrated in Fig. 4, the at least one particle **2** comprises a combination of at least two different nanoparticles (**31, 32**). In this embodiment, the at least one particle **2,** thus the resulting luminescent particle **1** will exhibit different properties.

In a preferred embodiment, the at least one particle **2** comprises at least two different luminescent nanoparticles, wherein said luminescent nanoparticles emit different emission wavelengths.

In a preferred embodiment, the at least one particle **2** comprises at least two different luminescent nanoparticles, wherein at least one luminescent nanoparticle emits at a wavelength in the range from 500 to 560 nm, and at least one luminescent nanoparticle emits at a wavelength in the range from 600 to 2500 nm. In this embodiment, the at least one particle **2** comprises at least one luminescent nanoparticle emitting in the green region of the visible spectrum and at least one luminescent nanoparticle emitting in the red region of the visible spectrum, thus the luminescent particle **1** paired with a blue LED will be a white light emitter.

In a preferred embodiment, the at least one particle **2** comprises at least two different luminescent nanoparticles, wherein at least one luminescent nanoparticle emits at a wavelength in the range from 400 to 490 nm, and at least one luminescent nanoparticle emits at a wavelength in the range from 600 to 2500 nm. In this embodiment, the at least one particle **2** comprises at least one luminescent nanoparticle emitting in the blue region of the visible spectrum and at least one luminescent nanoparticle emitting in the red region of the visible spectrum, thus the luminescent particle **1** will be a white light emitter.

In a preferred embodiment, the at least one particle **2** comprises at least two different luminescent nanoparticles, wherein at least one luminescent nanoparticle emits at a wavelength in the range from 400 to 490 nm, and at least one luminescent nanoparticle emits at a wavelength in the range from 500 to 560 nm. In this embodiment, the at least one particle **2** comprises at least one luminescent nanoparticle emitting in the blue region of the visible spectrum and at least one luminescent nanoparticle emitting in the green region of the visible spectrum.

In a preferred embodiment, the at least one particle **2** comprises three different luminescent nanoparticles, wherein said luminescent nanoparticles emit at different emission wavelengths or color.

In a preferred embodiment, the at least one particle **2** comprises at least three different luminescent nanoparticles, wherein at least one luminescent nanoparticle emits at a wavelength in the range from 400 to 490 nm, at least one luminescent nanoparticle emits at a wavelength in the range from 500 to 560 nm and at least one luminescent nanoparticle emits at a wavelength in the range from 600 to 2500 nm. In this embodiment, the at least one particle **2** comprises at least one luminescent nanoparticle emitting in the blue region of the visible spectrum, at least one luminescent nanoparticle emitting in the green region of the visible spectrum and at least one luminescent nanoparticle emitting in the red region of the visible spectrum.

According to one embodiment, the at least one particle **2** comprises at least one nanoparticle **3** without a shell and at least one nanoparticle **3** selected in the group of core **33**/shell **34** nanoparticles **3** and core **33**/insulator shell **36** nanoparticles **3.**

According to one embodiment, the at least one particle **2** comprises at least one core **33**/shell **34** nanoparticle **3** and at least one nanoparticle **3** selected in the group of nanoparticles **3** without a shell and core **33**/insulator shell **36** nanoparticles **3.**

According to one embodiment, the at least one particle **2** comprises at least one core **33**/insulator shell **36** nanoparticle **3** and at least one nanoparticle **3** selected in the group of nanoparticles **3** without a shell and core **33**/shell **34** nanoparticles **3.**

According to one embodiment, the at least one nanoparticle **3** is a colloidal nanoparticle.

According to one embodiment, the at least one nanoparticle **3** is an inorganic nanoparticle.

According to one embodiment, the at least one nanoparticle **3** comprises an inorganic material. Said inorganic material is the same or different from the first or second materials.

According to one embodiment, the luminescent particle **1** comprises at least one inorganic nanoparticle and at least one organic nanoparticle.

According to one embodiment, the at least one nanoparticle **3** is not a ZnO nanoparticle.

According to one embodiment, the at least one nanoparticle **3** is not a metal nanoparticle.

According to one embodiment, the luminescent particle **1** does not comprise only metal nanoparticles.

According to one embodiment, the luminescent particle **1** does not comprise only magnetic nanoparticles.

According to one embodiment, the inorganic nanoparticle is a colloidal nanoparticle.

According to one embodiment, the inorganic nanoparticle is a semiconductor nanocrystal.

According to one embodiment, the semiconductor nanocrystal comprises a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; x, y, z and w are independently a decimal number from 0 to 5; x, y, z and w are not simultaneously equal to 0; x and y are not simultaneously equal to 0; z and w may not be simultaneously equal to 0.

According to one embodiment, the semiconductor nanocrystal comprises a core comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; x, y, z and w are independently a decimal number from 0 to 5; x, y, z and w are not simultaneously equal to 0; x and y are not simultaneously equal to 0; z and w may not be simultaneously equal to 0.

According to one embodiment, the semiconductor nanocrystal comprises a material of formula MₓN_{y}E_{z}A_{w}, wherein M and/or N is selected from the group consisting of Ib, IIa, lib, IIIa, IIIb, IVa, IVb, Va, Vb, Vlb, VIIb, VIII, or mixtures thereof; E and/or A is selected from the group consisting of Va, VIa, VIIa, or mixtures thereof; x, y, z and w are independently a decimal number from 0 to 5; x, y, z and w are not simultaneously equal to 0; x and y are not simultaneously equal to 0; z and w may not be simultaneously equal to 0.

According to one embodiment, w, x, y and z are independently a decimal number from 0 to 5, at the condition that when w is 0, x, y and z are not 0, when x is 0, w, y and z are not 0, when y is 0, w, x and z are not 0 and when z is 0, w, x and y are not 0.

According to one embodiment, the semiconductor nanocrystal is selected from the group consisting of a IIb-VIa, IVa-VIa, Ib-IIIa-VIa, IIb-IVa-Va, Ib-VIa, VIII-Via, IIb-Va, IIIa-VIa, IVb-VIa, IIa-VIa, IIIa-Va, IIIa-VIa, VIb-VIa, and Va-VIa semiconductor.

According to one embodiment, the inorganic nanoparticle is a semiconductor nanoplatelet, nanosheet, nanoribbon, nanowire, nanodisk, nanocube, nanoring, magic size cluster, or sphere such as for example quantum dot.

According to one embodiment, the inorganic nanoparticle is a semiconductor nanoplatelet, nanosheet, nanoribbon, nanowire, nanodisk, nanocube, magic size cluster, or nanoring.

According to one embodiment, the inorganic nanoparticle comprises an initial nanocrystal.

According to one embodiment, the inorganic nanoparticle comprises an initial colloidal nanocrystal.

According to one embodiment, the inorganic nanoparticle comprises an initial nanoplatelet.

According to one embodiment, the inorganic nanoparticle comprises an initial colloidal nanoplatelet.

According to one embodiment, the inorganic nanoparticle is a core nanoparticle, wherein each core is not partially or totally covered with at least one shell comprising at least one layer of inorganic material.

According to one embodiment, the inorganic nanoparticle is a core **33** nanocrystal, wherein each core **33** is not partially or totally covered with at least one shell **34** comprising at least one layer of inorganic material.

According to one embodiment, the inorganic nanoparticle is a core/shell nanoparticle, wherein the core is partially or totally covered with at least one shell comprising at least one layer of inorganic material.

According to one embodiment, the inorganic nanoparticle is a core nanocrystal, wherein the core is not partially or totally covered with a shell comprising at least one layer of inorganic material.

According to one embodiment, the inorganic nanoparticle is a core **33**/shell **34** nanocrystals, wherein the core **33** is partially or totally covered with at least one shell **34** comprising at least one layer of inorganic material.

According to one embodiment, the core/shell semiconductor nanocrystal comprises at least one shell **34** comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are independently a decimal number from 0 to 5; x, y, z and w are not simultaneously equal to 0; x and y are not simultaneously equal to 0; z and w may not be simultaneously equal to 0.

According to one embodiment, the core/shell semiconductor nanocrystal comprises two shells (**34**, **35**) comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

According to one embodiment, the shell **34** comprises a different material than the material of core **33.**

According to one embodiment, the shell **34** comprises the same material than the material of core **33.**

According to one embodiment, the shells (**34, 35**) comprise different materials.

According to one embodiment, the shells (**34, 35**) comprise the same material.

According to one embodiment, the core/shell semiconductor nanocrystal comprises at least one shell comprising a material of formula MₓN_{y}E_{z}A_{w}, wherein M, N, E and A are as described hereabove.

According to one embodiment, examples of core/shell semiconductor nanocrystals include but are not limited to: CdSe/CdS, CdSe/CdₓZn₁₋ₓS, CdSe/CdS/ZnS, CdSe/ZnS/CdS, CdSe/ZnS, CdSe/CdₓZn₁₋ₓS/ZnS, CdSe/ZnS/CdₓZn₁₋ₓS, CdSe/CdS/CdₓZn₁₋ₓS, CdSe/ZnSe/ZnS, CdSe/ZnSe/CdₓZn₁₋ₓS, CdSeₓS₁₋ₓ/CdS, CdSeₓS₁₋ₓ/CdZnS, CdSeₓS₁₋ₓ/CdS/ZnS, CdSeₓS₁₋ₓ/ZnS/CdS, CdSeₓS₁₋ₓ/ZnS, CdSeₓS₁₋ₓ/CdₓZn₁₋ₓS/ZnS, CdSeₓS₁₋ₓ/ZnS/CdₓZn₁₋ₓS, CdSeₓS₁₋ₓ/CdS/CdₓZn₁₋ₓS, CdSeₓS₁₋ₓ/ZnSe/ZnS, CdSeₓS₁₋ₓ/ZnSe/CdₓZn₁₋ₓS, InP/CdS, InP/CdS/ZnSe/ZnS, InP/CdₓZn₁₋ₓS, InP/CdS/ZnS, InP/ZnS/CdS, InP/ZnS, InP/CdₓZn₁₋ₓS/ZnS, InP/ZnS/CdₓZn₁₋ₓS, InP/CdS/CdₓZn₁₋ₓS, InP/ZnSe, InP/ZnSe/ZnS, InP/ZnSe/CdₓZn₁₋ₓS, InP/ZnSeₓS₁₋ₓ, InP/GaP/ZnS, InₓZn₁₋ₓP/ZnS, InₓZn₁₋ₓP/ZnS, InP/GaP/ZnSe, InP/ZnS/ZnSe, InP/GaP/ZnSe/ZnS, InP/ZnS/ZnSe/ZnS, wherein x is a decimal number from 0 to 1.

According to one embodiment, the core/shell semiconductor nanocrystal is ZnS rich, i.e. the last monolayer of the shell is a ZnS monolayer.

According to one embodiment, the core/shell semiconductor nanocrystal is CdS rich, i.e. the last monolayer of the shell is a CdS monolayer.

According to one embodiment, the core/shell semiconductor nanocrystal is CdₓZn₁₋ₓS rich, i.e. the last monolayer of the shell is a CdₓZn₁₋ₓS monolayer, wherein x is a decimal number from 0 to 1.

According to one embodiment, the last atomic layer of the semiconductor nanocrystal is a cation-rich monolayer of cadmium, zinc or indium.

According to one embodiment, the last atomic layer of the semiconductor nanocrystal is an anion-rich monolayer of sulfur, selenium or phosphorus.

According to one embodiment, the inorganic nanoparticle is a core/crown semiconductor nanocrystal.

According to one embodiment, the core/crown semiconductor nanocrystal comprises at least one crown **37** comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

According to one embodiment, the core/crown semiconductor nanocrystal comprises at least one crown comprising a material of formula MₓN_{y}E_{z}A_{w}, wherein M, N, E and A are as described hereabove.

According to one embodiment, the crown **37** comprises a different material than the material of core **33.**

According to one embodiment, the crown **37** comprises the same material than the material of core **33.**

According to one embodiment, the semiconductor nanocrystal is atomically flat. In this embodiment, the atomically flat semiconductor nanocrystal may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the semiconductor nanocrystal comprises an atomically flat core. In this embodiment, the atomically flat core may be evidenced by transmission electron microscopy or fluorescence scanning microscopy, energy-dispersive X-ray spectroscopy (EDS), X-Ray photoelectron spectroscopy (XPS), UV photoelectron spectroscopy (UPS), electron energy loss spectroscopy (EELS), photoluminescence or any other characterization means known by the person skilled in the art.

According to one embodiment, the semiconductor nanocrystal is a semiconductor nanoplatelet.

According to one embodiment, the semiconductor nanoplatelet is 2D-shaped.

According to one embodiment, the semiconductor nanoplatelet has a thickness tuned at the atomic level.

According to one embodiment, the semiconductor nanoplatelet comprises an initial nanocrystal.

According to one embodiment, the semiconductor nanoplatelet comprises an initial colloidal nanocrystal.

According to one embodiment, the semiconductor nanoplatelet comprises an initial nanoplatelet.

According to one embodiment, the semiconductor nanoplatelet comprises an initial colloidal nanoplatelet.

According to one embodiment, the core 33 of the semiconductor nanoplatelet is an initial nanoplatelet.

According to one embodiment, the initial nanoplatelet comprises a material of formula MₓN_{y}E_{z}A_{w}, wherein M, N, E and A are as described hereabove.

According to one embodiment, the thickness of the initial nanoplatelet comprises an alternate of atomic layers of M and E.

According to one embodiment, the thickness of the initial nanoplatelet comprises an alternate of atomic layers of M, N, A and E.

According to one embodiment, a semiconductor nanoplatelet comprises an initial nanoplatelet partially or completely covered with at least one layer of additional material.

According to one embodiment, the at least one layer of additional material comprises a material of formula MₓN_{y}E_{z}A_{w}, wherein M, N, E and A are as described hereabove.

According to one embodiment, a semiconductor nanoplatelet comprises an initial nanoplatelet partially or completely covered on a least one facet by at least one layer of additional material.

In one embodiment wherein several layers cover all or part of the initial nanoplatelet, these layers can be composed of the same material or composed of different materials.

In one embodiment wherein several layers cover all or part of the initial nanoplatelet, these layers can be composed such as to form a gradient of materials.

In one embodiment, the initial nanoplatelet is an inorganic colloidal nanoplatelet.

In one embodiment, the initial nanoplatelet comprised in the semiconductor nanoplatelet has preserved its 2D structure.

In one embodiment, the material covering the initial nanoplatelet is inorganic.

In one embodiment, at least one part of the semiconductor nanoplatelet has a thickness greater than the thickness of the initial nanoplatelet.

In one embodiment, the semiconductor nanoplatelet comprises the initial nanoplatelet totally covered with at least one layer of material.

In one embodiment, the semiconductor nanoplatelet comprises the initial nanoplatelet totally covered with a first layer of material, said first layer being partially or completely covered with at least a second layer of material.

In one embodiment, the initial nanoplatelet has a thickness of at least 0.3 nm, 0.4 nm, 0.5 nm, 0.6 nm, 0.7 nm, 0.8 nm, 0.9 nm, 1.0 nm, 1.1 nm, 1.2 nm, 1.3 nm, 1.4 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the thickness of the initial nanoplatelet is smaller than at least one of the lateral dimensions (length or width) of the initial nanoplatelet by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100; at least 150; at least 200; at least 250; at least 300; at least 350; at least 400; at least 450; at least 500; at least 550; at least 600; at least 650; at least 700; at least 750; at least 800; at least 850; at least 900; at least 950; or at least 1000.

In one embodiment, the initial nanoplatelet has lateral dimensions of at least 2 nm, 3 nm, 4 nm, 5 nm, 6 nm, 7 nm, 8 nm, 9 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the semiconductor nanoplatelet has a thickness of at least 0.3 nm, 0.4 nm, 0.5 nm, 0.6 nm, 0.7 nm, 0.8 nm, 0.9 nm, 1.0 nm, 1.1 nm, 1.2 nm, 1.3 nm, 1.4 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, 10 nm, 10.5 nm, 11 nm, 11.5 nm, 12 nm, 12.5 nm, 13 nm, 13.5 nm, 14 nm, 14.5 nm, 15 nm, 15.5 nm, 16 nm, 16.5 nm, 17 nm, 17.5 nm, 18 nm, 18.5 nm, 19 nm, 19.5 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 350 nm, 400 nm, 450 nm, or 500 nm.

According to one embodiment, the semiconductor nanoplatelet has lateral dimensions of at least 2 nm, 3 nm, 4 nm, 5 nm, 6 nm, 7 nm, 8 nm, 9 nm, 10 nm, 15 nm, 20 nm, 25 nm, 30 nm, 35 nm, 40 nm, 45 nm, 50 nm, 55 nm, 60 nm, 65 nm, 70 nm, 75 nm, 80 nm, 85 nm, 90 nm, 95 nm, 100 nm, 105 nm, 110 nm, 115 nm, 120 nm, 125 nm, 130 nm, 135 nm, 140 nm, 145 nm, 150 nm, 200 nm, 210 nm, 220 nm, 230 nm, 240 nm, 250 nm, 260 nm, 270 nm, 280 nm, 290 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1 µm, 1.5 µm, 2.5 µm, 3 µm, 3.5 µm, 4 µm, 4.5 µm, 5 µm, 5.5 µm, 6 µm, 6.5 µm, 7 µm, 7.5 µm, 8 µm, 8.5 µm, 9 µm, 9.5 µm, 10 µm, 10.5 µm, 11 µm, 11.5 µm, 12 µm, 12.5 µm, 13 µm, 13.5 µm, 14 µm, 14.5 µm, 15 µm, 15.5 µm, 16 µm, 16.5 µm, 17 µm, 17.5 µm, 18 µm, 18.5 µm, 19 µm, 19.5 µm, 20 µm, 20.5 µm, 21 µm, 21.5 µm, 22 µm, 22.5 µm, 23 µm, 23.5 µm, 24 µm, 24.5 µm, 25 µm, 25.5 µm, 26 µm, 26.5 µm, 27 µm, 27.5 µm, 28 µm, 28.5 µm, 29 µm, 29.5 µm, 30 µm, 30.5 µm, 31 µm, 31.5 µm, 32 µm, 32.5 µm, 33 µm, 33.5 µm, 34 µm, 34.5 µm, 35 µm, 35.5 µm, 36 µm, 36.5 µm, 37 µm, 37.5 µm, 38 µm, 38.5 µm, 39 µm, 39.5 µm, 40 µm, 40.5 µm, 41 µm, 41.5 µm, 42 µm, 42.5 µm, 43 µm, 43.5 µm, 44 µm, 44.5 µm, 45 µm, 45.5 µm, 46 µm, 46.5 µm, 47 µm, 47.5 µm, 48 µm, 48.5 µm, 49 µm, 49.5 µm, 50 µm, 50.5 µm, 51 µm, 51.5 µm, 52 µm, 52.5 µm, 53 µm, 53.5 µm, 54 µm, 54.5 µm, 55 µm, 55.5 µm, 56 µm, 56.5 µm, 57 µm, 57.5 µm, 58 µm, 58.5 µm, 59 µm, 59.5 µm, 60 µm, 60.5 µm, 61 µm, 61.5 µm, 62 µm, 62.5 µm, 63 µm, 63.5 µm, 64 µm, 64.5 µm, 65 µm, 65.5 µm, 66 µm, 66.5 µm, 67 µm, 67.5 µm, 68 µm, 68.5 µm, 69 µm, 69.5 µm, 70 µm, 70.5 µm, 71 µm, 71.5 µm, 72 µm, 72.5 µm, 73 µm, 73.5 µm, 74 µm, 74.5 µm, 75 µm, 75.5 µm, 76 µm, 76.5 µm, 77 µm, 77.5 µm, 78 µm, 78.5 µm, 79 µm, 79.5 µm, 80 µm, 80.5 µm, 81 µm, 81.5 µm, 82 µm, 82.5 µm, 83 µm, 83.5 µm, 84 µm, 84.5 µm, 85 µm, 85.5 µm, 86 µm, 86.5 µm, 87 µm, 87.5 µm, 88 µm, 88.5 µm, 89 µm, 89.5 µm, 90 µm, 90.5 µm, 91 µm, 91.5 µm, 92 µm, 92.5 µm, 93 µm, 93.5 µm, 94 µm, 94.5 µm, 95 µm, 95.5 µm, 96 µm, 96.5 µm, 97 µm, 97.5 µm, 98 µm, 98.5 µm, 99 µm, 99.5 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, or 1 mm.

According to one embodiment, the thickness of the semiconductor nanoplatelet is smaller than at least one of the lateral dimensions (length or width) of the semiconductor nanoplatelet by a factor (aspect ratio) of at least 1.5; of at least 2; at least 2.5; at least 3; at least 3.5; at least 4; at least 4.5; at least 5; at least 5.5; at least 6; at least 6.5; at least 7; at least 7.5; at least 8; at least 8.5; at least 9; at least 9.5; at least 10; at least 10.5; at least 11; at least 11.5; at least 12; at least 12.5; at least 13; at least 13.5; at least 14; at least 14.5; at least 15; at least 15.5; at least 16; at least 16.5; at least 17; at least 17.5; at least 18; at least 18.5; at least 19; at least 19.5; at least 20; at least 25; at least 30; at least 35; at least 40; at least 45; at least 50; at least 55; at least 60; at least 65; at least 70; at least 75; at least 80; at least 85; at least 90; at least 95; at least 100, at least 150, at least 200, at least 250, at least 300, at least 350, at least 400, at least 450, at least 500, at least 550, at least 600, at least 650, at least 700, at least 750, at least 800, at least 850, at least 900, at least 950, or at least 1000.

According to one embodiment, the semiconductor nanoplatelet is obtained by a process of growth in the thickness of at least one face of at least one initial nanoplatelet by deposition of a film or a layer of material on the surface of the at least one initial nanoplatelet; or a process lateral growth of at least one face of at least one initial nanoplatelet by deposition of a film or a layer of material on the surface of the at least one initial nanoplatelet; or any methods known by the person skilled in the art.

In one embodiment, the semiconductor nanoplatelet can comprise the initial nanoplatelet and 1, 2, 3, 4, 5 or more layers covering all or part of the initial nanoplatelet, said layers begin of same composition as the initial nanoplatelet or being of different composition than the initial nanoplatelet or being of different composition one another.

In one embodiment, the semiconductor nanoplatelet can comprise the initial nanoplatelet and at least 1, 2, 3, 4, 5 or more layers in which the first deposited layer covers all or part of the initial nanoplatelet and the at least second deposited layer covers all or part of the previously deposited layer, said layers being of same composition as the initial nanoplatelet or being of different composition than the initial nanoplatelet and possibly of different compositions one another.

According to one embodiment, the semiconductor nanoplatelet has a thickness quantified by a MₓN_{y}E_{z}A_{w} monolayer, wherein M, N, E and A are as described hereabove.

According to one embodiment, the core **33** of the semiconductor nanoplatelet has a thickness of at least 1 MₓN_{y}E_{z}A_{w} monolayer, at least 2 MₓN_{y}E_{z}A_{w} monolayers, at least 3 MₓN_{y}E_{z}A_{w} monolayers, at least 4 MₓN_{y}E_{z}A_{w} monolayers, at least 5 MₓN_{y}E_{z}A_{w} monolayers, wherein M, N, E and A are as described hereabove.

According to one embodiment, the shell **34** of the semiconductor nanoplatelet has a thickness quantified by a MₓN_{y}E_{z}A_{w} monolayer, wherein M, N, E and A are as described hereabove, wherein M, N, E and A are as described hereabove.

According to one embodiment, the photoluminescence of the at least one nanoparticle **3** is preserved after encapsulation in the at least one particle **2** and after encapsulation of said at least one particle **2** in the luminescent particle **1.**

According to one embodiment, the specific property of the nanoparticles **3** is preserved after encapsulation in the at least one particle **2** and after encapsulation of said at least one particle **2** in the luminescent particle **1.**

According to one embodiment, the size ratio between the luminescent particle **1** and the at least one particle **2** ranges from 10 to 2 000, preferably from 10 to 1 500, more preferably from 10 to 1 000, even more preferably from 10 to 500.

According to one embodiment, the size ratio between the luminescent particle **1** and the at least one nanoparticle **3** ranges from 12 to 100 000, preferably from 50 to 50 000, more preferably from 100 to 10 000, even more preferably from 200 to 1 000.

According to one embodiment, the size ratio between the at least one particle **2** and the at least one nanoparticle **3** ranges from 1.25 to 1 000, preferably from 2 to 500, more preferably from 5 to 250, even more preferably from 5 to 100.

According to a preferred embodiment, examples of luminescent particle **1** include but are not limited to: semiconductor nanoparticles encapsulated in an inorganic material dispersed in Al₂O₃, HfO₂, Si_{0.8}Hf_{0.2}O₂, ZnS, ZnO, MgO, or SiO₂; semiconductor nanocrystals encapsulated in an inorganic material dispersed in Al₂O₃, HfO₂, Si_{0.8}Hf_{0.2}O₂, ZnS, ZnO, MgO, or SiO₂; semiconductor nanoplatelets encapsulated in an inorganic material dispersed in Al₂O₃, HfO₂, Si_{0.8}Hf_{0.2}O₂, ZnS, ZnO, MgO, or SiO₂; perovskite nanoparticles encapsulated in an inorganic material dispersed in Al₂O₃, HfO₂, Si_{0.8}Hf_{0.2}O₂, ZnS, ZnO, MgO, or SiO₂; phosphor nanoparticles encapsulated in an inorganic material dispersed in Al₂O₃, HfO₂, Si_{0.8}Hf_{0.2}O₂, ZnS, ZnO, MgO, or SiO₂; semiconductor nanoplatelets coated with grease dispersed in Al₂O₃, HfO₂, Si_{0.8}Hf_{0.2}O₂, ZnS, ZnO, MgO, or SiO₂; or a mixture thereof. In this embodiment, grease can refer to lipids as, for example, long apolar carbon chain molecules; phosphlipid molecules that possess a charged end group; polymers such as block copolymers or copolymers, wherein one portion of polymer has a domain of long apolar carbon chains, either part of the backbone or part of the polymeric sidechain; or long hydrocarbon chains that have a terminal functional group that includes carboxylates, sulfates, phosphonates or thiols.

According to a preferred embodiment, examples of luminescent particle **1** include but are not limited to: CdSe/CdZnS@SiO₂@Al₂O₃, CdSe/CdZnS@SiₓCd_{y}Zn_{z}O_{w}@Al₂O₃, CdSe/CdZnS-Au@SiO₂@Al₂O₃, CdSeS/CdZnS@SiO₂@Al₂O₃, InP/ZnSe/ZnS@SiO₂@Al₂O₃, CdSeS/CdZnS@SiO₂@Al₂O₃, phosphor nanoparticles@SiO₂@Al₂O₃, Fe₃O₄@SiO₂@Al₂O₃, InP/ZnS@SiO₂@Al₂O₃, CdSe/CdZnS-Au@SiO₂@Al₂O₃, CdSe/CdS/ZnS@SiO₂@Al₂O₃; CdSe/CdZnS@SiO₂@ZnO, CdSe/CdZnS@SiₓCd_{y}Zn_{z}O_{w}@ZnO, CdSe/CdZnS-Au@SiO₂@ZnO, CdSeS/CdZnS@SiO₂@ZnO, InP/ZnSe/ZnS@SiO₂@ZnO, CdSeS/CdZnS@SiO₂@ZnO, phosphor nanoparticles@SiO₂@ZnO, Fe₃O₄@SiO₂@ZnO, InP/ZnS@SiO₂@ZnO, CdSe/CdZnS-Au@SiO₂@ZnO, CdSe/CdS/ZnS@SiO₂@ZnO; CdSe/CdZnS@SiO₂@HfO₂, CdSe/CdZnS @SiₓCd_{y}Zn_{z}O_{w}@HfO₂, CdSe/CdZnS-Au@SiO₂@HfO₂, CdSeS/CdZnS @SiO₂@HfO₂, InP/ZnSe/ZnS @SiO₂@HfO₂, CdSeS/CdZnS @SiO₂@HfO₂, phosphor nanoparticles @SiO₂@HfO₂, Fe₃O₄@SiO₂@HfO₂, InP/ZnS @SiO₂@HfO₂, CdSe/CdZnS-Au@SiO₂@HfO₂, CdSe/CdS/ZnS@SiO₂@HfO₂; CdSe/CdZnS@SiO₂@MgO, CdSe/CdZnS @SiₓCd_{y}Zn_{z}O_{w}@MgO, CdSe/CdZnS-Au@SiO₂@MgO, CdSeS/CdZnS @SiO₂@MgO, InP/ZnSe/ZnS @SiO₂@MgO, CdSeS/CdZnS @SiO₂@MgO, phosphor nanoparticles@SiO₂@MgO, Fe₃O₄@SiO₂@MgO, InP/ZnS@SiO₂@MgO, CdSe/CdZnS-Au@SiO₂@MgO, CdSe/CdS/ZnS @SiO₂@MgO;CdSe/CdZnS@Al₂O₃@SiO₂, InP/ZnS @Al₂O₃@SiO₂, CH₅N₂-PbBr₃@Al₂O₃@SiO₂, CdS/ZnS @Al₂O₃@SiO₂, CdSeS/CdZnS@Al₂O₃@SiO₂, CdSeS/ZnS@Al₂O₃@SiO₂, Fe₃O₄@Al₂O₃@SiO₂, CdSe/CdZnS-phosphor nanoparticles@Al₂O₃@SiO₂; CdSe/CdZnS@Al₂O₃@ZnO, InP/ZnS@Al₂O₃@ZnO, CH₅N₂-PbBr₃@Al₂O₃@ZnO, CdS/ZnS@Al₂O₃@ZnO, CdSeS/CdZnS@Al₂O₃@ZnO, CdSeS/ZnS@Al₂O₃@ZnO, Fe₃O₄@Al₂O₃@ZnO, CdSe/CdZnS- phosphor nanoparticles@Al₂O₃@ZnO; CdSe/CdZnS@Al₂O₃@HfO₂, InP/ZnS@Al₂O₃@HfO₂, CH₅N₂-PbBr₃@Al₂O₃@HfO₂, CdS/ZnS@Al₂O₃@HfO₂, CdSeS/CdZnS@Al₂O₃@HfO₂, CdSeS/ZnS@Al₂O₃@HfO₂, Fe₃O₄@Al₂O₃@HfO₂, CdSe/CdZnS- phosphor nanoparticles@Al₂O₃@HfO₂; CdSe/CdZnS@Al₂O₃@MgO, InP/ZnS@Al₂O₃@MgO, CH₅N₂-PbBr₃@Al₂O₃@MgO, CdS/ZnS@Al₂O₃@MgO, CdSeS/CdZnS@Al₂O₃@MgO, CdSeS/ZnS@Al₂O₃@MgO, Fe₃O₄@Al₂O₃@MgO, CdSe/CdZnS- phosphor nanoparticles@Al₂O₃@MgO; CdSe/CdZnS@ZnO@Al₂O₃, CdSe/CdZnS@ZnO@Al₂O₃, phosphor nanoparticles@ZnO@Al₂O₃; CdSe/CdZnS@ZnO@HfO₂, CdSe/CdZnS@ZnO@HfO₂, phosphor nanoparticles@ZnO@HfO₂; CdSe/CdZnS@ZnO@SiO₂, CdSe/CdZnS@ZnO@SiO₂, phosphor nanoparticles@ZnO@SiO₂; CdSe/CdZnS@ZnO@MgO, CdSe/CdZnS@ZnO@MgO, phosphor nanoparticles@ZnO@MgO; phosphor nanoparticles@HfO₂@Al₂O₃, CdSe/CdZnS @HfO₂@Al₂O₃, CdSeS/CdZnS@HfO₂@Al₂O₃, InP/ZnS@HfO₂@Al₂O₃, CdSeS/CdZnS @HfO₂@Al₂O₃, InP/ZnSe/ZnS @HfO₂@Al₂O₃, CdSe/CdZnS-Fe₃O₄@HfO₂@Al₂O₃; phosphor nanoparticles@HfO₂@SiO₂, CdSe/CdZnS@HfO₂@SiO₂, CdSeS/CdZnS @HfO₂@SiO₂, InP/ZnS@HfO₂@SiO₂, CdSeS/CdZnS @HfO₂@SiO₂, InP/ZnSe/ZnS@HfO₂@SiO₂, CdSe/CdZnS-Fe₃O₄@HfO₂@SiO₂; phosphor nanoparticles@HfO₂@ZnO, CdSe/CdZnS @HfO₂@ZnO, CdSeS/CdZnS @HfO₂@ZnO, InP/ZnS@HfO₂@ZnO, CdSeS/CdZnS@HfO₂@ZnO, InP/ZnSe/ZnS@HfO₂@ZnO, CdSe/CdZnS-Fe₃O₄@HfO₂@ZnO; phosphor nanoparticles@HfO₂@MgO, CdSe/CdZnS@HfO₂@MgO, CdSeS/CdZnS@HfO₂@MgO, InP/ZnS@HfO₂@MgO, CdSeS/CdZnS@HfO₂@MgO, InP/ZnSe/ZnS@HfO₂@MgO, CdSe/CdZnS-Fe₃O₄@HfO₂@MgO; InP/GaP/ZnSe/ZnS@Al₂O₃@HfO₂; InP/ZnS/ZnSe/ZnS@Al₂O₃@HfO₂; CdSe/CdZnS@HfO₂@Si_{0.8}Hf_{0.2}O₂; CdSe/CdZnS@Al₂O₃@HfO₂; CdSe/CdZnS@Al₂O₃ and SnO₂ particles encapsulated in Al₂O₃; phosphor particles@Al₂O₃@HfO₂ CdSe/CdZnS@HfO₂@Al₂O₃; CdSe/CdZnS@HfO₂ and SnO₂ particles encapsulated in Al₂O₃; phosphor particles@HfO₂@Al₂O₃; CdSe/CdZnS@HfO₂@SiO₂ comprising SnO2 nanoparticles; semiconductor nanoplatelets@Al₂O₃@SiO₂; semiconductor nanoplatelets@HfO₂@SiO₂; semiconductor nanoplatelets@Al₂O₃@SiO₂; CdSe/CdZnS@HfO₂@SiO₂; or a mixture thereof; wherein phosphor nanoparticles include but are not limited to: Yttrium aluminium garnet particles (YAG, Y₃Al₅O₁₂), (Ca,Y)-α-SiAlON:Eu particles, ((Y,Gd)₃(Al,Ga)₅O₁₂:Ce) particles, CaAlSiN₃:Eu particles, sulfide-based phosphor particles, PFS:Mn⁴⁺ particles (potassium fluorosilicate).

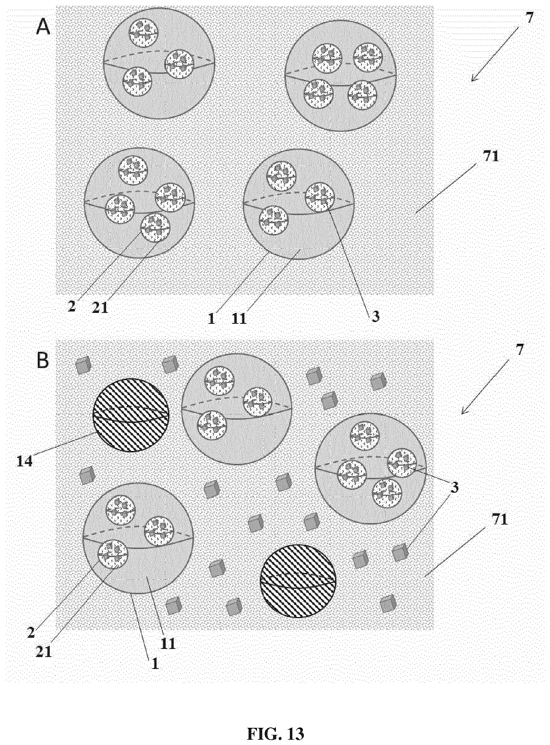

Another object of the invention relates to light emitting material **7** comprising at least one host material **71** and at least one luminescent particle **1** of the invention, wherein said at least one luminescent particle **1** is dispersed in the at least one host material **71** (as illustrated in Fig. 13A).

The light emitting material **7** allows the protection of the luminescent particle **1** from molecular oxygen, water and/or high temperature by the at least one host material **71.** Therefore, deposition of a supplementary protective layer on top of said light emitting material **7** is not compulsory, which can save time, money and loss of luminescence.

According to one embodiment, the host material **71** surrounds, encapsulates and/or covers partially or totally at least one luminescent particle **1.**

According to one embodiment, the light emitting material **7** further comprises a plurality of luminescent particle 1.

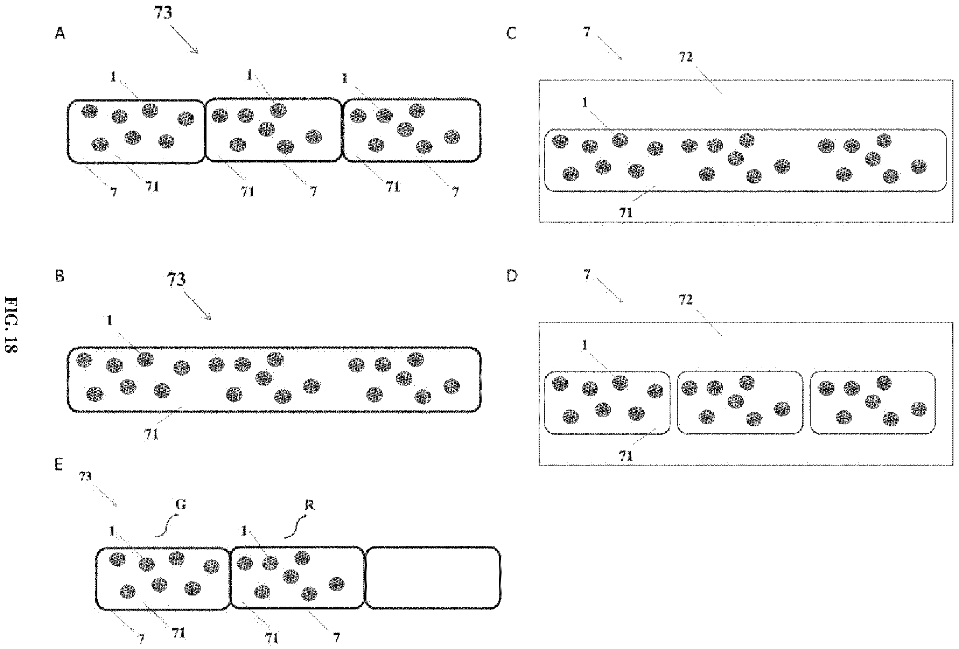

According to one embodiment illustrated in Fig. 18 C-D, the light emitting material **7** comprises at least two host materials **71.** In this embodiment, the host materials may be different or identical.

According to one embodiment, the light emitting material **7** comprises a plurality of host materials **71.**

According to one embodiment, the plurality of luminescent particles **1** is uniformly dispersed in the host material **71.**

According to one embodiment, the loading charge of luminescent particles **1** in the host material **71** is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of luminescent particles **1** in the host material **71** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the luminescent particles **1** dispersed in the host material **71** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the luminescent particles **1** dispersed in the host material **71** have a packing fraction of less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the luminescent particles **1** are adjoigning, are in contact.

According to one embodiment, in the same host material **71,** the luminescent particles **1** are not aggregated.

According to one embodiment, the luminescent particles **1** do not touch, are not in contact.

According to one embodiment in the same host material **71,** the luminescent particles **1** do not touch, are not in contact.

According to one embodiment, the luminescent particles **1** are separated by the host material **71.**

According to one embodiment, the luminescent particles **1** can be individually evidenced for example by conventional microscopy, transmission electron microscopy, scanning transmission electron microscopy, scanning electron microscopy, or fluorescence scanning microscopy.

According to one embodiment, each luminescent particle **1** of the plurality of luminescent particles **1** is spaced from its adjacent luminescent particle **1** by an average minimal distance as described hereabove.

According to one embodiment, the light emitting material **7** is free of oxygen.

According to one embodiment, the light emitting material **7** is free of water.

According to one embodiment, the light illumination the photon flux or average peak pulse power of the illumination are as described hereabove. According to one embodiment, the host material **71** is free of oxygen.

According to one embodiment, the host material **71** is free of water.

According to one embodiment, the host material **71** limits or prevents the degradation of the chemical and physical properties of the at least one luminescent particle **1** from molecular oxygen, water and/or high temperature.

According to one embodiment, the host material **71** is optically transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

According to one embodiment, the host material **71** has a refractive index ranging from 1.0 to 3.0, from 1.2 to 2.6, from 1.4 to 2.0 at 450 nm.

According to one embodiment, the host material **71** has a refractive index of at least 1.0, 1.1, 1.2, 1.3, 1.4, 1.5, 1.6, 1.7, 1.8, 1.9, 2.0, 2.1, 2.2, 2.3, 2.4, 2.5, 2.6, 2.7, 2.8, 2.9, or 3.0 at 450 nm.

According to one embodiment, the host material **71** has a refractive index distinct from the refractive index of the first material **11** comprised in the at least one luminescent particle **1** or from the refractive index of the luminescent particle **1.** This embodiment allows for a wider scattering of light. This embodiment also allows to have a difference in light scattering as a function of the wavelength, in particular to increase the scattering of the excitation light with respect to the scattering of the emitted light, as the wavelength of the excitation light is lower than the wavelength of the emitted light.

According to one embodiment, the host material **71** has a difference of refractive index with the refractive index of the first material **11** comprised in the at least one luminescent particle **1** or with the refractive index of the luminescent particle **1** of at least 0.02, 0.025, 0.03, 0.035, 0.04, 0.045, 0.05, 0.055, 0.06, 0.065, 0.07, 0.075, 0.08, 0.085, 0.09, 0.095, 0.1, 0.11, 0.115, 0.12, 0.125, 0.13, 0.135, 0.14, 0.145, 0.15, 0.155, 0.16, 0.165, 0.17, 0.175, 0.18, 0.185, 0.19, 0.195, 0.2, 0.25, 0.3, 0.35, 0.4, 0.45, 0.5, 0.55, 0.6, 0.65, 0.7, 0.75, 0.8, 0.85, 0.9, 0.95, 1, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, or 2.

According to one embodiment, the host material **71** has a difference of refractive index with the first material **11** comprised in the at least one luminescent particle **1** ranging from 0.02 to 2, ranging from 0.02 to 1.5, ranging from 0.03 to 1.5, ranging from 0.04 to 1.5, ranging from 0.05 to 1.5, ranging from 0.02 to 1.2, ranging from 0.03 to 1.2, ranging from 0.04 to 1.2, ranging from 0.05 to 1.2, ranging from 0.05 to 1, ranging from 0.1 to 1, ranging from 0.2 to 1, ranging from 0.3 to 1, ranging from 0.5 to 1, ranging from 0.05 to 2, ranging from 0.1 to 2, ranging from 0.2 to 2, ranging from 0.3 to 2, or ranging from 0.5 to 2.

The difference of refractive index was measured at 450 nm.

According to one embodiment, the host material **71** has a refractive index superior or equal to the refractive index of the first material **11.**

According to one embodiment, the host material **71** has a refractive index inferior to the refractive index of the first material **11.**

According to one embodiment, the host material **71** has a difference of refractive index with the refractive index of the second material **21** of at least 0.02, 0.025, 0.03, 0.035, 0.04, 0.045, 0.05, 0.055, 0.06, 0.065, 0.07, 0.075, 0.08, 0.085, 0.09, 0.095, 0.1, 0.11, 0.115, 0.12, 0.125, 0.13, 0.135, 0.14, 0.145, 0.15, 0.155, 0.16, 0.165, 0.17, 0.175, 0.18, 0.185, 0.19, 0.195, 0.2, 0.25, 0.3, 0.35, 0.4, 0.45, 0.5, 0.55, 0.6, 0.65, 0.7, 0.75, 0.8, 0.85, 0.9, 0.95, 1, 1.1, 1.15, 1.2, 1.25, 1.3, 1.35, 1.4, 1.45, 1.5, 1.55, 1.6, 1.65, 1.7, 1.75, 1.8, 1.85, 1.9, 1.95, or 2 at 450 nm.

According to one embodiment, the host material **71** has a refractive index superior or equal to the refractive index of the second material **21.**

According to one embodiment, the host material **71** has a refractive index inferior to the refractive index of the second material **21.**

According to one embodiment, the at least one luminescent particle **1** in the host material **71** is configured to scatter light.

According to one embodiment, the light emitting material **7** has a haze factor ranging from 1% to 100%.

According to one embodiment, the light emitting material **7** has a haze factor of at least 1%, 2%, 3%, 4%, 5%, 10%, 15%, 20%, 25%, 30%, 35%, 40%, 45%, 50%, 55%, 60%, 65%, 70%, 75%, 80%, 85%, 90%, 95%, or 100%.

The haze factor is calculated by the ratio between the intensity of light scattered by the material beyond the viewing angle and the total intensity transmitted by the material when illuminated with a light source.

According to one embodiment, the viewing angle used to measure the haze factor ranges from 0° to 20°.

According to one embodiment, the viewing angle used to measure the haze factor is at least 0°, 1°, 2°, 3°, 4°, 5°, 6°, 7°, 8°, 9°, 10°, 11°, 12°, 13°, 14°, 15°, 16°, 17°, 18°, 19°, or 20°.

According to one embodiment, the at least one luminescent particle **1** in the host material **71** is configured to serve as a waveguide. In this embodiment, the refractive index of the at least one luminescent particle **1** is higher than the refractive index of the host material **71.**

According to one embodiment, the luminescent particle **1** has a spherical shape. The spherical shape may permit to the light to circulate in the luminescent particle **1** without leaving said luminescent particle such as to operate as a waveguide. The spherical shape may permit to the light to have whispering-gallery wave modes. Furthermore, a perfect spherical shape prevents fluctuations of the intensity of the scattered light.

According to one embodiment, the at least one luminescent particle **1** in the host material **71** is configured to generate multiple reflections of light inside said luminescent particle **1.**

According to one embodiment, the host material **71** has a refractive index equal to the refractive index of the first material **11** comprised in the at least one luminescent particle **1.** In this embodiment, scattering of light is prevented.

According to one embodiment, the host material **71** has a thermal conductivity at standard conditions of at least 0.1 W/(m.K).

According to one embodiment, the host material **71** can be cured into a shape of a film, thereby generating a film.

According to one embodiment, the host material **71** is polymeric.

According to one embodiment, the host material **71** comprises an organic material as described hereafter.

According to one embodiment, the host material **71** comprises an organic polymer as described hereafter.

According to one embodiment, the host material **71** can polymerize by heating it and/or by exposing it to UV light.

According to one embodiment, the polymeric host material **71** includes but is not limited to: silicone based polymers, polydimethylsiloxanes (PDMS), polyethylene terephthalate, polyesters, polyacrylates, polymethacrylates, polycarbonate, poly(vinyl alcohol), polyvinylpyrrolidone, polyvinylpyridine, polysaccharides, poly(ethylene glycol), melamine resins, a phenol resin, an alkyl resin, an epoxy resin, a polyurethane resin, a maleic resin, a polyamide resin, an alkyl resin, a maleic resin, terpenes resins, an acrylic resin or acrylate based resin such as PMMA, copolymers forming the resins, co-polymers, block co-polymers, polymerizable monomers comprising an UV initiator or thermic initiator, or a mixture thereof.

According to one embodiment, the polymeric host material **71** includes but is not limited to: thermosetting resin, photosensitive resin, photoresist resin, photocurable resin, or dry-curable resin. The thermosetting resin and the photocurable resin are cured using heat and light, respectively. For the use of the dry hard resin, the resin is cured by applying heat to a solvent in which the at least one luminescent particle **1** is dispersed.

When a thermosetting resin or a photocurable resin is used, the composition of the resulting light emitting material **7** is equal to the composition of the raw material of the light emitting material **7.** However, when a dry-curable resin is used, the composition of the resulting light emitting material **7** may be different from the composition of the raw material of the light emitting material **7.** During the dry-curing by heat, the solvent is partially evaporated. Thus, the volume ratio of luminescent particle **1** in the raw material of the light emitting material **7** may be lower than the volume ratio of luminescent particle **1** in the resulting light emitting material **7.**

Upon curing of the resin, a volume contraction is caused. According to one embodiment, a least 2%, 3%, 4%, 5%, 6%, 7%, 8%, 9%, 10%, 15%, or 20%, of contraction are aroused from a thermosetting resin or a photocurable resin. According to one embodiment, a dry-curable resin is contracted by at least 0.1%, 0.2%, 0.3%, 0.4%, 0.5%, 0.6%, 0.7%, 0.8%, 0.9%, 1%, 1.5%, 2%, 2.5%, 3%, 3.5%, 4%, 4.5%, 5%, 5.5%, 6%, 6.5%, 7%, 7.5%, 8%, 8.5%, 9%, 9.5%, 10%, 15%, or 20%. The contraction of the resin may cause movement of the luminescent particles **1,** which may be lower the degree of dispersion of the luminescent particles **1** in the light emitting material **7.** However, embodiments of the present invention can maintain high dispersibility by preventing the movement of the luminescent particles **1** by introducing other particles in said light emitting material **7.**

In one embodiment, the host material **71** may be a polymerizable formulation which can include monomers, oligomers, polymers, or mixture thereof.

In one embodiment, the polymerizable formulation may further comprise a crosslinking agent, a scattering agent, a photo initiator or a thermal initiator.

In one embodiment, the polymerizable formulation includes but is not limited to: monomers, oligomers or polymers made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, n-butyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In another embodiment, the polymerizable formulation includes but is not limited to: monomers, oligomers or polymers made from an alkyl acrylamide or alkyl methacrylamide such as acrylamide, Alkylacrylamide, N-tert-Butylacrylamide, Diacetone acrylamide, N,N-Diethylacrylamide, N-(Isobutoxymethyl)acrylamide, N-(3-Methoxypropyl)acrylamide, NDiphenylmethylacrylamide, N-Ethylacrylamide, N-Hydroxyethyl acrylamide, N-(Isobutoxymethyl)acrylamide, N-Isopropylacrylamide, N-(3-Methoxypropyl)acrylamide, N-Phenylacrylamide, N-[Tris(hydroxymethyl)methyl]acrylamide, N,N-Diethylmethacrylamide, N,NDimethylacrylamide, N-[3-(Dimethylamino)propyl]methacrylamide, N-(Hydroxymethyl)acrylamide, 2-Hydroxypropyl methacrylamide, N-Isopropylmethacrylamide, Methacrylamide, N-(Triphenylmethyl)methacrylamide, poly (3,4-ethylenedioxythiopene), poly(ethylene dioxythiophene)/poly(styrene sulfonic acid) (PEDOT/PSS), an aqueous solution of polyaniline/camphor sulfonic acid (PANI/CSA), PTPDES, Et-PIT- DEK, PPBA, and similar derivatives.

In one embodiment, the polymerizable formulation includes but is not limited to: monomers, oligomers or polymers made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, examples of crosslinking agent include but are not limited to: di-acrylate, triacrylate, tetra-acrylate, di-methacrylate, tri-methacrylate and tetra- methacrylate monomers derivatives and the like. Another example of crosslinking agent includes but is not limited to: monomers, oligomers or polymers made from di- or trifunctional monomers such as allyl methacrylate, diallyl maleate, 1,3-butanediol dimethacrylate, 1,4-butanediol dimethacrylate, 1,6-hexanediol dimethacrylate, pentaerythritol triacrylate, trimethylolpropane triacrylate, Ethylene glycol dimethacrylate, Triethylene glycol dimethacrylate, N,N-methylenebis(acrylamide), N,N'-Hexamethylenebis(methacrylamide), and divinyl benzene.

In one embodiment, the polymerizable formulation may further comprise scattering particles Examples of scattering particles include but are not limited to: SiO₂, ZrO₂, ZnO, MgO, SnO₂, Au, Ag, TiO₂, alumina, barium sulfate, PTFE, barium titanate and the like.

In one embodiment, the polymerizable formulation may further comprise a thermal conductor. Examples of thermal conductor include but are not limited to: SiO₂, ZrO₂, ZnO, MgO, SnO₂, TiO₂, CaO, alumina, barium sulfate, PTFE, barium titanate and the like. In this embodiment, the thermal conductivity of the host material **71** is increased.

In one embodiment, the polymerizable formulation may further comprise a photo initiator. Examples of photo initiator include but are not limited to: α-hydroxyketone, phenylglyoxylate, benzyldimethyl-ketal, α-aminoketone, monoacylphosphine oxides, bisacylphosphine oxides, phosphine oxide, benzophenone and derivatives, polyvinyl cinnamate, metallocene or iodonium salt derivatives and the like. Another example of photo initiator includes Irgacure^{®} photoinitiator and Esacure^{®} photoinitiator and the like.

In one embodiment, the polymerizable formulation may further comprise a thermal initiator. Examples of thermal initiator include but are limited to: peroxide compounds, azo compounds such as azobisisobutyronitrile (AIBN) and 4,4-Azobis(4-cyanovaleric acid), potassium and ammonium persulfate, tert-Butyl peroxide, benzoyl peroxide and the like.

In one embodiment, the polymeric host material **71** may be a polymerized solid made from an alkyl methacrylates or an alkyl acrylates such as acrylic acid, methacrylic acid, crotonic acid, acrylonitrile, acrylic esters substituted with methoxy, ethoxy, propoxy, butoxy, and similar derivatives for example, methyl acrylate, ethyle acrylate, propyl acrylate, butyl acrylate, isobutyl acrylate, lauryl acrylate, norbornyl acrylate, 2-ethyl hexyl acrylate, 2-hydroxyethyl acrylate, 4-hydroxybutyl acrylate, benzyl acrylate, phenyl acrylate, isobornyle acrylate, hydroxypropyl acrylate, fluorinated acrylic monomers, chlorinated acrylic monomers, methacrylic acid, methyl methacrylate, nbutyl methacrylate, isobutyl methacrylate, 2-ethyl hexyl methacrylate, 2-hydroxyethyl methacrylate, 4-hydroxybutyl methacrylate, benzyl methacrylate, phenyl methacrylate, lauryl methacrylate, norbornyl methacrylate, isobornyle methacrylate, hydroxypropyl methacrylate, fluorinated methacrylic monomers, chlorinated methacrylic monomers, alkyl crotonates, allyl crotonates, glycidyl methacrylate and related esters.

In one embodiment, the polymeric host material **71** may be a polymerized solid made from an alkyl acrylamide or alkyl methacrylamide such as acrylamide, Alkylacrylamide, Ntert-Butylacrylamide, Diacetone acrylamide, N,N-Diethylacrylamide, N-Isobutoxymethyl)acrylamide, N-(3-Methoxypropyl)acrylamide, NDiphenylmethylacrylamide, N-Ethylacrylamide, N-Hydroxyethyl acrylamide, N-(Isobutoxymethyl)acrylamide, N-Isopropylacrylamide, N-(3- Methoxypropyl)acrylamide, N-Phenylacrylamide, N-[Tris(hydroxymethyl)methyl] acrylamide, N,N-Diethylmethacrylamide, N,NDimethylacrylamide, N-[3-(Dimethylamino)propyl]methacrylamide, N- (Hydroxymethyl)acrylamide, 2-Hydroxypropyl methacrylamide, NIsopropylmethacrylamide, Methacrylamide, N-(Triphenylmethyl)methacrylamide, poly (3,4-ethylenedioxythiopene), poly(ethylene dioxythiophene)/poly(styrene sulfonic acid) (PEDOT/PSS), an aqueous solution of polyaniline/camphor sulfonic acid (PANI/CSA), PTPDES, Et-PIT- DEK, PPBA, and similar derivatives.

In one embodiment, the polymeric host material **71** may be a polymerized solid made from alpha-olefins, dienes such as butadiene and chloroprene; styrene, alpha-methyl styrene, and the like; heteroatom substituted alpha-olefins, for example, vinyl acetate, vinyl alkyl ethers for example, ethyl vinyl ether, vinyltrimethylsilane, vinyl chloride, tetrafluoroethylene, chlorotrifiuoroethylene, cyclic and polycyclic olefin compounds for example, cyclopentene, cyclohexene, cycloheptene, cyclooctene, and cyclic derivatives up to C20; polycyclic derivates for example, norbornene, and similar derivatives up to C20; cyclic vinyl ethers for example, 2, 3-dihydrofuran, 3,4-dihydropyran, and similar derivatives; allylic alcohol derivatives for example, vinylethylene carbonate, disubstituted olefins such as maleic and fumaric compounds for example, maleic anhydride, diethylfumarate, and the like, and mixtures thereof.

In one embodiment, the polymeric host material **71** may be PMMA, Poly(lauryl methacrylate), glycolized poly(ethylene terephthalate), Poly(maleic anhydride -altoctadecene), or mixtures thereof.

According to one embodiment, the host material **71** comprises a film-forming material. In this embodiment, the film-forming material is a polymer or an inorganic material as described hereabove.

According to one embodiment, the host material **71** comprises at least 1%, 2%, 3%, 4%, 5%, 6%, 7%, 8%, 9%, 10%, 15%, 20%, 25%, 30%, 35%, 40%, 45%, 50%, 55%, 60%, 65%, 70%, 75%, 80%, 85%, 90%, 95%, or 100% by weight of a film-forming material.

According to one embodiment, the film-forming material is polymeric, i.e. comprises or consists of polymers and/or monomers as described hereabove.

According to one embodiment, the film-forming material is inorganic, i.e. it comprises or consists of an inorganic material as described hereafter.

In another embodiment, the light emitting material **7** comprises the luminescent particles **1** of the invention and a polymeric host material **71,** and does not comprise a solvent. In this embodiment, the luminescent particles **1** and host material **71** can be mixed by extrusion.

According to another embodiment, the host material **71** is inorganic.

According to one embodiment, the host material **71** does not comprise glass.

According to one embodiment, the host material **71** does not comprise vitrified glass.

According to one embodiment, examples of inorganic host material **71** include but are not limited to: materials obtainable by sol-gel process, metal oxides such as for example SiO₂, Al₂O₃, TiO₂, ZrO₂, ZnO, MgO, SnO₂, IrO₂, or a mixture thereof. Said host material **71** acts as a supplementary barrier against oxidation and can drain away the heat if it is a good thermal conductor.

According to one embodiment, the host material **71** is composed of a material selected in the group of metals, halides, chalcogenides, phosphides, sulfides, metalloids, metallic alloys, ceramics such as for example oxides, carbides, or nitrides. Said host material **71** is prepared using protocols known to the person skilled in the art.

According to one embodiment, a chalcogenide is a chemical compound consisting of at least one chalcogen anion selected in the group of O, S, Se, Te, Po, and at least one or more electropositive element.

According to one embodiment, the metallic host material **71** is selected in the group of gold, silver, copper, vanadium, platinum, palladium, ruthenium, rhenium, yttrium, mercury, cadmium, osmium, chromium, tantalum, manganese, zinc, zirconium, niobium, molybdenum, rhodium, tungsten, iridium, nickel, iron, or cobalt.

According to one embodiment, examples of carbide host material **71** include but are not limited to: SiC, WC, BC, MoC, TiC, Al₄C₃, LaC₂, FeC, CoC, HfC, SiₓC_{y}, WₓC_{y}, BₓC_{y}, MoₓC_{y}, TiₓC_{y}, AlₓC_{y}, LaₓC_{y}, FeₓC_{y}, CoₓC_{y}, HfₓC_{y}, or a mixture thereof; x and y are independently a decimal number from 0 to 5, at the condition that x and y are not simultaneously equal to 0, and x ≠ 0.

According to one embodiment, examples of oxide host material **71** include but are not limited to: SiO₂, Al₂O₃, TiO₂, ZrO₂, ZnO, MgO, SnO₂, Nb₂O₅, CeO₂, BeO, IrO₂, CaO, Sc₂O₃, NiO, Na₂O, BaO, K₂O, PbO, Ag₂O, V₂O₅, TeO₂, MnO, B₂O₃, P₂O₅, P₂O₃, P₄O₇, P₄O₈, P₄O₉, P₂O₆, PO, GeO₂, As₂O₃, Fe₂O₃, Fe₃O₄, Ta₂O₅, Li₂O, SrO, Y₂O₃, HfO₂, WO₂, MoO₂, Cr₂O₃, Tc₂O₇, ReO₂, RuO₂, Co₃O₄, OsO, RhO₂, Rh₂O₃, PtO, PdO, CuO, Cu₂O, CdO, HgO, Tl₂O, Ga₂O₃, In₂O₃, Bi₂O₃, Sb₂O₃, PoO₂, SeO₂, Cs₂O, La₂O₃, Pr₆O₁₁, Nd₂O₃, La₂O₃, Sm₂O₃, Eu₂O₃, Tb₄O₇, Dy₂O₃, Ho₂O₃, Er₂O₃, Tm₂O₃, Yb₂O₃, Lu₂O₃, Gd₂O₃, or a mixture thereof.

According to one embodiment, examples of oxide host material **71** include but are not limited to: silicon oxide, aluminium oxide, titanium oxide, copper oxide, iron oxide, silver oxide, lead oxide, calcium oxide, magnesium oxide, zinc oxide, tin oxide, beryllium oxide, zirconium oxide, niobium oxide, cerium oxide, iridium oxide, scandium oxide, nickel oxide, sodium oxide, barium oxide, potassium oxide, vanadium oxide, tellurium oxide, manganese oxide, boron oxide, phosphorus oxide, germanium oxide, osmium oxide, rhenium oxide, platinum oxide, arsenic oxide, tantalum oxide, lithium oxide, strontium oxide, yttrium oxide, hafnium oxide, tungsten oxide, molybdenum oxide, chromium oxide, technetium oxide, rhodium oxide, ruthenium oxide, cobalt oxide, palladium oxide, cadmium oxide, mercury oxide, thallium oxide, gallium oxide, indium oxide, bismuth oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, mixed oxides, mixed oxides thereof or a mixture thereof.

According to one embodiment, examples of nitride host material **71** include but are not limited to: TiN, Si₃N₄, MoN, VN, TaN, Zr₃N₄, HfN, FeN, NbN, GaN, CrN, AlN, InN, TiₓN_{y}, SiₓN_{y}, MoₓN_{y}, VₓN_{y}, TaₓN_{y}, ZrₓN_{y}, HfₓN_{y}, FeₓN_{y}, NbₓN_{y}, GaₓN_{y}, CrₓN_{y}, AlₓN_{y}, InₓN_{y}, or a mixture thereof; x and y are independently a decimal number from 0 to 5, at the condition that x and y are not simultaneously equal to 0, and x ≠ 0.

According to one embodiment, examples of sulfide host material **71** include but are not limited to: Si_{y}Sₓ, Al_{y}Sₓ, Ti_{y}Sₓ, Zr_{y}Sₓ, Zn_{y}Sₓ, Mg_{y}Sₓ, Sn_{y}Sₓ, Nb_{y}Sₓ, Ce_{y}Sₓ, Be_{y}Sₓ, Ir_{y}S_{X}, Ca_{y}Sₓ, Sc_{y}Sₓ, Ni_{y}Sₓ, Na_{y}Sₓ, Ba_{y}Sₓ, K_{y}Sₓ, Pb_{y}Sₓ, Ag_{y}Sₓ, V_{y}Sₓ, Te_{y}Sₓ, Mn_{y}Sₓ, B_{y}Sₓ, P_{y}Sₓ, Ge_{y}Sₓ, As_{y}Sₓ, Fe_{y}Sₓ, Ta_{y}Sₓ, Li_{y}Sₓ, Sr_{y}Sₓ, Y_{y}Sₓ, Hf_{y}Sₓ, W_{y}Sₓ, Mo_{y}Sₓ, Cr_{y}Sₓ, Tc_{y}Sₓ, Re_{y}Sₓ, Ru_{y}Sₓ, Co_{y}Sₓ, Os_{y}Sₓ, Rh_{y}Sₓ, Pt_{y}Sₓ, Pd_{y}Sₓ, Cu_{y}Sₓ, Au_{y}Sₓ, Cd_{y}Sₓ, Hg_{y}Sₓ, Tl_{y}Sₓ, Ga_{y}Sₓ, In_{y}Sₓ, Bi_{y}Sₓ, Sb_{y}Sₓ, Po_{y}Sₓ, Se_{y}Sₓ, Cs_{y}Sₓ, mixed sulfides, mixed sulfides thereof or a mixture thereof; x and y are independently a decimal number from 0 to 10, at the condition that x and y are not simultaneously equal to 0, and x ≠ 0.

According to one embodiment, examples of halide host material **71** include but are not limited to: BaF₂, LaF₃, CeF₃, YF₃, CaF₂, MgF₂, PrF₃, AgCl, MnCl₂, NiCl₂, Hg₂Cl₂, CaCl₂, CsPbCl₃, AgBr, PbBr₃, CsPbBr₃, AgI, CuI, PbI, HgI₂, BiI₃, CH₃NH₃PbI₃, CH₃NH₃PbCl₃, CH₃NH₃PbBr₃, CsPbI₃, FAPbBr₃ (with FA formamidinium), or a mixture thereof.

According to one embodiment, examples of chalcogenide host material **71** include but are not limited to: CdO, CdS, CdSe, CdTe, ZnO, ZnS, ZnSe, ZnTe, HgO, HgS, HgSe, HgTe, CuO, Cu₂O, CuS, Cu₂S, CuSe, CuTe, Ag₂O, Ag₂S, Ag₂Se, Ag₂Te, Au₂S, PdO, PdS, Pd₄S, PdSe, PdTe, PtO, PtS, PtS₂, PtSe, PtTe, RhO₂, Rh₂O₃, RhS2, Rh₂S₃, RhSe₂, Rh₂Se₃, RhTe₂, IrO₂, IrS₂, Ir₂S₃, IrSe₂, IrTe₂, RuO₂, RuS₂, OsO, OsS, OsSe, OsTe, MnO, MnS, MnSe, MnTe, ReO₂, ReS₂, Cr₂O₃, Cr₂S₃, MoO₂, MoS₂, MoSe₂, MoTe₂, WO₂, WS₂, WSe₂, V₂O₅, V₂S₃, Nb₂O₅, NbS₂, NbSe₂, HfO₂, HfS₂, TiO₂, ZrO₂, ZrS₂, ZrSe₂, ZrTe₂, Sc₂O₃, Y₂O₃, Y₂S₃, SiO₂, GeO₂, GeS, GeS₂, GeSe, GeSe₂, GeTe, SnO₂, SnS, SnS₂, SnSe, SnSe₂, SnTe, PbO, PbS, PbSe, PbTe, MgO, MgS, MgSe, MgTe, CaO, CaS, SrO, Al₂O₃, Ga₂O₃, Ga₂S₃, Ga₂Se₃, In₂O₃, In₂S₃, In₂Se₃, In₂Te₃, La₂O₃, La₂S₃, CeO₂, CeS₂, Pr₆O₁₁, Nd₂O₃, NdS₂, La₂O₃, Tl₂O, Sm₂O₃, SmS₂, Eu₂O₃, EuS₂, Bi₂O₃, Sb₂O₃, PoO₂, SeO₂, Cs₂O, Tb₄O₇, TbS₂, Dy₂O₃, Ho₂O₃, Er₂O₃, ErS₂, Tm₂O₃, Yb₂O₃, Lu₂O₃, CuInS₂, CuInSe₂, AgInS₂, AgInSe₂, Fe₂O₃, Fe₃O₄, FeS, FeS₂, Co₃S₄, CoSe, Co₃O₄, NiO, NiSe₂, NiSe, Ni₃Se₄, Gd₂O₃, BeO, TeO₂, Na₂O, BaO, K₂O, Ta₂O₅, Li₂O, TC₂O₇, As₂O₃, B₂O₃, P₂O₅, P₂O₃, P₄O₇, P₄O₈, P₄O₉, P₂O₆, PO, or a mixture thereof.

According to one embodiment, examples of phosphide host material **71** include but are not limited to: InP, Cd₃P₂, Zn₃P₂, AlP, GaP, TlP, or a mixture thereof.

According to one embodiment, examples of metalloid host material **71** include but are not limited to: Si, B, Ge, As, Sb, Te, or a mixture thereof.

According to one embodiment, examples of metallic alloy host material **71** include but are not limited to: Au-Pd, Au-Ag, Au-Cu, Pt-Pd, Pt-Ni, Cu-Ag, Cu-Sn, Ru-Pt, Rh-Pt, Cu-Pt, Ni-Au, Pt-Sn, Pd-V, Ir-Pt, Au-Pt, Pd-Ag, Cu-Zn, Cr-Ni, Fe-Co, Co-Ni, Fe-Ni or a mixture thereof.

According to one embodiment, the host material **71** comprises a polymeric host material as described hereabove, an inorganic host material as described hereabove, or a mixture thereof.

According to one embodiment, the light emitting material **7** comprises at least one host material **71.**

According to one embodiment, the light emitting material **7** comprises at least two host materials **71.** In this embodiment, the host materials can be identical or different from each other.

According to one embodiment, the light emitting material **7** comprises a plurality of host materials **71.** In this embodiment, the host materials can be identical or different from each other.

In one embodiment, the light emitting material **7** of the invention comprises at least one population of luminescent particles **1.** In one embodiment, a population of luminescent particles **1** is defined by the maximum emission wavelength.

In one embodiment, the light emitting material **7** comprises two populations of luminescent particles **1** emitting different colors or wavelengths.

In one embodiment, the concentration of the at least two populations of luminescent particles **1** comprised in the light emitting material **7** and emitting different colors or wavelengths, is controlled to predetermine the light intensity of each secondary light emitted by each of the least two populations of luminescent particles **1,** after excitation by an incident light.

In one embodiment, the light emitting material **7** comprises luminescent particles **1** which emit green light and red light upon downconversion of a blue light source. In this embodiment, the light emitting material **7** is configured to transmit a predetermined intensity of the blue light from the light source and to emit a predetermined intensity of secondary green and red lights, allowing to emit a resulting tri-chromatic white light.

According to one embodiment, the light emitting material **7** comprises at least one luminescent particle **1** comprising at least one nanoparticle **3** that emits green light upon downconversion of a blue light source.

According to one embodiment, the light emitting material **7** comprises at least one luminescent particle **1** comprising at least one nanoparticles **3** that emits orange light upon downconversion of a blue light source.

According to one embodiment, the light emitting material **7** comprises at least one luminescent particle **1** comprising at least one nanoparticles **3** that emits yellow light upon downconversion of a blue light source.

According to one embodiment, the light emitting material **7** comprises at least one luminescent particle **1** comprising at least one nanoparticles **3** that emits purple light upon downconversion of a blue light source.

In one embodiment, the light emitting material **7** comprises two populations of luminescent particles **1,** a first population with a maximum emission wavelength between 500 nm and 560 nm, more preferably between 515 nm and 545 nm and a second population with a maximum emission wavelength between 600 nm and 2500 nm, more preferably between 610 nm and 650 nm.

In one embodiment, the light emitting material **7** comprises three populations of luminescent particles **1,** a first population of luminescent particles **1** with a maximum emission wavelength between 440 and 499 nm, more preferably between 450 and 495 nm, a second population of luminescent particles **1** with a maximum emission wavelength between 500 nm and 560 nm, more preferably between 515 nm and 545 nm and a third population of luminescent particles **1** with a maximum emission wavelength between 600 nm and 2500 nm, more preferably between 610 nm and 650 nm.

In one embodiment, the light emitting material **7** is splitted in several areas, each of them comprises a different population of luminescent particles **1** emitting different colors or wavelengths.

In one embodiment, the light emitting material **7** has a shape of a film.

In one embodiment, the light emitting material **7** is a film.

In one embodiment, the light emitting material **7** is processed by extrusion.

In one embodiment, the light emitting material **7** is an optical pattern. In this embodiment, said pattern may be formed on a support as described herein.

In one embodiment, the support as described herein can be heated or cooled down by an external system.

In one embodiment, the light emitting material **7** is a light collection pattern. In this embodiment, said pattern may be formed on a support as described herein.

In one embodiment, the light emitting material **7** is a light diffusion pattern. In this embodiment, said pattern may be formed on a support as described herein.

In one embodiment, the light emitting material **7** is made of a stack of two films, each of them comprises a different population of luminescent particles **1** emitting different colors or wavelengths.

In one embodiment, the light emitting material **7** is made of a stack of a plurality of films, each of them comprises a different population of luminescent particles **1** emitting different colors or wavelengths.

According to one embodiment, the light emitting material **7** has a thickness between 30 nm and 10 cm, more preferably between 100 nm and 1 cm, even more preferably between 100 nm and 1 mm.

According to one embodiment, the light emitting material **7** has a thickness less than 200 µm. This embodiment is particularly advantageous as that the light conversion efficiency is greatly improved when the surface roughness value is approximately 10 nm. For example, in this embodiment, the light conversion efficiency can be 80% or more.

According to one embodiment, the light emitting material **7** has a thickness ranging from 30 µm to 120 µm. This embodiment is particularly advantageous the light conversion efficiency is improved when the surface roughness value is in a range from 10 nm to 300 nm. For example, in this embodiment, the light conversion efficiency can be 80% or more.

According to one embodiment, the light emitting material **7** absorbs at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the light emitting material **7** transmits at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the light emitting material **7** scatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the light emitting material **7** backscatters at least 5%, 10%, 15%, 20%, 25%, 30%, 35%, 40%, 45%, 50%, 55%, 60%, 65%, 70%, 75%, 80%, 85%, 90%, 95%, or 100% of the incident light.

According to one embodiment, the light emitting material **7** transmits a part of the incident light and emits at least one secondary light. In this embodiment, the resulting light is a combination of the remaining transmitted incident light.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm, 350 nm, 400 nm, 450 nm, 455 nm, 460 nm, 470 nm, 480 nm, 490 nm, 500 nm, 510 nm, 520 nm, 530 nm, 540 nm, 550 nm, 560 nm, 570 nm, 580 nm, 590 nm, or 600 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 300 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 350 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 400 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 450 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 455 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 460 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 470 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 480 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 490 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 500 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 510 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 520 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 530 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 540 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 550 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 560 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 570 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 580 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 590 nm.

According to one embodiment, the light emitting material **7** has an absorbance value of at least 0.1, 0.2, 0.3, 0.4, 0.5, 0.6, 0.7, 0.8, 0.9, 1.0, 1.2, 1.4, 1.6, 1.8, 2.0, 2.5, 3.0, 4.0, 5.0 at 600 nm.

According to one embodiment, the increase in absorption efficiency of incident light by the light emitting material **7** is at least of 1%, 2%, 3%, 4%, 5%, 6%, 7%, 8%, 9%, 10%, 20%, 30%, 40%, 50%, 55%, 60%, 65%, 70%, 75%, 80%, 85%, 90%, 95%, or 100% compared to bare nanoparticles **3.**

Bare nanoparticles **3** refers here to nanoparticles **3** that are not encapsulated in a second material **21.**

According to one embodiment, the increase in emission efficiency of secondary light by the light emitting material **7** is less than 1%, 2%, 3%, 4%, 5%, 6%, 7%, 8%, 9%, 10%, 20%, 30%, 40%, 50%, 55%, 60%, 65%, 70%, 75%, 80%, 85%, 90%, 95%, or 100% compared to bare nanoparticles **3.**

In another embodiment, the light emitting material **7** comprising at least one population of luminescent particles **1,** may further comprise at least one population of converters having phosphor properties. Examples of converter having phosphor properties include, but are not limited to: garnets (LuAG, GAL, YAG, GaYAG), silicates, oxynitrides/oxycarbidonitrides, nintrides/carbidonitrides, Mn⁴⁺ red phosphors (PFS/KFS), quantum dots.

According to one embodiment, luminescent particles **1** of the invention are incorporated in the host material **71** at a level ranging from 100 ppm to 500 000 ppm in weight.

According to one embodiment, luminescent particles **1** of the invention are incorporated in the host material **71** at a level of at least 100 ppm, 200 ppm, 300 ppm, 400 ppm, 500 ppm, 600 ppm, 700 ppm, 800 ppm, 900 ppm, 1000 ppm, 1100 ppm, 1200 ppm, 1300 ppm, 1400 ppm, 1500 ppm, 1600 ppm, 1700 ppm, 1800 ppm, 1900 ppm, 2000 ppm, 2100 ppm, 2200 ppm, 2300 ppm, 2400 ppm, 2500 ppm, 2600 ppm, 2700 ppm, 2800 ppm, 2900 ppm, 3000 ppm, 3100 ppm, 3200 ppm, 3300 ppm, 3400 ppm, 3500 ppm, 3600 ppm, 3700 ppm, 3800 ppm, 3900 ppm, 4000 ppm, 4100 ppm, 4200 ppm, 4300 ppm, 4400 ppm, 4500 ppm, 4600 ppm, 4700 ppm, 4800 ppm, 4900 ppm, 5000 ppm, 5100 ppm, 5200 ppm, 5300 ppm, 5400 ppm, 5500 ppm, 5600 ppm, 5700 ppm, 5800 ppm, 5900 ppm, 6000 ppm, 6100 ppm, 6200 ppm, 6300 ppm, 6400 ppm, 6500 ppm, 6600 ppm, 6700 ppm, 6800 ppm, 6900 ppm, 7000 ppm, 7100 ppm, 7200 ppm, 7300 ppm, 7400 ppm, 7500 ppm, 7600 ppm, 7700 ppm, 7800 ppm, 7900 ppm, 8000 ppm, 8100 ppm, 8200 ppm, 8300 ppm, 8400 ppm, 8500 ppm, 8600 ppm, 8700 ppm, 8800 ppm, 8900 ppm, 9000 ppm, 9100 ppm, 9200 ppm, 9300 ppm, 9400 ppm, 9500 ppm, 9600 ppm, 9700 ppm, 9800 ppm, 9900 ppm, 10000 ppm, 10500 ppm, 11000 ppm, 11500 ppm, 12000 ppm, 12500 ppm, 13000 ppm, 13500 ppm, 14000 ppm, 14500 ppm, 15000 ppm, 15500 ppm, 16000 ppm, 16500 ppm, 17000 ppm, 17500 ppm, 18000 ppm, 18500 ppm, 19000 ppm, 19500 ppm, 20000 ppm, 30000 ppm, 40000 ppm, 50000 ppm, 60000 ppm, 70000 ppm, 80000 ppm, 90000 ppm, 100000 ppm, 110000 ppm, 120000 ppm, 130000 ppm, 140000 ppm, 150000 ppm, 160000 ppm, 170000 ppm, 180000 ppm, 190000 ppm, 200000 ppm, 210000 ppm, 220000 ppm, 230000 ppm, 240000 ppm, 250000 ppm, 260000 ppm, 270000 ppm, 280000 ppm, 290000 ppm, 300000 ppm, 310000 ppm, 320000 ppm, 330000 ppm, 340000 ppm, 350000 ppm, 360000 ppm, 370000 ppm, 380000 ppm, 390000 ppm, 400000 ppm, 410000 ppm, 420000 ppm, 430000 ppm, 440000 ppm, 450000 ppm, 460000 ppm, 470000 ppm, 480000 ppm, 490000 ppm, or 500 000 ppm in weight.

According to one embodiment, the light emitting material **7** comprises less than 95%, 90%, 80%, 70%, 60%, 50%, 40%, 30%, 20%, preferably 10% in weight of luminescent particles **1** of the invention.

According to one embodiment, the loading charge of luminescent particles **1** in the light emitting material **7** is at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the loading charge of luminescent particles **1** in the light emitting material **7** is less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98%, or 99%.

According to one embodiment, the luminescent particles **1** dispersed in the light emitting material **7** have a packing fraction of at least 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the luminescent particles **1** dispersed in the light emitting material **7** have a packing fraction of less than 0.01%, 0.05%, 0.1%, 0.15%, 0.2%, 0.25%, 0.3%, 0.35%, 0.4%, 0.45%, 0.5%, 0.55%, 0.6%, 0.65%, 0.7%, 0.75%, 0.8%, 0.85%, 0.9%, 0.95%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, 50%, 51%, 52%, 53%, 54%, 55%, 56%, 57%, 58%, 59%, 60%, 61%, 62%, 63%, 64%, 65%, 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, or 95%.

According to one embodiment, the light emitting material **7** comprises at least 0.01 wt%, 0.02 wt%, 0.03 wt%, 0.04 wt%, 0.05 wt%, 0.06 wt%, 0.07 wt%, 0.08 wt%, 0.09 wt%, 0.1 wt%, 0.2 wt%, 0.3 wt%, 0.4 wt%, 0.5 wt%, 0.6 wt%, 0.7 wt%, 0.8 wt%, 0.9 wt%, 1 wt%, 2 wt%, 3 wt%, 4 wt%, 5 wt%, 6 wt%, 7 wt%, 8 wt%, 9 wt%, 10 wt%, 15 wt%, 20 wt%, 25 wt%, 30 wt%, 35 wt%, 40 wt%, 45 wt%, 50 wt%, 55 wt%, 60 wt%, 65 wt%, 70 wt%, 75 wt%, 80 wt%, 85 wt%, 90 wt%, 95 wt%, or 99 wt% of luminescent particle **1.**

According to one embodiment, in the light emitting material **7,** the weight ratio between the host material **71** and the luminescent particle **1** of the invention is at least 0.01%, 0.02%, 0.03%, 0.04%, 0.05%, 0.06%, 0.07%, 0.08%, 0.09%, 0.1%, 0.2%, 0.3%, 0.4%, 0.5%, 0.6%, 0.7%, 0.8%, 0.9%, 1%, 2%, 3%, 4%, 5%, 6%, 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, 31%, 32%, 33%, 34%, 35%, 36%, 37%, 38%, 39%, 40%, 41%, 42%, 43%, 44%, 45%, 46%, 47%, 48%, 49%, or 50%.

According to one embodiment, the light emitting material **7** comprises one or more materials useful in forming at least one of a hole transport layer, a hole injection layer, an electron transport layer, an electron injection layer, and an emissive layer, of a light-emitting device.

According to one embodiment, the light emitting material **7** comprises a material that is cured or otherwise processed to form a layer on a support.

According to one embodiment, the light emitting material **7** comprises a binder that is an organic material as described herein, an inorganic material as described herein, or a mixture thereof.

According to one embodiment, examples of binders include but are not limited to: a crosslinked body of an inorganic material as described herein such as, for example, a silicic acid such as sodium silicate, potassium silicate, or silicate soda.

According to one embodiment, the binder is a liquid in which Si0₂ (anhydrous silicate) and Na₂O (soda oxide) or K₂0 (potassium oxide) are mixed with a predetermined ratio. In this embodiment, the molecular formula is represented by Na₂O.nSi0₂.

According to one embodiment, the binder comprised in the light emitting material **7** has a difference of linear expansion coefficient with the support on which is deposited said light emitting material **7.** In this embodiment, the difference of linear expansion coefficient between the binder and the support is less than 8 ppm/K. This embodiment is particularly advantageous as it prevents peeling between the support and the light emitting material **7.** This is because that the stress inside the light emitting material **7,** accompanied by heat generation, is sufficiently eased even though the light emitting material **7** generates heat by irradiation with the excitation light.

According to a preferred embodiment, examples of light emitting material **7** include but are not limited to: luminescent particle **1** dispersed in sol gel materials, silicone, polymers such as for example PMMA, PS, or a mixture thereof.

According to one embodiment, the light emitting material **7** may be used as a light source.

According to one embodiment, the light emitting material **7** may be used in a light source.

According to one embodiment, the light emitting material **7** may be used as a color filter.

According to one embodiment, the light emitting material **7** may be used in a color filter.

According to one embodiment, the light emitting material **7** may be used in addition to a color filter.

Another object of the invention relates to a support supporting at least one luminescent particle **1** of the invention and/or at least one light emitting material **7** as described here above.

In one embodiment, the at least one luminescent particle **1** of the invention and/or at least one light emitting material **7** are deposited on the support by drop-casting, spin coating, dip coating, inkjet printing, lithography, spray, plating, electroplating, or any other means known by the person skilled in the art.

In one embodiment, the support supports at least one population of luminescent particles **1.** In one embodiment, the support supports at least one light emitting material **7** comprising at least one population of luminescent particles **1.** In the present application, a population of luminescent particles **1** is defined by the maximum emission wavelength.

In one embodiment, the support supports two populations of luminescent particles **1** emitting different colors or wavelengths. In one embodiment, the support supports at least one light emitting material **7** comprising two populations of luminescent particles **1** emitting different colors or wavelengths. In one embodiment, the support supports two light emitting materials **7** each comprising one population of luminescent particles **1,** the populations comprised in each light emitting material **7** emitting different colors or wavelengths.

In one embodiment, the support supports luminescent particles **1** which emit green light and red light upon downconversion of a blue light source. Thus, the blue light from the light source(s) pass through the luminescent particle **1,** where predetermined amounts of green and red light are mixed with the remaining blue light to create the tri-chromatic white light. In one embodiment, the support supports at least one light emitting material **7** comprising luminescent particles **1** which emit green light and red light upon downconversion of a blue light source. In this embodiment, the at least one light emitting material **7** is configured to transmit a predetermined intensity of the incident blue light and to emit a predetermined intensity of secondary green and red lights, allowing to emit a resulting tri-chromatic white light. In one embodiment, the support supports at least one light emitting material **7** comprising at least one luminescent particle **1** which emits green light, and at least one light emitting material **7** comprising at least one luminescent particle **1** which emits red light upon downconversion of a blue light source. In this embodiment, the at least one light emitting material **7** is configured to transmit a predetermined intensity of the incident blue light and to emit a predetermined intensity of secondary green and red lights, allowing to emit a resulting tri-chromatic white light.

In one embodiment, the support supports two populations of luminescent particles **1,** a first population with a maximum emission wavelength between 500 nm and 560 nm, more preferably between 515 nm and 545 nm and a second population with a maximum emission wavelength between 600 nm and 2500 nm, more preferably between 610 nm and 650 nm. In one embodiment, the support supports at least one light emitting material **7** comprising two populations of luminescent particles **1,** a first population with a maximum emission wavelength between 500 nm and 560 nm, more preferably between 515 nm and 545 nm and a second population with a maximum emission wavelength between 600 nm and 2500 nm, more preferably between 610 nm and 650 nm. In one embodiment, the support supports two light emitting material **7** each comprising at least one population of luminescent particles **1,** a first light emitting material **7** comprising a first population with a maximum emission wavelength between 500 nm and 560 nm, more preferably between 515 nm and 545 nm and a second light emitting material **7** comprising a second population with a maximum emission wavelength between 600 nm and 2500 nm, more preferably between 610 nm and 650 nm.

In one embodiment, the support supports two populations of luminescent particles **1,** a first population with at least one emission peak having a full width half maximum lower than 90 nm, 80 nm, 70 nm, 60 nm, 50 nm, 40 nm, 30 nm, 25 nm, 20 nm, 15 nm, or 10 nm and a second population with at least one emission peak having a full width half maximum lower than 90 nm, 80 nm, 70 nm, 60 nm, 50 nm, 40 nm, 30 nm, 25 nm, 20 nm, 15 nm, or 10 nm. In one embodiment, the support supports at least one light emitting material **7** comprising two populations of luminescent particles **1,** a first population with at least one emission peak having a full width half maximum lower than 90 nm, 80 nm, 70 nm, 60 nm, 50 nm, 40 nm, 30 nm, 25 nm, 20 nm, 15 nm, or 10 nm and a second population with at least one emission peak having a full width half maximum lower than 90 nm, 80 nm, 70 nm, 60 nm, 50 nm, 40 nm, 30 nm, 25 nm, 20 nm, 15 nm, or 10 nm. In one embodiment, the support supports two light emitting material **7** each comprising at least one population of luminescent particles **1,** a first light emitting material **7** comprising a first population with at least one emission peak having a full width half maximum lower than 90 nm, 80 nm, 70 nm, 60 nm, 50 nm, 40 nm, 30 nm, 25 nm, 20 nm, 15 nm, or 10 nm and a second light emitting material **7** comprising a second population with at least one emission peak having a full width half maximum lower than 90 nm, 80 nm, 70 nm, 60 nm, 50 nm, 40 nm, 30 nm, 25 nm, 20 nm, 15 nm, or 10 nm.

In one embodiment, the support supports two populations of luminescent particles **1,** a first population with at least one emission peak having a full width at quarter maximum lower than 90 nm, 80 nm, 70 nm, 60 nm, 50 nm, 40 nm, 30 nm, 25 nm, 20 nm, 15 nm, or 10 nm and a second population with at least one emission peak having a full width at quarter maximum lower than 90 nm, 80 nm, 70 nm, 60 nm, 50 nm, 40 nm, 30 nm, 25 nm, 20 nm, 15 nm, or 10 nm. In one embodiment, the support supports at least one light emitting material **7** comprising two populations of luminescent particles **1,** a first population with at least one emission peak having a full width at quarter maximum lower than 90 nm, 80 nm, 70 nm, 60 nm, 50 nm, 40 nm, 30 nm, 25 nm, 20 nm, 15 nm, or 10 nm and a second population with at least one emission peak having a full width at quarter maximum lower than 90 nm, 80 nm, 70 nm, 60 nm, 50 nm, 40 nm, 30 nm, 25 nm, 20 nm, 15 nm, or 10 nm. In one embodiment, the support supports two light emitting material 7 each comprising at least one population of luminescent particles **1,** a first light emitting material **7** comprising a first population with at least one emission peak having a full width at quarter maximum lower than 90 nm, 80 nm, 70 nm, 60 nm, 50 nm, 40 nm, 30 nm, 25 nm, 20 nm, 15 nm, or 10 nm and a second light emitting material **7** comprising a second population with at least one emission peak having a full width at quarter maximum lower than 90 nm, 80 nm, 70 nm, 60 nm, 50 nm, 40 nm, 30 nm, 25 nm, 20 nm, 15 nm, or 10 nm.

In one embodiment, the at least one luminescent particle **1** and/or the at least one light emitting material **7** on a support is encapsulated into a multilayered system. In one embodiment, the multilayer system comprises at least two, at least three layers.

In one embodiment, the multilayered system may further comprise at least one auxiliary layer.

According to one embodiment, the auxiliary layer is a polymeric auxiliary layer.

According to one embodiment, the one or more components of the auxiliary layer can include a polymerizable component, a crosslinking agent, a scattering agent, a rheology modifier, a filler, a photoinitiator, or a thermal initiator as described here after or above.

According to one embodiment, the auxiliary layer comprises a polymeric host material **71** as described here above.

According to one embodiment, the auxiliary layer comprises an inorganic host material **71** as described here above.

In one embodiment, the auxiliary layer has a thickness between 30 nm and 1 cm, between 100 nm and 1 mm, preferably between 100 nm and 500 µm.

According to one embodiment, the at least one luminescent particle **1** or the multilayered system comprising at least one luminescent particle **1** is covered by at least one protective layer. According to one embodiment, the at least one light emitting material **7** or the multilayered system comprising at least one light emitting material **7** is covered by at least one protective layer.

In one embodiment, the at least one luminescent particle **1** or the multilayered system comprising at least one luminescent particle **1** is surrounded by at least one protective layer. In one embodiment, the at least one light emitting material **7** or the multilayered system comprising at least one light emitting material **7** is surrounded by at least one protective layer.

In one embodiment, the at least one luminescent particle **1** or the multilayered system comprising at least one luminescent particle **1** is covered by at least one auxiliary layer, both being then surrounded by at least one protective layer. In one embodiment, the at least one light emitting material **7** or the multilayered system comprising at least one light emitting material **7** is covered by at least one auxiliary layer, both being then surrounded by at least one protective layer.

In one embodiment, the at least one luminescent particle **1** or the multilayered system comprising at least one luminescent particle **1** is covered at least one auxiliary layer and/or at least one protective layer. In one embodiment, the at least one light emitting material **7** or the multilayered system comprising at least one light emitting material **7** is covered at least one auxiliary layer and/or at least one protective layer.

In one embodiment, the protective layer is a planarization layer.

In one embodiment, the protective layer is an oxygen, ozone and/or water impermeable layer. In this embodiment, the protective layer is a barrier against oxidation, and limits or prevents the degradation of the chemical and physical properties of the at least one luminescent particles **1** and/or the at least one emitting material from molecular oxygen, ozone and/or water.

In one embodiment, the protective layer is an oxygen, ozone and/or water non-permeable layer. In this embodiment, the protective layer is a barrier against oxidation, and limits or prevents the degradation of the chemical and physical properties of the at least one luminescent particles **1** and/or the at least one emitting material from molecular oxygen, ozone and/or water.

In one embodiment, the protective layer can be made of glass, PET (Polyethylene terephthalate), PDMS (Polydimethylsiloxane), PES (Polyethersulfone), PEN (Polyethylene naphthalate), PC (Polycarbonate), PI (Polyimide), PNB (Polynorbornene), PAR (Polyarylate), PEEK (Polyetheretherketone), PCO (Polycyclic olefins), PVDC (Polyvinylidene chloride), Nylon, ITO (Indium tin oxide), FTO (Fluorine doped tin oxide), cellulose, Al₂O₃, AlOₓN_{y}, SiOₓC_{y}, SiO₂, SiOₓ, SiNₓ, SiCₓ, ZrO₂, TiO₂, MgO, ZnO, SnO₂, ceramic, organic modified ceramic, or mixture thereof.

In one embodiment, the protective layer can be deposited by PECVD (Plasma Enhanced Chemical Vapor Deposition), ALD (Atomic Layer Deposition), CVD (Chemical Vapor Deposition), iCVD (Initiator Chemical Vapor Deposition), Cat-CVD (Catalytic Chemical Vapor Deposition).

In one embodiment, the support can be a LED. Preferably the support is optically transparent at wavelengths between 200 nm and 50 µm, between 200 nm and 10 µm, between 200 nm and 2500 nm, between 200 nm and 2000 nm, between 200 nm and 1500 nm, between 200 nm and 1000 nm, between 200 nm and 800 nm, between 400 nm and 700 nm, between 400 nm and 600 nm, or between 400 nm and 470 nm.

LED used herein includes LED, LED chip **5** and micro sized LED **6.**

According to one embodiment, the substrate comprises GaN, GaSb, GaAs, GaAsP, GaP, InP, SiGe, InGaN, GaAlN, GaAlPN, AlN, AlGaAs, AlGaP, AlGaInP, AlGaN, AlGaInN, ZnSe, Si, SiC, diamond, boron nitride.

Another object of the invention relates to an optoelectronic device comprising at least one luminescent particle **1** and/or at least one light emitting material **7** as described here above.

According to one embodiment, the optoelectronic device is a display device, a diode, a light emitting diode (LED), a laser, a photodetector, a transistor, a supercapacitor, a barcode, a LED, a microLED, an array of LED, an array of microLED, or an IR camera.

LED used herein includes LED, LED chip **5** and micro sized LED **6.**

According to one embodiment, the optoelectronic device comprises at least one LED and at least one luminescent particle **1** and/or at least one light emitting material **7** as described here above.

According to one embodiment, a pixel comprises at least one LED.

According to one embodiment, a pixel comprises at least 1, 2, 3, 4, 5, 10, 20, 30, 40, 50, 60, 70, 80, 90, 100, 500, 1000, 5000, 10000, 50000, 100000, 150000, 200000, 250000, 300000, 350000, 400000, 450000, 500000, 550000, 600000, 650000, 750000, 800000, 850000, 900000, 950000, 10⁶, 10⁷, 10⁸, 10⁹, 10¹⁰, 10¹¹, or 10¹² LEDs.

According to one embodiment, the at least one luminescent particle **1** or the at least one light emitting material **7** is on top of a LED chip **5** or a microsized LED **6.**

According to one embodiment, the at least one luminescent particle **1** or the at least one light emitting material **7** is on top of at least one LED of a LED array or a microsized LED **6** array.

According to one embodiment, the at least one luminescent particle **1** or the at least one light emitting material **7** is deposited and patterned on top of at least one LED of a LED array or a micro sized LED **6** array.

According to one embodiment, the at least one luminescent particle **1** or the at least one light emitting material **7** is deposited and patterned on top of a LED, at least one LED of a LED array, a microsized LED **6** or at least one LED of a microsized LED **6** array using a lift-off technique, lithography, or a direct etching of the at least one luminescent particle **1** or the at least one light emitting material **7.**

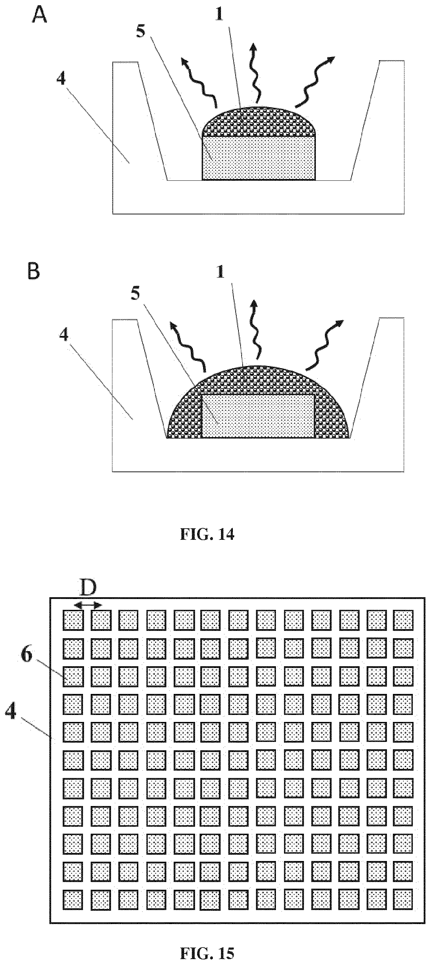

In one embodiment, as illustrated in Fig. 14A, the at least one luminescent particle **1** covers the LED chip **5.**

In one embodiment, as illustrated in Fig. 14B, the at least one luminescent particle **1** covers and surrounds partially or totally the LED chip **5.**

In one embodiment, the at least one light emitting material **7** as described above covers the LED chip **5.**

In one embodiment, the at least one light emitting material **7** as described above covers and surrounds partially or totally the LED chip **5.**

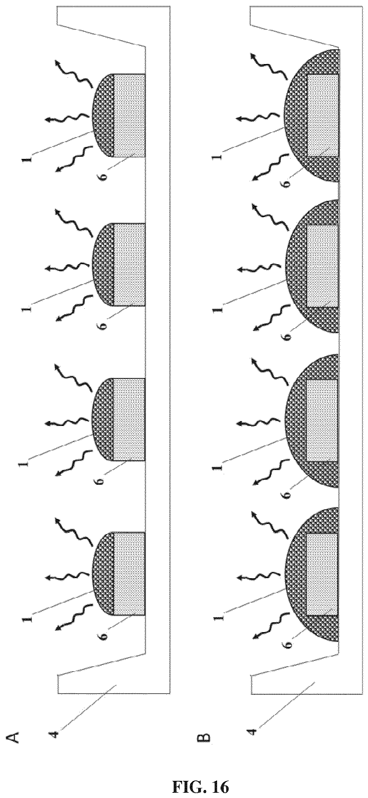

In one embodiment, as illustrated in Fig. 16A, the at least one luminescent particle **1** or the at least one light emitting material **7** covers a pixel of a micro sized LED **6** array without overlapping between the pixels of said microsized LED **6** array.

In one embodiment, the at least one luminescent particle **1** or the at least one light emitting material **7** covers partially a pixel of a microsized LED **6** array without overlapping between the pixels of said microsized LED 6 array.

In one embodiment, as illustrated in Fig. 16B, the at least one luminescent particle **1** or the at least one light emitting material **7** covers and surrounds partially or totally a pixel of a microsized LED **6** array without overlapping between the pixels of said microsized LED **6** array.

In one embodiment, the at least one luminescent particle **1** or the at least one light emitting material **7** covers a microsized LED **6** array without overlapping between the pixels of said microsized LED **6** array.

In one embodiment, the at least one luminescent particle **1** or the at least one light emitting material **7** covers partially a microsized LED **6** array without overlapping between the pixels of said micro sized LED **6** array.

In one embodiment, the at least one luminescent particle **1** or the at least one light emitting material **7** covers and surrounds partially or totally a microsized LED **6** array without overlapping between the pixels of said microsized LED **6** array.

In one embodiment, one population of luminescent particles **1** is deposited on a microsized LED **6** array. In one embodiment, a population of luminescent particles **1** is defined by the maximum emission wavelength.

In one embodiment, at least one population of luminescent particles **1** is deposited on a pixel of a micro sized LED **6** array.

In one embodiment, two populations of luminescent particles **1** emitting different colors or wavelengths are deposited on a microsized LED **6** array.

In one embodiment, two populations of luminescent particles **1** which emit green light and red light upon downconversion of a blue light source are deposited on a microsized LED **6** array.

In one embodiment, the two populations of luminescent particles **1** comprise a first population with a maximum emission wavelength between 500 nm and 560 nm, more preferably between 515 nm and 545 nm and a second population with a maximum emission wavelength between 600 nm and 2500 nm, more preferably between 610 nm and 650 nm.

In one embodiment, a light emitting material **7** as described here above comprising one population of luminescent particles **1** is deposited on a microsized LED **6** array.

In one embodiment, a light emitting material **7** as described here above comprising at least one population of luminescent particles **1** is deposited a microsized LED **6** array.

In one embodiment, a light emitting material **7** as described here above comprising two populations of luminescent particles **1** emitting different colors or wavelengths is deposited on a micro sized LED **6** array.

In one embodiment, the light emitting material **7** comprises two populations of luminescent particles **1,** a first population with a maximum emission wavelength between 500 nm and 560 nm, more preferably between 515 nm and 545 nm and a second population with a maximum emission wavelength between 600 nm and 2500 nm, more preferably between 610 nm and 650 nm.

In one embodiment, two light emitting materials **7** as described here above each comprising one population of luminescent particles **1** emitting different colors or wavelengths are deposited on a micro sized LED **6** array.

In one embodiment, the two light emitting materials **7** each comprise one population of luminescent particles **1,** a first population with a maximum emission wavelength between 500 nm and 560 nm, more preferably between 515 nm and 545 nm and a second population with a maximum emission wavelength between 600 nm and 2500 nm, more preferably between 610 nm and 650 nm.

According to one embodiment, the primary light is a blue light with an emission wavelength ranging from 400 nm to 470 nm, preferably at about 450 nm.

According to one embodiment, the primary light is a UV light with an emission wavelength ranging from 200 nm to 400 nm, preferably at about 390 nm.

In one embodiment, the LED chip **5** or the micro sized LED **6** is a blue LED with a wavelength ranging from 400 nm to 470 nm such as for instance a gallium nitride based diode.

In one embodiment, the LED chip **5** or the micro sized LED **6** is a blue LED with a wavelength ranging from 400 nm to 470 nm. In one embodiment, the LED chip **5** or the microsized LED **6** has an emission peak at about 405 nm. In one embodiment, the LED chip **5** or the microsized LED **6** has an emission peak at about 447 nm. In one embodiment, the LED chip **5** or the microsized LED **6** has an emission peak at about 455 nm.

In one embodiment, the LED chip **5** or the micro sized LED **6** is a UV LED with a wavelength ranging from 200 nm to 400 nm. In one embodiment, the LED chip **5** or the microsized LED **6** has an emission peak at about 253 nm. In one embodiment, the LED chip **5** or the microsized LED **6** has an emission peak at about 365 nm. In one embodiment, the LED chip **5** or the microsized LED **6** has an emission peak at about 395 nm.

In one embodiment, the LED chip **5** or the micro sized LED **6** is a green LED with a wavelength ranging from 500 nm to 560 nm. In one embodiment, the LED chip **5** or the microsized LED **6** has an emission peak at about 515 nm. In one embodiment, the LED chip **5** or the microsized LED **6** has an emission peak at about 525 nm. In one embodiment, the LED chip **5** or the microsized LED **6** has an emission peak at about 540 nm.

In one embodiment, the LED chip **5** or the microsized LED **6** is a red LED with a wavelength ranging from 750 to 850 nm. In one embodiment, the LED chip **5** or the microsized LED **6** has an emission peak at about 755 nm. In one embodiment, the LED chip **5** or the microsized LED **6** has an emission peak at about 800 nm. In one embodiment, the LED chip **5** or the microsized LED **6** has an emission peak at about 850 nm.

In one embodiment, the LED chip **5** or the microsized LED **6** has a photon flux or average peak pulse power between 1 µW.cm⁻² and 1 kW.cm⁻² and more preferably between 1 mW.cm⁻² and 100 W.cm⁻², and even more preferably between 1 mW.cm⁻² and 30 W.cm⁻².

In one embodiment, the LED chip **5** or the microsized LED **6** has a photon flux or average peak pulse power of at least 1 µW.cm⁻², 10 µW.cm⁻², 100 µW.cm⁻², 500 µW.cm⁻², 1 mW.cm⁻², 10 mw.cm⁻², 100 mW.cm⁻², 500 mW.cm⁻², 1 W.cm⁻², 10 W.cm⁻², 100 W.cm⁻², 500 W.cm⁻², or 1 kW.cm⁻².

In one embodiment, the LED chip **5** is a GaN, GaSb, GaAs, GaAsP, GaP, InP, SiGe, InGaN, GaAlN, GaAlPN, AlN, AlGaAs, AlGaP, AlGaInP, AlGaN, AlGaInN, ZnSe, Si, SiC, diamond, boron nitride diode.

In one embodiment, the microsized LED **6** is a GaN, GaSb, GaAs, GaAsP, GaP, InP, SiGe, InGaN, GaAlN, GaAlPN, AlN, AlGaAs, AlGaP, AlGaInP, AlGaN, AlGaInN, ZnSe, Si, SiC, diamond, boron nitride diode.

In one embodiment, a LED array comprises an array of GaN diodes, GaSb diodes, GaAs diodes, GaAsP diodes, GaP diodes, InP diodes, SiGe diodes, InGaN diodes, GaAlN diodes, GaAlPN diodes, AlN diodes, AlGaAs diodes, AlGaP diodes, AlGaInP diodes, AlGaN diodes, AlGaInN diodes, ZnSe diodes, Si diodes, SiC diodes, diamond diodes, boron nitride diodes or a mixture thereof.

According to one embodiment, a pixel comprises at least one microsized LED **6.**

According to one embodiment, at least one pixel comprises a unique microsized LED **6.**

According to one embodiment, at least one pixel comprises one microsized LED **6.** In this embodiment, the microsized LED **6** and the one pixel are combined.

According to one embodiment, as illustrated in Fig. 15, the pixel pitch **D** is at least 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 48 µm, 49 µm, 50 µm, 51 µm, 52 µm, 53 µm, 54 µm, 55 µm, 56 µm, 57 µm, 58 µm, 59 µm, 60 µm, 61 µm, 62 µm, 63 µm, 64 µm, 65 µm, 66 µm, 67 µm, 68 µm, 69 µm, 70 µm, 71 µm, 72 µm, 73 µm, 74 µm, 75 µm, 76 µm, 77 µm, 78 µm, 79 µm, 80 µm, 81 µm, 82 µm, 83 µm, 84 µm, 85 µm, 86 µm, 87 µm, 88 µm, 89 µm, 90 µm, 91 µm, 92 µm, 93 µm, 94 µm, 95 µm, 96 µm, 97 µm, 98 µm, 99 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the pixel pitch **D** is smaller than 10 µm.

According to one embodiment, the pixel size is at least 1 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 48 µm, 49 µm, 50 µm, 51 µm, 52 µm, 53 µm, 54 µm, 55 µm, 56 µm, 57 µm, 58 µm, 59 µm, 60 µm, 61 µm, 62 µm, 63 µm, 64 µm, 65 µm, 66 µm, 67 µm, 68 µm, 69 µm, 70 µm, 71 µm, 72 µm, 73 µm, 74 µm, 75 µm, 76 µm, 77 µm, 78 µm, 79 µm, 80 µm, 81 µm, 82 µm, 83 µm, 84 µm, 85 µm, 86 µm, 87 µm, 88 µm, 89 µm, 90 µm, 91 µm, 92 µm, 93 µm, 94 µm, 95 µm, 96 µm, 97 µm, 98 µm, 99 µm, 100 µm, 200 µm, 250 µm, 300 µm, 350 µm, 400 µm, 450 µm, 500 µm, 550 µm, 600 µm, 650 µm, 700 µm, 750 µm, 800 µm, 850 µm, 900 µm, 950 µm, 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, 3 mm, 3.1 mm, 3.2 mm, 3.3 mm, 3.4 mm, 3.5 mm, 3.6 mm, 3.7 mm, 3.8 mm, 3.9 mm, 4 mm, 4.1 mm, 4.2 mm, 4.3 mm, 4.4 mm, 4.5 mm, 4.6 mm, 4.7 mm, 4.8 mm, 4.9 mm, 5 mm, 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 1 cm, 1.1 cm, 1.2 cm, 1.3 cm, 1.4 cm, 1.5 cm, 1.6 cm, 1.7 cm, 1.8 cm, 1.9 cm, 2 cm, 2.1 cm, 2.2 cm, 2.3 cm, 2.4 cm, 2.5 cm, 2.6 cm, 2.7 cm, 2.8 cm, 2.9 cm, 3 cm, 3.1 cm, 3.2 cm, 3.3 cm, 3.4 cm, 3.5 cm, 3.6 cm, 3.7 cm, 3.8 cm, 3.9 cm, 4 cm, 4.1 cm, 4.2 cm, 4.3 cm, 4.4 cm, 4.5 cm, 4.6 cm, 4.7 cm, 4.8 cm, 4.9 cm, 5 cm, 5.1 cm, 5.2 cm, 5.3 cm, 5.4 cm, 5.5 cm, 5.6 cm, 5.7 cm, 5.8 cm, 5.9 cm, 6 cm, 6.1 cm, 6.2 cm, 6.3 cm, 6.4 cm, 6.5 cm, 6.6 cm, 6.7 cm, 6.8 cm, 6.9 cm, 7 cm, 7.1 cm, 7.2 cm, 7.3 cm, 7.4 cm, 7.5 cm, 7.6 cm, 7.7 cm, 7.8 cm, 7.9 cm, 8 cm, 8.1 cm, 8.2 cm, 8.3 cm, 8.4 cm, 8.5 cm, 8.6 cm, 8.7 cm, 8.8 cm, 8.9 cm, 9 cm, 9.1 cm, 9.2 cm, 9.3 cm, 9.4 cm, 9.5 cm, 9.6 cm, 9.7 cm, 9.8 cm, 9.9 cm, or 10 cm.

According to one embodiment, the optoelectronic device comprises LEDs, microLEDs, at least one array of LED or at least one array of microLED, on which at least one luminescent particle 1 and/or at least one light emitting material 7 is deposited. According to one embodiment, red emitting luminescent particle 1 and/or light emitting material 7, and green emitting luminescent particle 1 and/or light emitting material 7 are deposited alternatively on LEDs, microLEDs, at least one array of LED or at least one array of microLED, preferably blue LEDs, microLEDs, at least one array of LED or at least one array of microLED thus creating an alternance of red-green emitting pixels. According to one embodiment, red emitting luminescent particle **1** and/or light emitting material **7,** green emitting luminescent particle **1** and/or light emitting material **7,** no luminescent particle **1** and/or light emitting material **7** are deposited alternatively on LEDs, microLEDs, at least one array of LED or at least one array of microLED, preferably blue LEDs, microLEDs, at least one array of LED or at least one array of microLED, thus creating an alternance of blue-red-green emitting pixels.

According to one embodiment, the luminescent particle **1** and/or light emitting material **7** deposited on LEDs, microLEDs, at least one array of LED or at least one array of microLED is covered with an auxiliary layer as described herein, preferably a blue absorbing resin so that only red and green secondary light can be emitted.

According to one embodiment, the optoelectronic device comprises at least one film of luminescent particle **1** and/or at least one light emitting material **7** deposited on at least one array of LED, at least one array of microLED, or a pixel.

According to one embodiment, after deposition, the at least one luminescent particle **1** or the at least one light emitting material **7** is coated with an auxiliary layer as described here above. In this embodiment, the auxiliary layer limits or prevents the degradation of the chemical and physical properties of the at least one luminescent particle **1** or the at least one light emitting material **7** from molecular oxygen, ozone, water and/or high temperature.

According to one embodiment, after deposition, the at least one luminescent particle **1** or the at least one light emitting material **7** is coated with a protective layer as described here above. In this embodiment, the protective layer limits or prevents the degradation of the chemical and physical properties of the at least one luminescent particle **1** or the at least one light emitting material **7** from molecular oxygen, ozone, water and/or high temperature.

In one embodiment, the at least one luminescent particle **1** or the at least one light emitting material **7** exhibits photoluminescence quantum yield (PLQY) decrease of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

According to one embodiment, the light illumination and the photon flux or average peak pulse power of the illumination are as described hereabove.

In one embodiment, the at least one luminescent particle **1** or the at least one light emitting material **7** exhibits photoluminescence quantum yield (PQLY) decrease of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cW⁻², 60 W.cm⁻², 70 W.cW⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cW⁻², 300 W.cm⁻², 400 W.cm⁻², 500 W.cm⁻², 600 W.cm⁻², 700 W.cW⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cW⁻², 20 W.cW⁻², 30 W.cm⁻², 40 W.cm⁻², 50 W.cm⁻², 60 W.cW⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm^{-2,} 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000,48000,49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cW⁻², 20 W.cW⁻², 30 W.cW⁻², 40 W.cW⁻², 50 W.cW⁻², 60 W.cW⁻², 70 W.cW⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cW⁻², 200 W.cm⁻², 300 W.cm⁻², 400 W.cW⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cW⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a decrease of the intensity of at least one emission peak of less than 90%, 80%, 70%, 60%, 50%, 40%, 30%, 25%, 20%, 15%, 10%, 5%, or 0% after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits a shift of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 60 nm, 55 nm, 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under a humidity of at least 0%, 10%, 20%, 30%, 40%, 50%, 55%, 60%, 65%, 70%, 75%, 80%, 85%, 90%, 95%, or 100%, under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻².

In one embodiment, the optoelectronic device exhibits an increase of the full width half maximum of at least one emission peak of less than 90%, 80%, 70%, 60%, 50%, 40%, 30%, 25%, 20%, 15%, 10%, 5%, or 0% under a humidity of at least 0%, 10%, 20%, 30%, 40%, 50%, 55%, 60%, 65%, 70%, 75%, 80%, 85%, 90%, 95%, or 100%, under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻², under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C, and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under a temperature of at least 0°C, 10°C, 20°C, 30°C, 40°C, 50°C, 60°C, 70°C, 80°C, 90°C, 100°C, 125°C, 150°C, 175°C, 200°C, 225°C, 250°C, 275°C, or 300°C and under a humidity of at least 0%, 10%, 20%, 30%, 40%, 50%, 55%, 60%, 65%, 70%, 75%, 80%, 85%, 90%, 95%, or 100%.

In one embodiment, the optoelectronic device exhibits an increase of the full width half maximum of at least one emission peak of less than 50 nm, 45 nm, 40 nm, 35 nm, 30 nm, 25 nm, 20 nm, 15 nm, 10 nm, 5 nm, 4 nm, 3 nm, 2 nm, or 1 nm after at least 300, 400, 500, 600, 700, 800, 900, 1000, 2000, 3000, 4000, 5000, 6000, 7000, 8000, 9000, 10000, 11000, 12000, 13000, 14000, 15000, 16000, 17000, 18000, 19000, 20000, 21000, 22000, 23000, 24000, 25000, 26000, 27000, 28000, 29000, 30000, 31000, 32000, 33000, 34000, 35000, 36000, 37000, 38000, 39000, 40000, 41000, 42000, 43000, 44000, 45000, 46000, 47000, 48000, 49000, or 50000 hours under light illumination with a photon flux or average peak pulse power of at least 1 mW.cm⁻², 50 mW.cm⁻², 100 mW.cm⁻², 500 mW.cm⁻², 1 W.cm⁻², 5 W.cm⁻², 10 W.cm⁻², 20 W.cm⁻², 30 W.cm⁻², 40 W.cm⁻², 50 W.cm⁻², 60 W.cm⁻², 70 W.cm⁻², 80 W.cm⁻², 90 W.cm⁻², 100 W.cm⁻², 110 W.cm⁻², 120 W.cm⁻², 130 W.cm⁻², 140 W.cm⁻², 150 W.cm⁻², 160 W.cm⁻², 170 W.cm⁻², 180 W.cm⁻², 190 W.cm⁻², 200 W.cm⁻², 300 W.cm⁻², 400 W.cm⁻², 500 W.cm⁻², 600 W.cm⁻², 700 W.cm⁻², 800 W.cm⁻², 900 W.cm⁻², 1 kW.cm⁻², 50 kW.cm⁻², or 100 kW.cm⁻² and under a humidity of at least 0%, 10%, 20%, 30%, 40%, 50%, 55%, 60%, 65%, 70%, 75%, 80%, 85%, 90%, 95%, or 100%.

While various embodiments have been described and illustrated, the detailed description is not to be construed as being limited hereto. Various modifications can be made to the embodiments by those skilled in the art without departing from the scope of the disclosure as defined by the claims.

### BRIEF DESCRIPTION OF THE DRAWINGS

**Figure 1** illustrates a luminescent particle **1** comprising a first material **11** and particles **2;** wherein each particle **2** comprises a second material **21** and at least one nanoparticle **3** dispersed in said second material **21.**
**Figure 2** illustrates a luminescent particle **1** comprising a first material **11** and particles **2;** wherein each particle **2** comprises a second material **21** and at least one spherical nanoparticle **31** dispersed in said second material **21.**
**Figure 3** illustrates a luminescent particle **1** comprising a first material **11** and particles **2;** wherein each particle **2** comprises a second material **21** and at least one 2D nanoparticle **32** dispersed in said second material **21.**
**Figure 4** illustrates a luminescent particle **1** comprising a first material **11** and particles **2;** wherein each particle **2** comprises a second material **21,** at least one spherical nanoparticle **31** and at least one 2D nanoparticle **32** dispersed in said second material **21.**
**Figure 5** illustrates a luminescent particle **1** comprising different particles **2.**
**Figure 6** illustrates a heterostructured luminescent particle **1.**
**Figure 6A** illustrates a hetero structured luminescent particle **1,** wherein the core **12** of the luminescent particle **1** comprises at least one particle **2** and the shell **13** of the luminescent particle **1** does not comprise particles **2.**
**Figure 6B** illustrates a heterostructured luminescent particle **1,** wherein the at least one particle **2** is a heterostructure.
**Figure 6C** illustrates a hetero structured luminescent particle **1,** wherein the core **12** of the luminescent particle **1** comprises at least one particle **2** and the shell **13** of the luminescent particle **1** comprises at least one particle **2.**
**Figure 6D** illustrates a hetero structured luminescent particle **1,** wherein the core **12** of the luminescent particle **1** comprises at least one particle **2** and the shell **13** of the luminescent particle **1** comprises at least one nanoparticle **3.**

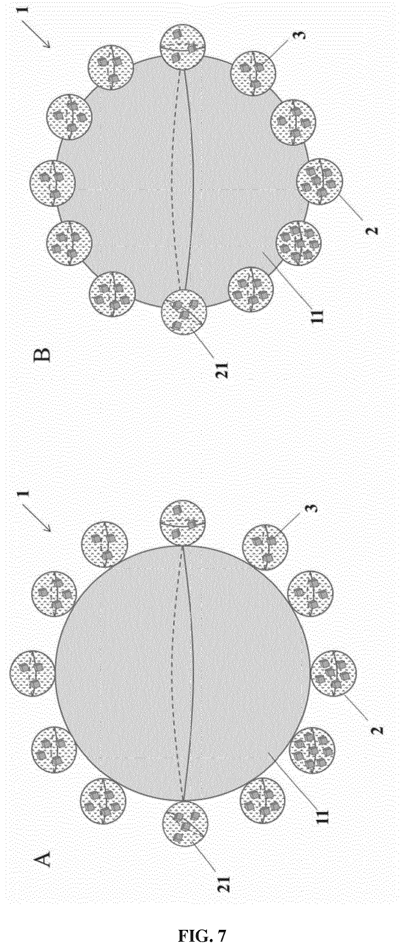

**Figure 7****,** not being part of the invention, for illustration purposes only, illustrates a luminescent particle **1** with at least one particle **2** located on its surface.
**Figure 7A** illustrates a luminescent particle **1** with at least one particle **2** adsorbed with a cement on its surface.
**Figure 7B** illustrates a luminescent particle **1** with at least one particle **2** located on its surface, wherein the at least one particle **2** has some of its volume trapped in the first material **11.**

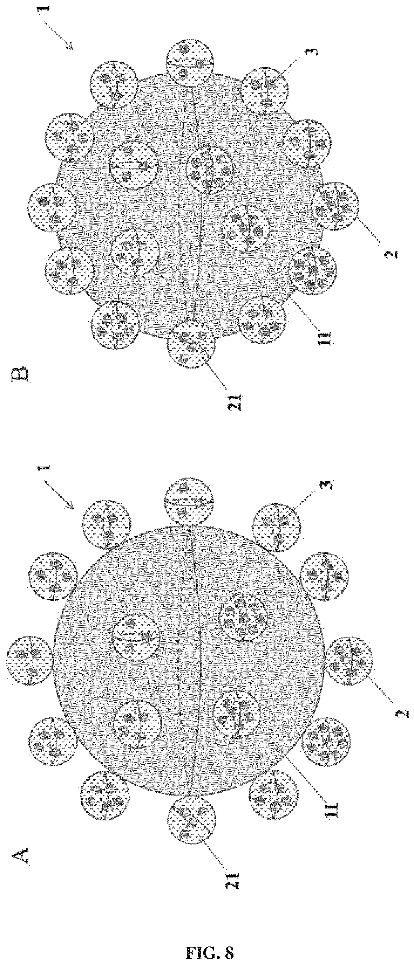

**Figure 8** illustrates a luminescent particle **1** comprising at least one particle **2** dispersed in the first material **11;** and at least one particle **2** located on the surface of said luminescent particle **1.**
**Figure 8A** illustrates a luminescent particle **1** comprising at least one particle **2** dispersed in the first material **11;** and at least one particle **2** adsorbed with a cement on the surface of said luminescent particle **1.**
**Figure 8B** illustrates a luminescent particle **1** comprising at least one particle **2** dispersed in the first material **11;** and at least one particle **2** located on the surface with some of its volume trapped in the first material **11.**

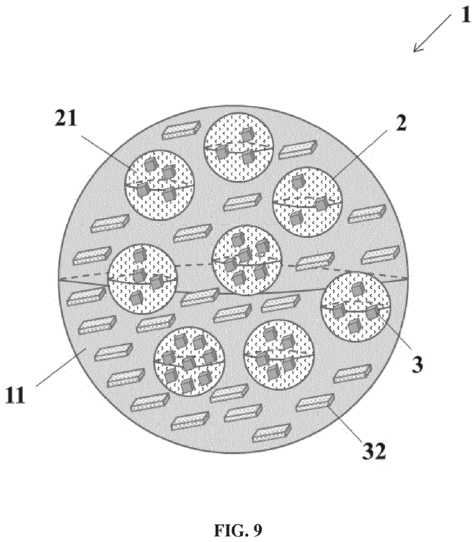

**Figure 9** illustrates a luminescent particle **1** further comprising at least one nanoparticle **3** dispersed in the first material **11.**

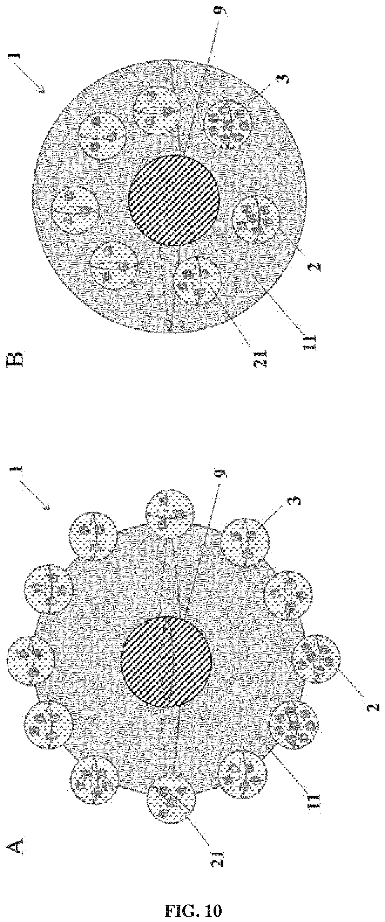

**Figure 10****,** not being part of the invention, for illustration purposes only, illustrates a luminescent particle **1** further comprising a dense particle **9** dispersed in the first material **11.**
**Figure 10A****,** not being part of the invention, for illustration purposes only, illustrates a luminescent particle **1** comprising at least one nanoparticle **2** located on its surface and a dense particle **9** dispersed in the first material **11.**
**Figure 10B****,** not being part of the invention, for illustration purposes only, illustrates a luminescent particle **1** comprising at least one nanoparticle **2** and a dense particle **9** dispersed in the first material **11.**

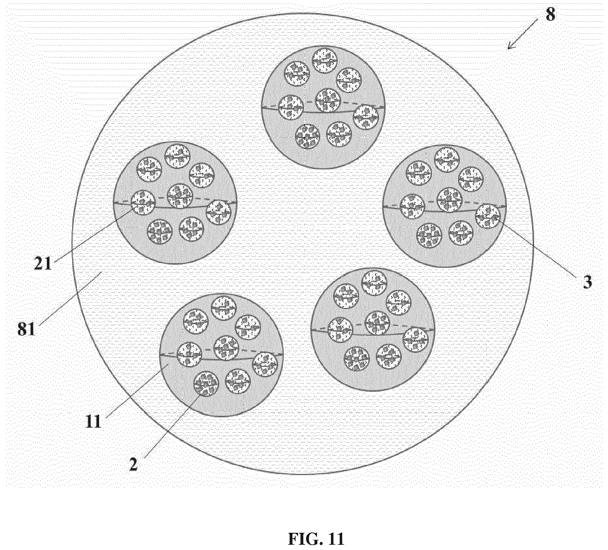

**Figure 11****,** not being part of the invention, for illustration purposes only, illustrates a bead **8** comprising a third material **81** and the luminescent particle **1** is dispersed in said third material **81.**
**Figure 12** illustrates different nanoparticles **3.**
**Figure 12A** illustrates a core nanoparticle **33** without a shell.
**Figure 12B** illustrates a core **33**/shell **34** nanoparticle **3** with one shell **34.**
**Figure 12C** illustrates a core **33**/shell (**34, 35**) nanoparticle **3** with two different shells (**34, 35**).
**Figure 12D** illustrates a core **33**/shell (**34, 35, 36**) nanoparticle **3** with two different shells (**34, 35**) surrounded by an oxide insulator shell **36.**
**Figure 12E** illustrates a core **33**/crown **37** nanoparticle **32.**
**Figure 12F** illustrates a sectional view of a core **33**/shell **34** nanoparticle **32** with one shell **34.**
**Figure 12G** illustrates a sectional view of a core **33**/shell (**34, 35**) nanoparticle **32** with two different shells (**34, 35**).
**Figure 12H** illustrates a sectional view of a core **33**/shell (**34, 35, 36**) nanoparticle **32** with two different shells (**34, 35**) surrounded by an oxide insulator shell **36.**
**Figure 13** illustrates a light emitting material **7.**
**Figure 13A** illustrates a light emitting material **7** comprising a host material **71** and at least one luminescent particle **1** of the invention.
**Figure 13B** illustrates a light emitting material **7** comprising a host material **71;** at least one luminescent particle **1** of the invention; a plurality of particles comprising an inorganic material **14;** and a plurality of 2D nanoparticles **32.**
**Figure 14** illustrates an optoelectronic device.
**Figure 14A** illustrates an optoelectronic device comprising a LED support **4,** a LED chip **5** and luminescent particles **1** deposited on said LED chip **5,** wherein the luminescent particles **1** cover the LED chip **5.**
**Figure 14B** illustrates an optoelectronic device comprising a LED support **4,** a LED chip **5** and luminescent particles **1** deposited on said LED chip **5** wherein the luminescent particles **1** cover and surround the LED chip **5.**
**Figure 15** illustrates a microsized LED **6** array comprising a LED support **4** and a plurality of microsized LED **6,** wherein the pixel pitch **D** is the distance from the center of a pixel to the center of the next pixel.
**Figure 16** illustrates an optoelectronic device.
**Figure 16A** illustrates an optoelectronic device comprising a LED support **4,** a microsized LED **6** and luminescent particles **1** deposited on said microsized LED **6,** wherein the luminescent particles **1** cover the microsized LED **6.**
**Figure 16B** illustrates an optoelectronic device comprising a LED support **4,** a microsized LED **6** and luminescent particles **1** deposited on said microsized LED **6** wherein the luminescent particles **1** cover and surround the microsized LED **6.**
**Figure 17A** is a TEM image of CdSe/CdZnS@HfO₂@SiO₂ particles
**Figure 17B** is a TEM image of CdSe/CdZnS@HfO₂@SiO₂ particles
**Figure 17C** is a TEM image of HfO₂ particles
**Figure 18A** illustrates a color conversion layer as described in the invention.
**Figure 18B** illustrates a color conversion layer as described in the invention.
**Figure 18C** illustrates a light emitting material comprising at least two host materials.
**Figure 18D** illustrates a light emitting material comprising at least two host materials.
**Figure 18E** illustrates a color conversion layer comprising three sub-pixels, wherein the first sub-pixel emits a green secondary light (**G**), the second sub-pixel emits a red secondary light (**R**), the third sub-pixel is free of light emitting material **7** or inorganic phosphor.

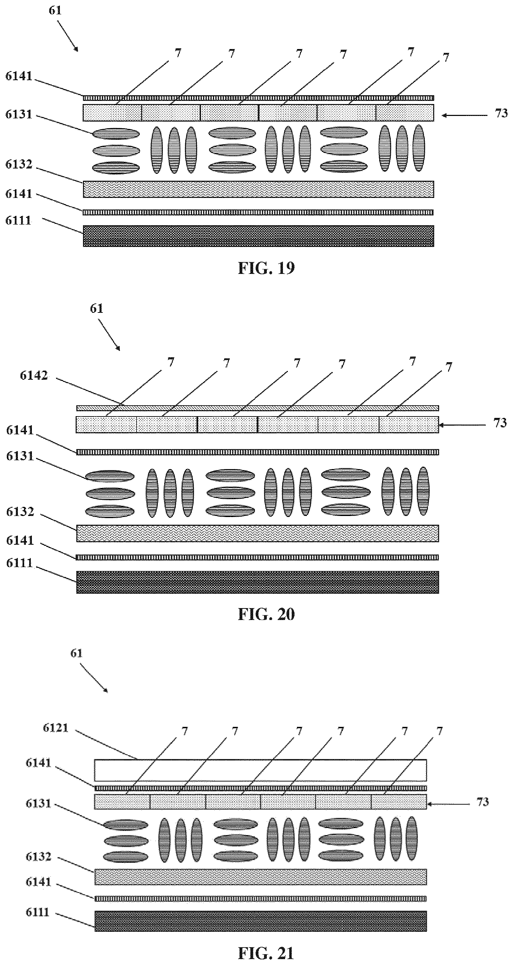

**Figure 19****,** not being part of the invention, for illustration purposes only, illustrates a structure of a display apparatus as described in the invention comprising an active matrix to control the light intensity passing through the liquid crystal layer before said light excites a color conversion layer comprising an array of light emitting materials.
**Figure 20****,** not being part of the invention, for illustration purposes only, illustrates a structure of a display apparatus as described in the invention comprising an optical enhancement film above the color conversion layer.
**Figure 21****,** not being part of the invention, for illustration purposes only, illustrates a structure of a display apparatus as described in the invention comprising a glass substrate.

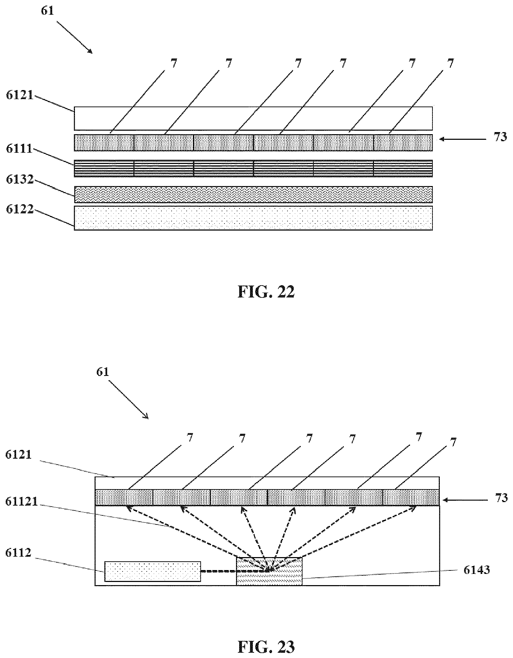

**Figure 22****,** not being part of the invention, for illustration purposes only, illustrates a display apparatus comprising an individual light source for each light emitting material of the array of light emitting materials.
**Figure 23****,** not being part of the invention, for illustration purposes only, illustrates a display apparatus comprising at least one laser source and an array of light emitting materials.

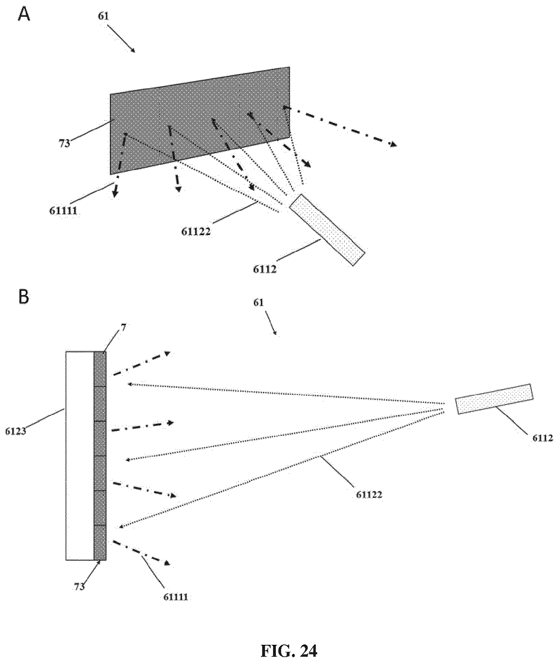

**Figures 24A** and **24B****,** not being part of the invention, for illustration purposes only, illustrate a display apparatus comprising at least one color conversion layer deposited onto a solid support.

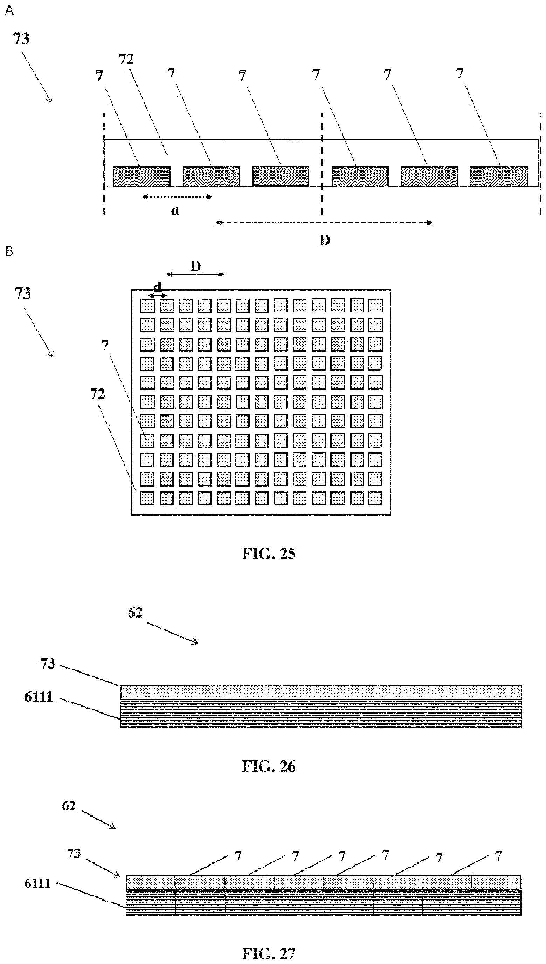

**Figures 25A** and **25B** illustrate a color conversion layer comprising an array of light emitting materials surrounded by a host material.
**Figure 26****,** not being part of the invention, for illustration purposes only, illustrates an illumination source comprising a light source and a color conversion layer.
**Figure 27****,** not being part of the invention, for illustration purposes only, illustrates an illumination source comprising an array of light source forming pixels and a color conversion layer comprising an array of light emitting materials.

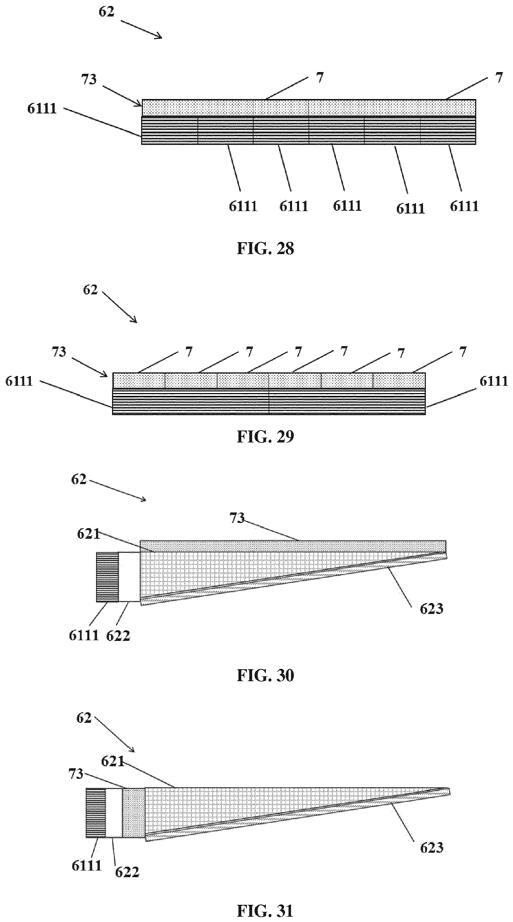

**Figure 28****,** not being part of the invention, for illustration purposes only, illustrates an illumination source wherein each pixel of the color conversion layer is illuminated by three light sources.
**Figure 29****,** not being part of the invention, for illustration purposes only, illustrates an illumination source wherein each light source pixel of the light source is able to illuminate several pixels of the color conversion layer.
**Figure 30****,** not being part of the invention, for illustration purposes only, illustrates an illumination source wherein the color conversion layer is upon a light guide, a reflector and a light source.
**Figure 31****,** not being part of the invention, for illustration purposes only, illustrates an illumination source wherein the color conversion layer is between the light source and the reflector.

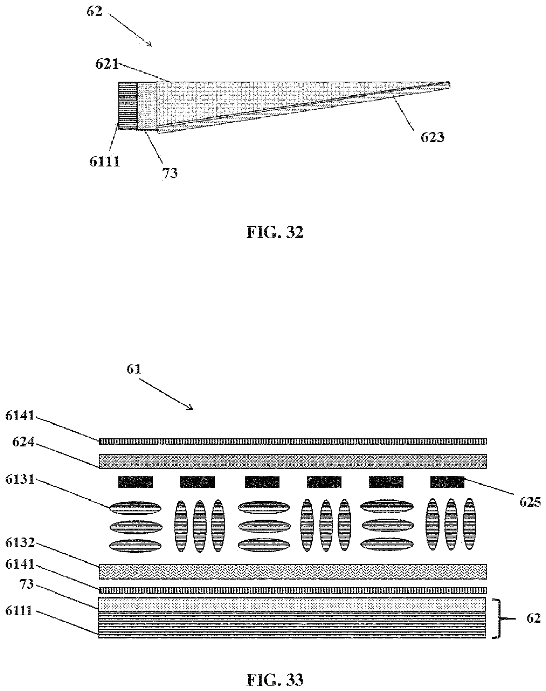

**Figure 32****,** not being part of the invention, for illustration purposes only, illustrates an illumination source wherein the color conversion layer is deposited on the light source.
**Figure 33****,** not being part of the invention, for illustration purposes only, illustrates a display apparatus comprising a light source, the color conversion layer, polarizers, an active matrix, a layer of liquid crystals material and a color filer layer.

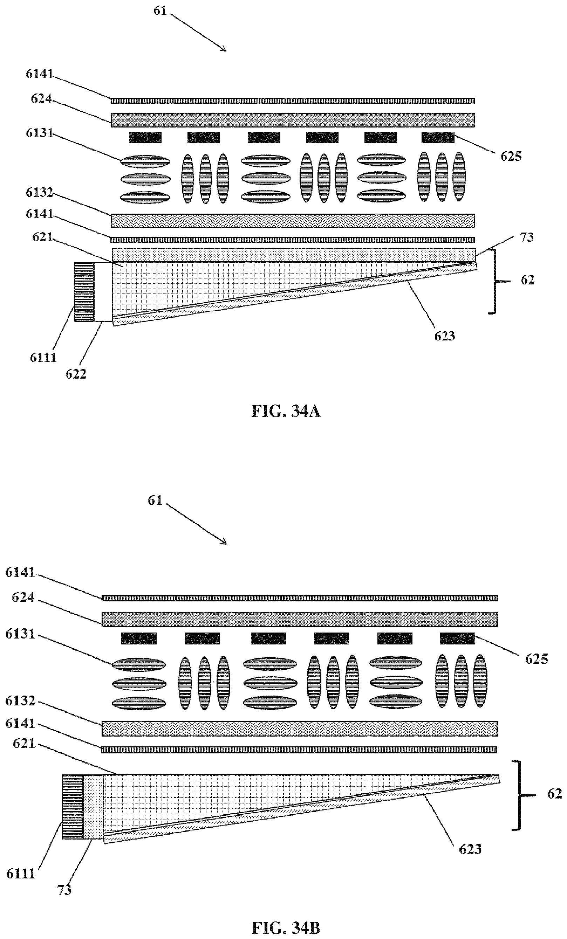

**Figures 34A** and **34B****,** not being part of the invention, for illustration purposes only, illustrate a display apparatus wherein the light source is a backlight unit comprising a color conversion layer.

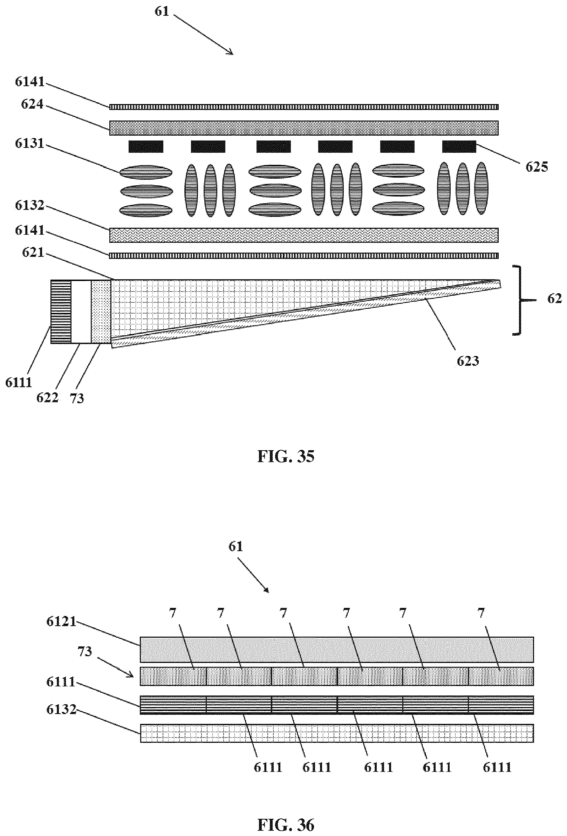

**Figure 35****,** not being part of the invention, for illustration purposes only, illustrates a display apparatus wherein the light source is a backlight unit comprising a color conversion layer.
**Figure 36****,** not being part of the invention, for illustration purposes only, illustrates a display apparatus comprising a light source and an active matrix.

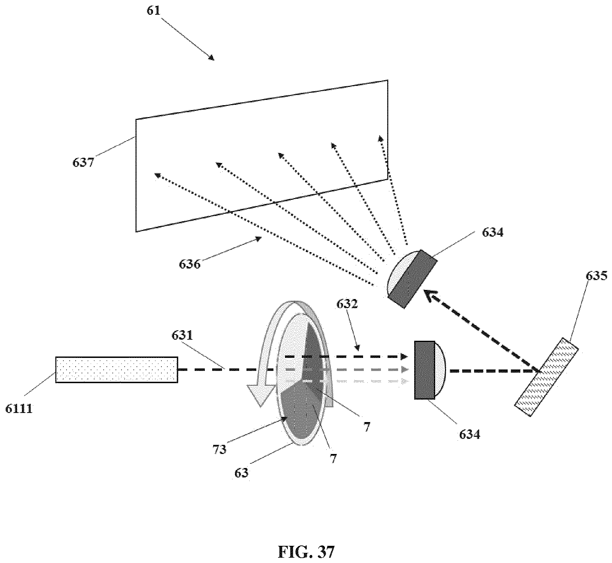

**Figure 37****,** not being part of the invention, for illustration purposes only, illustrates a display apparatus wherein the color conversion layer is deposited onto a rotation wheel and is excited by a light source.

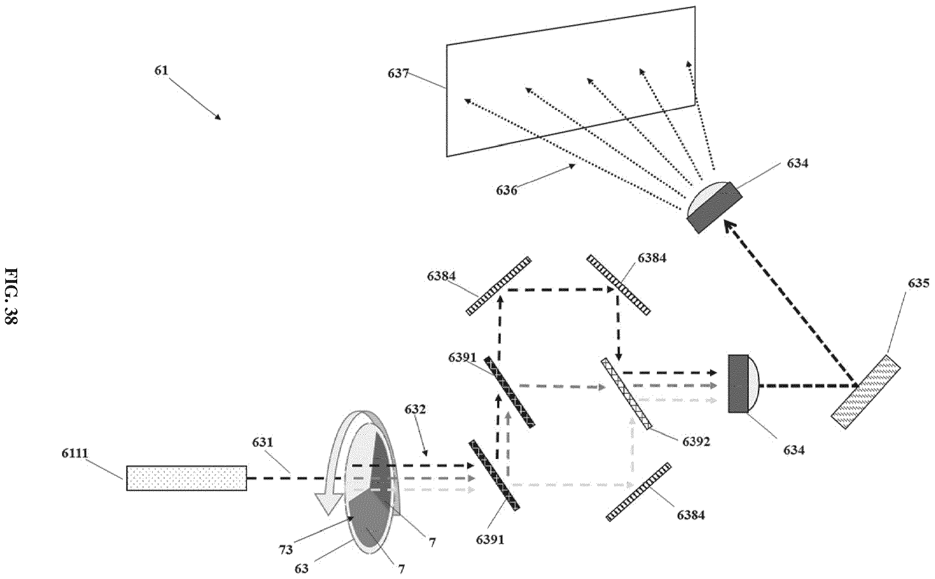

**Figure 38****,** not being part of the invention, for illustration purposes only, illustrates a display apparatus wherein the color conversion layer is deposited onto a rotation wheel and is excited by a light source.

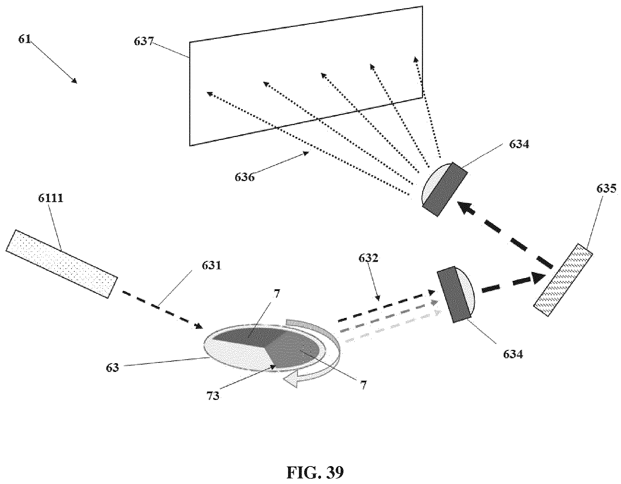

**Figure 39****,** not being part of the invention, for illustration purposes only, illustrates a display apparatus wherein the color conversion layer is deposited onto a rotation wheel and is excited by a light source. Said rotation wheel is configured to work in a reflective mode.

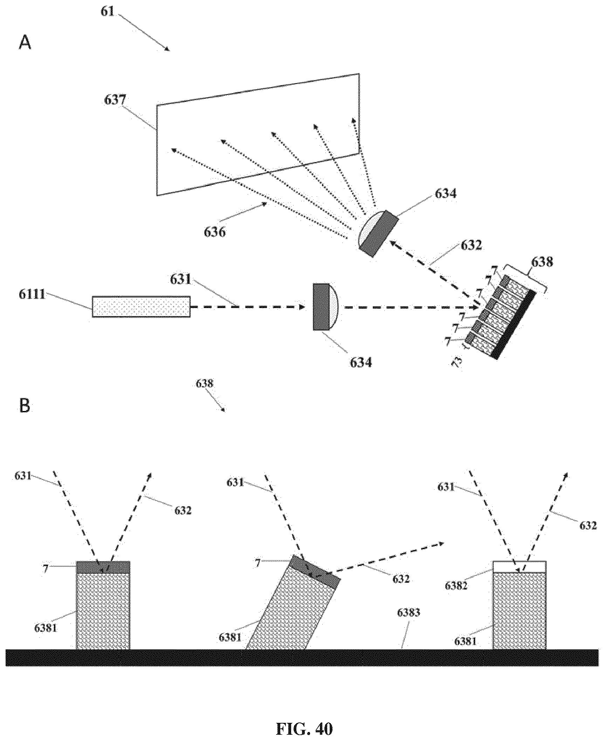

**Figures 40A****,** not being part of the invention, for illustration purposes only, illustrates a display apparatus comprising a digital micromirror device according to the invention.
**Figures 40B****,** not being part of the invention, for illustration purposes only, illustrates a digital micromirror device according to the invention.

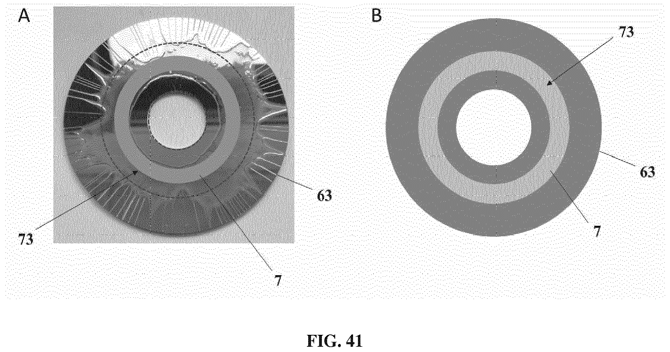

**Figure 41****,** not being part of the invention, for illustration purposes only, illustrates a a rotation wheel, wherein the color conversion layer forms a ring on said rotation wheel.

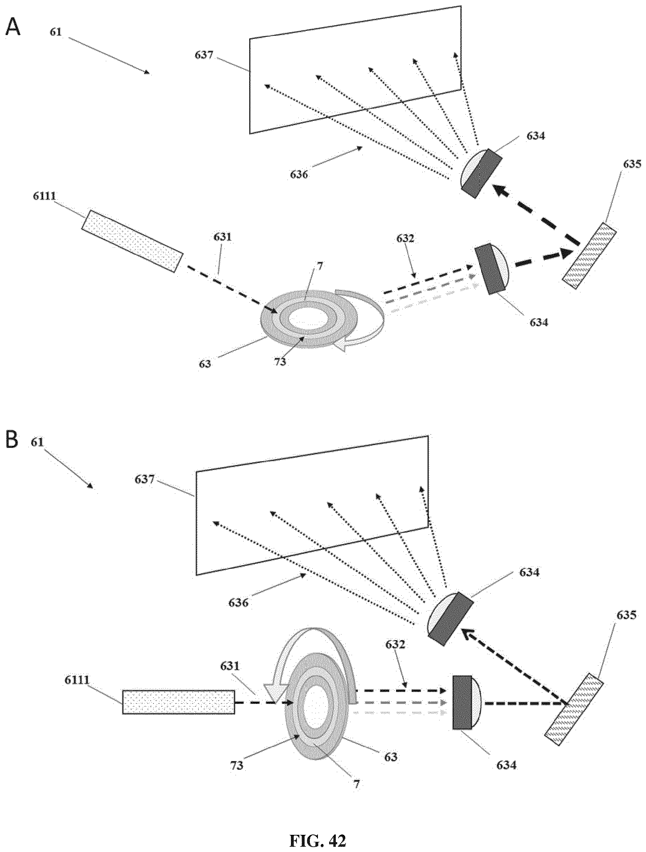

**Figure 42****,** not being part of the invention, for illustration purposes only, illustrates a display apparatus wherein the color conversion layer is deposited onto a rotation wheel to form a ring and is excited by a light source.

### EXAMPLES

The present invention is further illustrated by the following examples.

### Example 1: Inorganic nanoparticles preparation

Nanoparticles used in the examples herein were prepared according to methods of the art (Lhuillier E. et al., Acc. Chem. Res., 2015, 48 (1), pp 22-30; Pedetti S. et al., J. Am. Chem. Soc., 2014, 136 (46), pp 16430-16438; Ithurna S. et al., J. Am. Chem. Soc., 2008, 130, 16504-16505; Nasilowski M. et al., Chem. Rev. 2016, 116, 10934-10982).

Nanoparticles used in the examples herein were selected in the group comprising CdSe/CdZnS, CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots.

### Example 2: Exchange ligands for phase transfer in basic aqueous solution

100 µL of CdSe/CdZnS nanoplatelets suspended in heptane were mixed with 3-mercaptopropionic acid and heated at 60°C for several hours. The nanoparticles were then precipitated by centrifugation and redispersed in dimethylformamide. Potassium tert-butoxide were added to the solution before adding ethanol and centrifugate. The final colloidal nanoparticles were redispersed in water.

### Example 3: Exchange ligands for phase transfer in acidic aqueous solution

100 µL of CdSe/CdZnS nanoplatelets suspended in a basic aqueous solution were mixed with ethanol and centrifugated. A PEG-based polymer was solubilized in water and added to the precipitated nanoplatelets. Acetic acid was dissolved in the colloidal suspension to control the acidic pH.

### Example 4: InP/GaP/ZnSe/ZnS@Al₂O₃@HfO₂

### 1st step

100 µL of InP/GaP/ZnSe/ZnS nanocrystals suspended in heptane (10mg/mL) were mixed with aluminium tri-sec butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles InP/GaP/ZnSe/ZnS@Al₂O₃ were collected at the surface of a filter.

### 2nd step

5mg of InP/GaP/ZnSe/ZnS@Al₂O₃ particles were suspended in 5 mL of pentane and mixed with hafnium n-butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles InP/GaP/ZnSe/ZnS@Al₂O₃@HfO₂ were collected at the surface of a filter.

The same procedure was carried out by replacing InP/GaP/ZnSe/ZnS nanocrystals with CdSe/CdZnS, CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing InP/GaP/ZnSe/ZnS nanocrystals with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 5: InP/ZnS/ZnSe/ZnS@Al₂O₃@HfO₂

### 1st step

100 µL of InP/ZnS/ZnSe/ZnS nanocrystals suspended in heptane (10mg/mL) were mixed with aluminium tri-sec butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles InP/ZnS/ZnSe/ZnS@Al₂O₃ were collected at the surface of a filter.

### 2nd step

5mg of InP/ZnS/ZnSe/ZnS@Al₂O₃ particles were suspended in 5 mL of pentane and mixed with hafnium n-butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles InP/ZnS/ZnSe/ZnS@Al₂O₃@HfO₂ were collected at the surface of a filter.

The same procedure was carried out by replacing InP/ZnS/ZnSe/ZnS nanocrystals with CdSe, CdS, CdTe, CdSe/CdS, CdSe/ZnS, CdSe/CdZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing InP/ZnS/ZnSe/ZnS nanocrystals with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 6: CdSe/CdZnS@HfO₂@Si_{0.8}Hf_{0.2}O₂

### 1st step

100 µL of CdSe/CdZnS nanoplatelets suspended in heptane (10mg/mL) were mixed with hafnium n-butoxide and 5 mL of pentane, then loaded on a spray-drying set-up. On another side, an aqueous solution was prepared and loaded the same spray-drying set-up, but at a different location than the first pentane solution. The two liquids were sprayed simultaneously towards a tube furnace heated at a temperature ranging from the boiling point of the solvent to 1000°C with a nitrogen flow. The resulting particles CdSe/CdZnS@HfO₂ were collected at the surface of a filter.

### 2nd step

50 mg of CdSe/CdZnS@HfO₂ particles were suspended in 20 mL of ethanol and mixed with TEOS, hafnium oxychloride and water, then loaded on a spray-drying set-up. The liquid was sprayed towards a tube furnace heated at a temperature ranging from the boiling point of the solvent to 1000°C with a nitrogen flow. The luminescent particles CdSe/CdZnS@HfO₂@SiHfO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing and/or HfO₂ with ZnTe, Al₂O₃, SiO₂, TiO₂, HfO₂, ZnSe, ZnO, ZnS, SiZrO₂, or MgO, or a mixture thereof. Reaction temperature of the above procedure is adapted according to the inorganic material chosen.

The same procedure was carried out by replacing and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 7: CdSe/CdZnS@HfO₂@Si_{0.8}Zr_{0.2}O₂

### 1st step

100 µL of CdSe/CdZnS nanoplatelets suspended in heptane (10mg/mL) were mixed with hafnium n-butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS @HfO₂ were collected at the surface of a filter.

### 2nd step

50 mg of CdSe/CdZnS@HfO₂ particles were suspended in 20 mL of ethanol and mixed with TEOS, zirconium oxychloride and water, then loaded on a spray-drying set-up. The liquid was sprayed towards a tube furnace heated at a temperature ranging from the boiling point of the solvent to a temperature ranging from the boiling point of the solvent to 1000°C with a nitrogen flow. The luminescent particles CdSe/CdZnS@HfO₂@SiZrO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiZrO₂ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing SiZrO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 8: CdSe/CdZnS@Al₂O₃@HfO₂

### 1st step

100 µL of CdSe/CdZnS nanoplatelets suspended in heptane (10mg/mL) were mixed with aluminium tri-sec butoxide and 5 mL of pentane, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS@Al₂O₃ (particles **2**) were collected at the surface of a filter.

### 2nd step

5mg of CdSe/CdZnS@Al₂O₃ particles were suspended in 5 mL of pentane and mixed with hafnium n-butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles CdSe/CdZnS@Al₂O₃@HfO₂ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, Al₂O₃, SiO₂, TiO₂, HfO₂, ZnSe, ZnO, ZnS, SiZrO₂, or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 9: CdSe/CdZnS@Al₂O₃ and SnO₂ particles encapsulated in Al₂O₃

5mg of a previously prepared CdSe/CdZnS@Al₂O₃ particles (size: 150 nm) were suspended in 5 mL of pentane along with larger particles (SnO₂, 2 µm) and mixed with aluminium tri-sec butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles, CdSe/CdZnS@Al₂O₃ and SnO₂ particles encapsulated in Al₂O₃, were collected at the surface of a filter.

Note: the amount of aluminium tri-sec butoxide is calculated so that the amount of Al₂O₃ formed would form a layer around the SnO₂ particle so that it is thicker than the solid diameter.

The same procedure was carried out by replacing CdSe/CdZnS nanoplatelets and/or SnO₂ particles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ particles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ with ZnTe, Al₂O₃, SiO₂, HfO₂, ZnSe, ZnO, ZnS, TiO₂, SiZrO₂, or MgO, or a mixture thereof. Reaction temperature of the above procedure is adapted according to the inorganic material chosen.

The same procedure was carried out by replacing Al₂O₃ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 10: CdSe/CdZnS@HfO₂@Al₂O₃

### 1st step

100 µL of CdSe/CdZnS nanoplatelets suspended in heptane (10mg/mL) were mixed with hafnium n-butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS @HfO₂ were collected at the surface of a filter.

### 2nd step

5mg of CdSe/CdZnS@HfO₂ particles were suspended in 5 mL of pentane and mixed with aluminium tri-sec butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles CdSe/CdZnS@HfO₂@Al₂O₃ were collected at the surface of a filter.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, Al₂O₃, SiO₂, TiO₂, HfO₂, ZnSe, ZnO, ZnS, SiZrO₂, or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 11: CdSe/CdZnS@HfO₂ and SnO₂ particles encapsulated in Al₂O₃

5mg of a previously prepared CdSe/CdZnS@HfO₂ particles (size: 150 nm) were suspended in 5 mL of pentane along with larger particles (SnO₂, 2 µm) and mixed with aluminium tri-sec butoxide, then loaded on a spray-drying set-up. On another side, an aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles, CdSe/CdZnS@HfO₂ and SnO₂ particles encapsulated in Al₂O₃, were collected at the surface of a filter.

Note: the amount of aluminium tri-sec butoxide is calculated so that the amount of Al₂O₃ formed would form a layer around the SnO₂ particle so that it is thicker than the solid diameter.

The same procedure was carried out by replacing CdSe/CdZnS nanoplatelets and/or SnO₂ particles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ particles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 12: Preparation of CdSe/CdZnS@HfO₂@SiO₂ comprising SnO₂ nanoparticles by microemulsion

CdSe/CdZnS@HfO₂ and SnO₂ nanoparticles (30-40nm diameter) were coated with SiO₂ using reverse micelles of polyoxyethylene cetylether (Nihon surfactant, C-15) using cyclohexane (purity 99.0%) as the organic phase. The concentration of the surfactant in the organic solvent was 0.5 mol/L. The microemulsion solution was prepared by injecting an aqueous solution (4.0 mL, denoted as aq.) containing 100mg of CdSe/CdZnS@HfO₂ and SnO₂ nanoparticles (varying proportions) into the organic surfactant solution (100 mL) at 50°C under magnetic stirring. An oxalic acid solution ((COOH)₂ aq., 1 mol/L, 3.0 mL) was used to charge positively the oxides surface. Tetraethylorthosilicate (TEOS, 0.86 mol/L in the microemulsion solution) as a SiO₂ source and diluted NH₄OH solution (2.70 mol/l, 15.0 ml) were charged into the microemulsion containing CdSe/CdZnS@HfO₂ and SnO₂ nanoparticles, and subjected to hydrolysis at 50°C for 60 min. The molar ratio of water to surfactant in the solution during TEOS hydrolysis was 23. The solid formed was centrifuged, thoroughly washed with propanol, dried at 80°C overnight, and a thermal treatment at 130°C for 24h was performed in air.

The same procedure was carried out by replacing CdSe/CdZnS nanoplatelets and/or SnO₂ nanoparticles with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets and/or SnO₂ nanoparticles with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing SiO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 12 bis: Preparation of CdSe/CdS/ZnS@SiO₂@HfO₂ nanoparticles by microemulsion

The formation of a silica shell around the CdSe/CdS/ZnS nanocrystals was performed by an inverse water-in-oil microemulsion micelles method. In particular, 0.98 g of the surfactant Triton X-100 (C₈H₁₇C₆H₄(OC₂H₄)₉-₁₀OH) and 0.75 g of 1-Hexanol as co-surfactant were mixed and dissolved in 7.5 ml of cyclohexane. Then, -0.08 nmol of CdSe/CdS/ZnS particles dispersed in hexane were injected and after 10 min of stirring with a magnetic bar, 190 µl of water and 30 µl of ammonia (29% in water) were added. After, 30 µl of TEOS were added to start the reaction of silica formation around the nanoparticles. After 6h, another amount of 150 µl of TEOS was added to have final 100 nm diameter silica nanoparticles after 30 h of total time of growth. The CdSe/CdS/ZnS@SiO₂ particles show a high monodispersity (diameter 100±4 nm), only one CdSe/CdS/ZnS nanocrystal per silica particle and a few of empty silica beads. The microemulsion was broken by adding acetone and after centrifugation, CdSe/CdS/ZnS@SiO₂ particles were washed by centrifugation and sonication in different solvents (50% n-butanol-50% hexane, 50% isopropanol-50% hexane, 50% ethanol-50% hexane, two times in ethanol) and finally dispersed in 7.5 ml of ethanol with a final concentration of the order of 10 nM.

5mg of CdSe/CdS/ZnS@SiO₂ particles were suspended in 5 mL of pentane and mixed with hafnium n-butoxide, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The luminescent particles CdSe/CdS/ZnS@SiO₂@HfO₂ were collected at the surface of a filter.

The same procedure was carried out by replacing CdSe/CdS/ZnS nanocrystals with CdSe, CdS, CdTe, CdSe/CdS, CdSe/ZnS, CdSe/CdZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdS/ZnS nanocrystals with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ and/or HfO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing SiO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 13: Semiconductor nanoplatelets@Al₂O₃@SiO₂

The dry solid 0.05 g, i.e. semiconductor nanoplatelets@Al₂O₃, is weighted under dry atmosphere (glovebox) and is dispersed in 1 mL of pure/dry THF, then 0.07 mL of 2.3 mol.L⁻¹ HCl solution is added. The solution is then heated in a closed vessel to 70°C. A solution (1 mL) containing TEOS (TétraEthylOrthoSilicate) (0.5 mmol.L⁻¹) in clean THF is added dropwise over a period of 0.1 µmol.min⁻¹ under stirring. The mixture is then refluxed for about 1 h. The product is then filtered and washed consecutively with 20/80 water/THF (3 x 5 mL), EtOH (3 x 5 mL), and Et₂O (3 x 5 mL), and dried at 80°C under vacuum.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or SiO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 14: Semiconductor nanoplatelets@HfO₂@SiO₂

The dry solid 0.05 g, i.e. semiconductor nanoplatelets@HfO₂, is weighted under dry atmosphere (glovebox) and is dispersed in 1 mL of pure/dry THF, then 0.07 mL of 2.3 mol.L⁻¹ HCl solution is added. The solution is then heated in a closed vessel to 70°C. A solution (1 mL) containing TEOS (TétraEthylOrthoSilicate) (0.5 mmol.L⁻¹) in clean THF is added dropwise over a period of 0.1 µmol.min⁻¹ under stirring. The mixture is then refluxed for about 1 h. The product is then filtered and washed consecutively with 20/80 water/THF (3 x 5 mL), EtOH (3 x 5 mL), and Et₂O (3 x 5 mL), and dried at 80°C under vacuum.

Note 1: Trialkoxy Azidoalkyl silane, Trialkoxy Aminoalkyl silane or Trialkoxy alkylThiol silane can be added to the TEOS solution to add versatile functionalities the solid for further functionalization.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing HfO₂ and/or SiO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing HfO₂ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 15: Semiconductor nanoplatelets@Al₂O₃@SiO₂

Semiconductor nanoplatelets@Al₂O₃ particles are dispersed in 16.7wt% H₂O in an anhydrous ethanol to reach 5 wt.% solid loading and then ultrasonicated to break down agglomerates. A 20 wt.% of TEOS+silane in ethanol solution (quantity varied to tune SiO₂ thickness) was carefully added to the suspension step by step. The amounts of added TEOS were calculated based on the surface area of semiconductor nanoplatelets@Al₂O₃ particle and the desired shell thickness, assuming complete conversion of TEOS to silica. The appropriate pH value of the suspension was adjusted using ammonia to pH = 11. Afterward, the suspension was stirred at 50°C for 6h to control the thickness of the coating layer through the hydrolysis and condensation of TEOS on the surface of semiconductor nanoplatelets@Al₂O₃ particle. Resulting particles were then collected by centrifuged, washed with anhydrous ethanol and dried in an oven at 80°C.

The same procedure was carried out by replacing semiconductor nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing Al₂O₃ and/or SiO₂ with ZnTe, Al₂O₃, SiO₂, TiO₂, HfO₂, ZnSe, ZnO, ZnS, SiZrO₂, SiHfO₂ or MgO, or a mixture thereof. Reaction temperature of the above procedure is adapted according to the inorganic material chosen.

The same procedure was carried out by replacing Al₂O₃ and/or SiO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 16: CdSe/CdZnS@HfO₂@SiO₂

### 1st step

100 µL of CdSe/CdZnS nanoplatelets suspended in heptane (10mg/mL) were mixed with Hafnium n-butoxide and 5 mL of pentane, then loaded on a spray-drying set-up. On another side, a basic aqueous solution was prepared and loaded the same spray-drying set-up, but at a different location than the first heptane solution. The two liquids were sprayed simultaneously towards a tube furnace heated at a temperature ranging from the boiling point of the solvent to 1000°C with a nitrogen flow. The resulting particles CdSe/CdZnS @HfO₂ were collected at the surface of a filter.

### 2nd step

50 mg of CdSe/CdZnS @HfO₂ particles were suspended in 20 mL of water and mixed with TEOS and ammonia, then loaded on a spray-drying set-up. The liquid was sprayed towards a tube furnace heated at a temperature ranging from the boiling point of the solvent to 1000°C with a nitrogen flow. The luminescent particles CdSe/CdZnS@HfO₂@SiO₂ were collected at the surface of a filter.

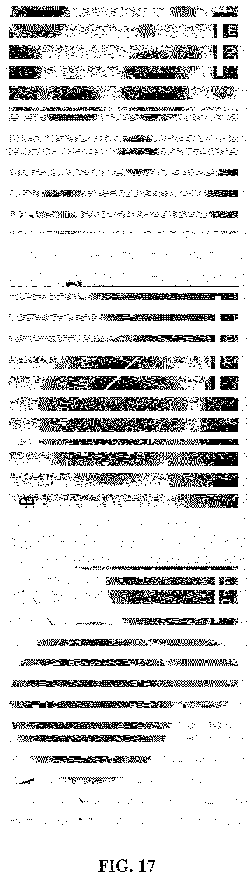

Figures 17A and 17B show as-synthetized CdSe/CdZnS@HfO₂@SiO₂ particles.

Figure 17C show a TEM image of HfO₂ particles, it is clear from that pictures that CdSe/CdZnS@HfO₂ seen in Figures 17A and 17B have a morphology consistent with HfO₂ particles.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing SiO₂ and/or HfO₂ with ZnTe, Al₂O₃, SiO₂, TiO₂, HfO₂, ZnSe, ZnO, ZnS, SiZrO₂, or MgO, or a mixture thereof. Reaction temperature of the above procedure is adapted according to the inorganic material chosen.

The same procedure was carried out by replacing SiO₂ and/or HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof. Reaction temperature of the above procedure is adapted according to the inorganic material chosen.

### Example 17: Luminescent particles preparation from an organometallic precursor

100 µL of CdSe/CdZnS@HfO₂particles suspended in heptane were mixed with an organometallic precursor selected in the group below in pentane under controlled atmosphere, then loaded on a spray-drying set-up. On another side, an aqueous solution was prepared and loaded on the same spray-drying set-up, but at a different location than the first heptane solution. The two liquids were sprayed simultaneously towards a tube furnace heated from room temperature to 300°C with a nitrogen flow. The particles were collected at the surface of a filter.

The procedure was carried out with an organometallic precursor selected in the group comprising: Al[N(SiMe₃)₂]₃, trimethyl aluminium, triisobutylaluminum, trioctylaluminum, triphenylaluminum, dimethyl aluminium, trimethyl zinc, dimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate), Hf[C₅H₄(CH₃)]₂(CH₃)₂, HfCH₃(OCH₃)[C₅H₄(CH₃)]₂, [[(CH₃)₃Si]₂N]₂HfCl₂, (C₅H₅)₂Hf(CH₃)₂, [(CH₂CH₃)₂N]₄Hf, [(CH₃)₂N]₄Hf, [(CH₃)₂N]₄Hf, [(CH₃)(C₂H₅)N]₄Hf, [(CH₃)(C₂H₅)N]₄Hf, 2,2',6,6'-tetramethyl-3,5-heptanedione zirconium (Zr(THD)₄), C₁₀H₁₂Zr, Zr(CH₃C₅H₄)₂CH₃OCH₃, C₂₂H₃₆Zr, [(C₂H₅)₂N]₄Zr, [(CH₃)₂N]₄Zr, [(CH₃)₂N]₄Zr, Zr(NCH₃C₂H₅)₄, Zr(NCH₃C₂H₅)₄, C₁₈H₃₂O₆Zr, Zr(C₈H₁₅O₂)₄, Zr(OCC(CH₃)₃CHCOC(CH₃)₃)₄, Mg(C₅H₅)₂, or C₂₀H₃₀Mg. Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing HfO₂ with ZnTe, Al₂O₃, SiO₂, HfO₂, ZnSe, TiO₂, ZnO, ZnS, SiZrO₂, or MgO, or a mixture thereof. The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

### Example 18: Luminescent particles preparation from an organometallic precursor - CdSe/CdZnS@HfO₂@ZnTe

100 µL of CdSe/CdZnS@HfO₂ particles suspended in heptane were mixed with two organometallic precursors selected in the group below in pentane under inert atmosphere then loaded on a spray-drying set-up. The suspension was sprayed towards a tube furnace heated from RT to 300°C with a nitrogen flow. The particles were collected at the surface of a filter.

The procedure was carried out by with a first organometallic precursor selected in the group comprising: dimethyl telluride, diethyl telluride, diisopropyl telluride, di-t-butyl telluride, diallyl telluride, methyl allyl telluride, dimethyl selenide, or dimethyl sulfur. Reaction temperature of the above procedure is adapted according to the organometallic precursor chosen.

The procedure was carried out by with a second organometallic precursor selected in the group comprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, or Zn(TMHD)₂ (β-diketonate). Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS2/ZnS, CuInSe2/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnTe with ZnS or ZnSe, or a mixture thereof.

The same procedure was carried out by replacing HfO₂ with ZnTe, Al₂O₃, SiO₂, HfO₂, ZnSe, TiO₂, ZnO, ZnS, SiZrO₂, SiHfO₂ or MgO, or a mixture thereof. The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

### Example 19: Luminescent particles preparation from an organometallic precursor - CdSe/CdZnS@HfO₂@ZnS

100 µL of CdSe/CdZnS@HfO₂ particles suspended in heptane were mixed with an organometallic precursor selected in the group below in pentane under inert atmosphere, then loaded on a spray-drying set-up. On another side, a vapor source of H₂S was inserted in the same spray-drying set-up. The suspension was sprayed towards a tube furnace heated from RT to 300°C with a nitrogen flow. The particles were collected at the surface of a filter.

The procedure was carried out with an organometallic precursor selected in the group omprising: dimethyl zinc, trimethyl zinc, diethylzinc, Zn[(N(TMS)₂]₂, Zn[(CF₃SO₂)₂N]₂, Zn(Ph)₂, Zn(C₆F₅)₂, Zn(TMHD)₂ (β-diketonate). Reaction temperature of the above procedure is adapted according to the organometallic precursor chosen.

The same procedure was carried out by replacing CdSe/CdZnS nanoplatelets with CdSe, CdS, CdTe, CdSe/CdS, CdSe/ZnS, CdSe/CdZnS, CdS/ZnS, CdS/CdZnS, CdTe/ZnS, CdTe/CdZnS, CdSeS/ZnS, CdSeS/CdS, CdSeS/CdZnS, CuInS₂/ZnS, CuInSe₂/ZnS, InP/CdS, InP/ZnS, InZnP/ZnS, InP/ZnSeS, InP/ZnSe, InP/CdZnS, CdSe/CdZnS/ZnS, CdSe/ZnS/CdZnS, CdSe/CdS/ZnS, CdSe/CdS/CdZnS, CdSe/ZnSe/ZnS, CdSeS/CdS/ZnS, CdSeS/CdS/CdZnS, CdSeS/CdZnS/ZnS, CdSeS/ZnSe/ZnS, CdSeS/ZnSe/CdZnS, CdSeS/ZnS/CdZnS, CdSe/ZnS/CdS, CdSeS/ZnS/CdS, CdSe/ZnSe/CdZnS, InP/ZnSe/ZnS, InP/CdS/ZnSe/ZnS, InP/CdS/ZnS, InP/ZnS/CdS, InP/GaP/ZnS, InP/GaP/ZnSe, InP/CdZnS/ZnS, InP/ZnS/CdZnS, InP/CdS/CdZnS, InP/ZnSe/CdZnS, InP/ZnS/ZnSe, InP/GaP/ZnSe/ZnS, InP/ZnS/ZnSe/ZnS, nanoplatelets or quantum dots, or a mixture thereof.

The same procedure was carried out by replacing CdSe/CdZnS nanoplatelets with organic nanoparticles, inorganic nanoparticles such as metal nanoparticles, halide nanoparticles, chalcogenide nanoparticles, phosphide nanoparticles, sulfide nanoparticles, metalloid nanoparticles, metallic alloy nanoparticles, phosphor nanoparticles, perovskite nanoparticles, ceramic nanoparticles such as for example oxide nanoparticles, carbide nanoparticles, nitride nanoparticles, or a mixture thereof.

The same procedure was carried out by replacing ZnS with ZnSe or ZnTe, or a mixture thereof.

The same procedure was carried out by replacing HfO₂ with ZnTe, Al₂O₃, SiO₂, HfO₂, ZnSe, TiO₂, ZnO, ZnS, SiZrO₂, SiHfO₂ or MgO, or a mixture thereof. The same procedure was carried out by replacing HfO₂ with a metal material, halide material, chalcogenide material, phosphide material, sulfide material, metalloid material, metallic alloy material, ceramic material such as for example oxide, carbide, nitride, glass, enamel, ceramic, stone, precious stone, pigment, cement and/or inorganic polymer, or a mixture thereof.

The same procedure was carried out by replacing the aqueous solution with another liquid or vapor source of oxidation.

The same procedure was carried out by replacing H₂S with H₂Se, H₂Te or other gas.

### Example 20: Dispersion of luminescent particles in a silicone and deposition onto a LED.

Luminescent partricles as-prepared in the examples hereabove, and containing fluorescent nanoparticles, were dispersed in a polymer of silicone, with a mass concentration of 20%. The obtained material was deposited onto a LED of InGaN before annealing at 150°C for 2 hours. The LED was then turned on to get a mixture of blue light and the light emitted by the fluorescent nanoparticles.

The same procedure was carried out by replacing silicone with ZnO, PMMA, Polystyrene, Al₂O₃, TiO₂, HfO₂ or ZrO₂, or a mixture thereof.

### Example 21: Dispersion of luminescent particles in a ZnO matrix and deposition onto a LED.

Luminescent partricles as-prepared in the examples hereabove, and containing fluorescent nanoparticles, were dispersed in a ZnO matrix prepared by a sol-gel method. The material was then deposited onto a glass substrate by spin-coating and annealed at 100°C for 24 hours. The glass substrate was then illuminated by a blue laser to get a mixture of blue light and the light emitted by the fluorescent nanoparticles.

The same procedure was carried out by replacing ZnO with a resin, silicone, PMMA, Polystyrene, Al₂O₃, TiO₂, HfO₂ or ZrO₂, or a mixture thereof.

### Example 22: Color conversion layer preparation

Blue emitting luminescent partricles as-prepared in the examples hereabove, green emitting luminescent partricles as-prepared in the examples hereabove, and red emitting luminescent partricles as-prepared in the examples hereabove were dispersed separately in silicone and deposited onto a support, such that each film of luminescent particles was around 1-10 µm in thickness. The support was then annealed at 180°C for 2 hours before it was introduced in the display apparatus described in the invention. The resulting lights were blue, green and red depending on the luminescent particles illuminated with the UV light from a light source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 23: Color conversion layer preparation

Green emitting core-shell CdSeS/CdZnS nanoplatelets and red emitting core-shell CdSe/CdZnS nanoplatelets were dispersed separately in silicone and deposited onto a support, such that each film of luminescent particles was around 1-10 µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 24: Color conversion layer preparation

Green emitting luminescent partricles as-prepared in the examples hereabove, and red emitting luminescent partricles as-prepared in the examples hereabove were dispersed separately in a zinc oxide matrix and deposited onto a support, such that each film of luminescent particles was around 1-10 µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing ZnO with a resin, silicone, MgO, PMMA, Polystyrene, Al₂O₃, TiO₂, HfO₂ or ZrO₂, or a mixture thereof.

The same procedure was carried out with luminescent particles prepared in the examples hereabove.

### The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 25: Color conversion layer preparation

Green emitting luminescent partricles as-prepared in the examples hereabove, and red emitting luminescent partricles as-prepared in the examples hereabove were dispersed separately in silicone and deposited onto a support, such that each film of luminescent particles was around 1-10 µm µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing silicone with a resin, ZnO, PMMA, MgO, Polystyrene, Al₂O₃, TiO₂, HfO₂ or ZrO₂, or a mixture thereof.

The same procedure was carried out with luminenescent particles prepared in the examples hereabove.

### The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 26: Color conversion layer preparation

Green emitting luminescent partricles as-prepared in the examples hereabove, and red emitting luminescent partricles as-prepared in the examples hereabove were dispersed separately in silicone and deposited onto a support, such that each film of luminescent particles was around 1-10 µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing silicone with a resin, ZnO, PMMA, MgO, Polystyrene, Al₂O₃, TiO₂, HfO₂ or ZrO₂, or a mixture thereof.

The same procedure was carried out with luminescent particles prepared in the examples hereabove.

The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 27: Color conversion layer preparation

Green emitting luminescent partricles as-prepared in the examples hereabove, and red emitting c luminescent partricles as-prepared in the examples hereabove were dispersed separately in a resin matrix and deposited onto a support, such that each film of luminescent particles was around 1-10 µm in thickness. The support was then annealed at 180°C for 3 hours before it was introduced in the display apparatus described in the invention. The resulting lights were green and red depending on the luminescent particles illuminated with the blue light from a light source.

The same procedure was carried out by replacing the resin with silicone, ZnO, MgO, PMMA, Polystyrene, Al₂O₃, TiO₂, HfO₂ or ZrO₂, or a mixture thereof.

The same procedure was carried out with luminescent particles prepared in the examples hereabove.

The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 28: Color conversion layer preparation

Green emitting luminescent partricles as-prepared in the examples hereabove and red emitting luminescent partricles as-prepared in the examples hereabove were dispersed separately in silicone and deposited onto a support, such that each film of luminescent particles was around 1-10 µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### The same procedure was carried out using inkjet printing; or traditional lithography.

With traditional lithography: the entire surface was coated with blue emitting luminescent particles, followed by the subtractive photolithography patterning process. The process is then repeated for the red emitting luminescent particles and for the green emitting luminescent particles.

### Example 29: Color conversion layer preparation

Green emitting luminescent partricles as-prepared in the examples hereabove and red emitting luminescent partricles as-prepared in the examples hereabove were dispersed separately in a MgO matrix and deposited onto a support, such that each film of luminescent particles was around 1-10 µm in thickness. The support was then annealed at 180°C for 2 hours before it was introduced in the display apparatus described in the invention. The resulting lights were green and red depending on the luminescent particles illuminated with the blue light from a light source.

The same procedure was carried out by replacing MgO with a resin, ZnO, silicone, PMMA, Polystyrene, Al₂O₃, TiO₂, HfO₂ or ZrO₂, or a mixture thereof.

The same procedure was carried out with luminescent particles prepared in the examples hereabove.

The same procedure was carried out using inkjet printing; or traditional lithography: the entire surface was coated with blue emitting luminescent particles, followed by the subtractive photolithography patterning process. The process is then repeated for the red emitting luminescent particles and for the green emitting luminescent particles.

### The same procedure was carried out using inkjet printing.

### Example 30: Color conversion layer preparation

Blue emitting luminescent partricles as-prepared in the examples hereabove, green emitting luminescent partricles as-prepared in the examples hereabove, and red emitting luminescent partricles as-prepared in the examples hereabove were dispersed separately in silicone and successively deposited onto an optically transparent rotating wheel with a ring shape, such that the film of luminescent particles is around 50-150 µm in thickness and were equally distributed in three zones along the ring to obtain one zone coated with green emitting luminescent particles, one zone coated with blue emitting luminescent particles and one zone coated with red emitting luminescent particles. The rotating wheel was then annealed at 150°C for 2 hours before it was introduced in the display apparatus described in the invention, wherein a UV laser source was used as excitation source. The resulting lights were blue, green and red depending on the zone illuminated with the UV light form the laser source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### Example 31: Color conversion layer preparation

Green emitting core-shell CdSeS/CdZnS nanoplatelets and red emitting core-shell CdSe/CdZnS nanoplatelets were dispersed separately in silicone and successively deposited onto an optically transparent rotating wheel with a ring shape, such that the film of luminescent particles is around 50-150 µm in thickness and were equally distributed in three zones along the ring, to obtain one zone not coated, one zone coated with green emitting core-shell CdSe/CdZnS nanoplatelets and one zone coated with red emitting core-shell CdSe/CdZnS nanoplatelets. The rotating wheel was then annealed at 150°C for 2 hours before it was introduced in the display apparatus described in the invention, where a blue laser source was used as excitation source. The resulting lights were blue, green and red depending on the zone illuminated with the blue light form the laser source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### Example 32: Color conversion layer preparation

Green emitting luminescent partricles as-prepared in the examples hereabove, and red emitting luminescent partricles as-prepared in the examples hereabove were dispersed separately in a zinc oxide matrix and successively deposited onto an optically transparent rotating wheel with a ring shape, such that the film of luminescent particles is around 50-150 µm in thickness and were equally distributed in three zones along the ring, to obtain one zone not coated, one zone coated with green emitting luminescent particles and one zone coated with red emitting luminescent particles. The rotating wheel was then annealed at 150°C for 2 hours before it was introduced in the display apparatus described in the invention, where a blue laser source was used as excitation source. The resulting lights were blue, green and red depending on the zone illuminated with the blue light form the laser source.

The same procedure was carried out by replacing ZnO with a resin, silicone, MgO, PMMA, Polystyrene, Al₂O₃, TiO₂, HfO₂ or ZrO₂, or a mixture thereof.

The same procedure was carried out with luminescent particles prepared in the examples hereabove.

### Example 33: Color conversion layer preparation

Green emitting luminescent partricles as-prepared in the examples hereabove, and red emitting luminescent partricles as-prepared in the examples hereabove were dispersed separately in a resin matrix and successively deposited onto an optically transparent rotating wheel with a ring shape, such that the film of luminescent particles is around 50-150 µm in thickness and were equally distributed in three zones along the ring, to obtain one zone not coated, one zone coated with green emitting luminescent particles and one zone coated with red emitting luminescent particles. The rotating wheel was then annealed at 150°C for 2 hours before it was introduced in the display apparatus described in the invention, where a blue laser source was used as excitation source. The resulting lights were blue, green and red depending on the zone illuminated with the blue light form the laser source.

The same procedure was carried out by replacing the resin with silicone, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### Example 34: Color conversion layer preparation

Green emitting luminescent partricles as-prepared in the examples hereabove, yellow emitting luminescent partricles as-prepared in the examples hereabove, orange emitting luminescent partricles as-prepared in the examples hereabove, and red emitting luminescent partricles as-prepared in the examples hereabove were dispersed separately in silicone and deposited onto an optically transparent rotating wheel with a ring shape, such that the film of luminescent particles is around 50-150 µm in thickness and wereequally distributed in five zones along the ring, to obtain one zone not coated, one zone coated with green emitting luminescent particles, one zone coated with yellow emitting luminescent particles, one zone coated with orange emitting luminescent particles and one zone coated with red emitting luminescent particles. The rotating wheel was then annealed at 150°C for 2 hours before it was introduced in the display apparatus described in the invention, where a blue laser source was used as excitation source. The resulting lights were blue, green, yellow, orange and red depending on the zone illuminated with the blue light form the laser source.

The same procedure was carried out by replacing silicone with a resin, ZnO, MgO, PMMA, Polystyrene, Al₂O₃, TiO₂, HfO₂ or ZrO₂, or a mixture thereof.

The same procedure was carried out with luminescent particles prepared in the examples hereabove.

### REFERENCES

1 - Luminescent particle
11 - First material
12 - Core of the luminescent particle
13 - Shell of the luminescent particle
14 - Inorganic material
2 -Particle
21 - Second material
22 - Core of the particle 2
23 - Shell of the particle 2
3 - Nanoparticle
31 - Spherical Nanoparticle
32 - 2D nanoparticle
33 - Core of a nanoparticle
34 - First shell of a nanoparticle
35 - Second shell of a nanoparticle
36 - Insulator shell of a nanoparticle
37 - Crown of a nanoparticle
4 - LED support
5 - LED chip
6 - Microsized LED
61 - Display apparatus
6111 - Light source
61111 - Possible colored light paths
6112 - Laser source
61121 - Laser path
61122 - Possible laser path
6121 - Glass substrate
6122 - Bottom substrate
6123 - Solid support
6131 - Layer of liquid crystal material
6132 - Active matrix
6141 -Polarizer
6142 - Optical enhancement film
6143 - Directing optical system
62 - Illumination source
621 - Light guide
622 - Space
623 - Reflector
624 - Substrate
625 - Color Filter
63 - Rotating wheel comprising at least a zone comprising a color conversion layer
631 - Possible light path of primary light from the light source
632 - Possible light paths of secondary or primary light
634 - Optical component
635 - Modulating optical system
636 - Possible path of the formed image
637 - Screen
638 - Digital micromirror device
6381 - Microscopic mirror of the digital micromirror device
6382 - Microscopic mirror of the digital micromirror device free of light emitting material, empty or optically transparent
6383 - Support of a microscopic mirror
6391 - Wavelength splitter system
6392 - Wavelength combiner system
6384 - Mirror
7 - Light emitting material
71 - Host material
72 - Surrounding medium
73 - Color conversion layer
8 - Bead
81 - Third material
9 - Dense particle
d - Sub-pixel pitch
D - Pixel pitch
G - Green secondary light
R - Red secondary light

## Claims

1. A luminescent particle (1) comprising a first material (11),
wherein the luminescent particle (1) comprises a plurality of particles (2) comprising a second material (21) and at least one nanoparticle (3) dispersed in said second material (21); wherein the first material (11) and the second material (21) have a bandgap superior or equal to 3 eV, wherein the plurality of particles (2) is dispersed in the first material (11), wherein the first material (11) and the second material (21) are selected from the group consisting of silicon oxide, aluminium oxide, titanium oxide, iron oxide, calcium oxide, magnesium oxide, zinc oxide, tin oxide, beryllium oxide, zirconium oxide, niobium oxide, cerium oxide, indium oxide, scandium oxide, sodium oxide, barium oxide, potassium oxide, tellurium oxide, manganese oxide, boron oxide, germanium oxide, osmium oxide, rhenium oxide, arsenic oxide, tantalum oxide, lithium oxide, strontium oxide, yttrium oxide, hafnium oxide, molybdenum oxide, technetium oxide, rhodium oxide, cobalt oxide, gallium oxide, indium oxide, antimony oxide, polonium oxide, selenium oxide, cesium oxide, lanthanum oxide, praseodymium oxide, neodymium oxide, samarium oxide, europium oxide, terbium oxide, dysprosium oxide, erbium oxide, holmium oxide, thulium oxide, ytterbium oxide, lutetium oxide, gadolinium oxide, silicon carbide SiC, aluminium nitride AlN, gallium nitride GaN, boron nitride BN, mixed oxides, mixed oxides thereof, or a mixture thereof, wherein the at least one nanoparticle (3) is a luminescent nanoparticle, and wherein the loading charge of particles (2) in said luminescent particle (1) is at least 10%, said loading charge being the mass ratio between the mass of particles (2) comprised in a luminescent particle (1) and the mass of said luminescent particle (1).

2. The luminescent particle (1) according to claim **1,** wherein the first material (11) prevents the diffusion of outer molecular species or fluids (liquid or gas) into said first material (11).

3. The luminescent particle (1) according to claim **1** or **2,** wherein the first material (11) has a density ranging from 1 g/cm³ to 10 g/cm³.

4. The luminescent particle (1) according to any one of claims **1** to **3,** wherein the first material (11) has a density superior or equal to the density of the second material (21).

5. The luminescent particle (1) according to any one of claims **1** to **4,** wherein the first material (11) has a thermal conductivity at standard conditions of at least 0.1 W/(m.K).

6. The luminescent particle (1) according to any one of claims **1** to **5,** wherein the at least one nanoparticle (3) is a semiconductor nanocrystal.

7. The luminescent particle (1) according to claim **6,** wherein the semiconductor nanocrystal comprises a core comprising a material of formula MₓN_{y}E_{z}A_{w}, wherein:
M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and
x, y, z and w are independently a decimal number from 0 to 5; x, y, z and w are not simultaneously equal to 0; x and y are not simultaneously equal to 0; z and w may not be simultaneously equal to 0.

8. The luminescent particle (1) according to claim **6** or **7,** wherein the semiconductor nanocrystal comprises at least one shell comprising a material of formula MₓN_{y}E_{z}A_{w}, wherein:
M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof;
E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and
x, y, z and w are independently a decimal number from 0 to 5; x, y, z and w are not simultaneously equal to 0; x and y are not simultaneously equal to 0; z and w may not be simultaneously equal to 0.

9. The luminescent particle (1) according to any one of claims **6** or **7,** wherein the semiconductor nanocrystals comprise at least one crown (37) comprising a material of formula MₓN_{y}E_{z}A_{w}, wherein: M is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; N is selected from the group consisting of Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs or a mixture thereof; E is selected from the group consisting of O, S, Se, Te, C, N, P, As, Sb, F, Cl, Br, I, or a mixture thereof; A is selected from the group consisting of O, S, Se, Te, C, N, P, As, Sb, F, Cl, Br, I, or a mixture thereof; and x, y, z and w are independently a decimal number from 0 to 5; x, y, z and w are not simultaneously equal to 0; x and y are not simultaneously equal to 0; z and w may not be simultaneously equal to 0.

10. The luminescent particle (1) according to any one of claims **6** to **9,** wherein the semiconductor nanocrystal is a semiconductor nanoplatelet.

11. A light emitting material comprising at least one host material and at least one luminescent particle (1) according to any one of claims **1** to **10,** wherein said at least one luminescent particle (1) is dispersed in the at least one host material.

12. The light emitting material according to claim **11,** wherein the host material comprises an inorganic material, a polymer such as a co-polymer, a block co-polymer, or a silicone-based polymer, a resin such as an epoxy resin or a mixture thereof.

13. The light emitting material according to claim **11** or **12,** wherein the host material has a thermal conductivity at standard conditions of at least 0.1 W/(m.K).

14. A support supporting at least one luminescent particle (1) according to any one of claims **1** to **10** or a light emitting material according to any one of claims **11** to **13.**

15. The support according to claim **14,** wherein the support is a LED chip or microsized LED.

16. An optoelectronic device comprising at least one luminescent particle (1) according to any one of claims **1** to **10** or a light emitting material according to any one of claims **11** to **13.**

## Patentansprüche

1. Lumineszierendes Partikel (1), das ein erstes Material (11) umfasst,
wobei das lumineszierende Partikel (1) eine Vielzahl von Partikeln (2) umfasst, die ein zweites Material (21) und mindestens ein Nanopartikel (3) umfassen, das in dem zweiten Material (21) dispergiert ist; wobei das erste Material (11) und das zweite Material (21) eine Bandlücke von größer oder gleich 3 eV aufweisen, wobei die Vielzahl von Partikeln (2) in dem ersten Material (11) dispergiert ist, wobei das erste Material (11) und das zweite Material (21) ausgewählt sind aus der Gruppe bestehend aus Siliziumoxid, Aluminiumoxid, Titanoxid, Eisenoxid, Calciumoxid, Magnesiumoxid, Zinkoxid, Zinnoxid, Berylliumoxid, Zirkoniumoxid, Niobiumoxid, Ceroxid, Iridiumoxid, Scandiumoxid, Natriumoxid, Bariumoxid, Kaliumoxid, Telluroxid, Manganoxid, Boroxid, Germaniumoxid, Osmiumoxid, Rheniumoxid, Arsenoxid, Tantaloxid, Lithiumoxid, Strontiumoxid, Yttriumoxid, Hafniumoxid, Molybdänoxid, Technetiumoxid, Rhodiumoxid, Cobaltoxid, Galliumoxid, Indiumoxid, Antimonoxid, Poloniumoxid, Selenoxid, Cäsiumoxid, Lanthanoxid, Praseodymoxid, Neodymoxid, Samariumoxid, Europiumoxid, Terbiumoxid, Dysprosiumoxid, Erbiumoxid, Holmiumoxid, Thuliumoxid, Ytterbiumoxid, Lutetiumoxid, Gadoliniumoxid, Siliziumcarbid SiC, Aluminiumnitrid AlN, Galliumnitrid GaN, Bornitrid BN, Mischoxiden, Mischoxiden davon, oder einer Mischung davon, wobei das mindestens eine Nanopartikel (3) ein lumineszierendes Nanopartikel ist, und wobei die Beladungslast an Partikeln (2) in dem lumineszierenden Partikel (1) mindestens 10 % beträgt, wobei es sich bei der Beladungslast um das Massenverhältnis zwischen der Masse von Partikeln (2), die in einem lumineszierenden Partikel (1) enthalten sind, und der Masse des lumineszierenden Partikels (1) handelt.

2. Lumineszierendes Partikel (1) nach Anspruch **1,** wobei das erste Material (11) die Diffusion von äußeren molekularen Spezies oder Fluiden (Flüssigkeit oder Gas) in das erste Material (11) verhindert.

3. Lumineszierendes Partikel (1) nach Anspruch **1** oder **2,** wobei das erste Material (11) eine Dichte im Bereich von 1 g/cm³ bis 10 g/cm³ aufweist.

4. Lumineszierendes Partikel (1) nach einem der Ansprüche **1** bis **3,** wobei das erste Material (11) eine Dichte von größer oder gleich der Dichte des zweiten Materials (21) aufweist.

5. Lumineszierendes Partikel (1) nach einem der Ansprüche **1** bis **4,** wobei das erste Material (11) eine Wärmeleitfähigkeit bei Standardbedingungen von mindestens 0,1 W/(m.K) aufweist.

6. Lumineszierendes Partikel (1) nach einem der Ansprüche **1** bis **5,** wobei das mindestens eine Nanopartikel (3) ein Halbleiter-Nanokristall ist.

7. Lumineszierendes Partikel (1) nach Anspruch **6,** wobei der Halbleiter-Nanokristall einen Kern umfasst, der ein Material der Formel MₓN_{y}E_{z}A_{w} umfasst, wobei:
M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
E ausgewählt ist aus der Gruppe bestehend aus O, S, Se, Te, C, N, P, As, Sb, F, Cl, Br, I, oder einer Mischung davon; A ausgewählt ist aus der Gruppe bestehend aus O, S, Se, Te, C, N, P, As, Sb, F, Cl, Br, I, oder einer Mischung davon; und
x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein können.

8. Lumineszierendes Partikel (1) nach Anspruch **6** oder **7,** wobei der Halbleiter-Nanokristall mindestens eine Schale umfasst, die ein Material der Formel MₓN_{y}E_{z}A_{w} umfasst, wobei:
M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon;
E ausgewählt ist aus der Gruppe bestehend aus O, S, Se, Te, C, N, P, As, Sb, F, Cl, Br, I, oder einer Mischung davon; A ausgewählt ist aus der Gruppe bestehend aus O, S, Se, Te, C, N, P, As, Sb, F, Cl, Br, I, oder einer Mischung davon; und
x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein können.

9. Lumineszierendes Partikel (1) nach einem der Ansprüche **6** oder **7,** wobei die Halbleiter-Nanokristalle mindestens einen Kranz (37) umfassen, der ein Material der Formel MₓN_{y}E_{z}A_{w} umfasst, wobei: M ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon; N ausgewählt ist aus der Gruppe bestehend aus Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs, oder einer Mischung davon; E ausgewählt ist aus der Gruppe bestehend aus O, S, Se, Te, C, N, P, As, Sb, F, Cl, Br, I, oder einer Mischung davon; A ausgewählt ist aus der Gruppe bestehend aus O, S, Se, Te, C, N, P, As, Sb, F, Cl, Br, I, oder einer Mischung davon; und x, y, z und w unabhängig eine Dezimalzahl von 0 bis 5 sind; x, y, z und w nicht gleichzeitig gleich 0 sind; x und y nicht gleichzeitig gleich 0 sind; z und w nicht gleichzeitig gleich 0 sein können.

10. Lumineszierendes Partikel (1) nach einem der Ansprüche **6** bis **9,** wobei der Halbleiter-Nanokristall ein Halbleiter-Nanoplättchen ist.

11. Lichtemittierendes Material, das mindestens ein Wirtsmaterial und mindestens ein lumineszierendes Partikel (1) nach einem der Ansprüche **1** bis **10** umfasst, wobei das mindestens eine lumineszierende Partikel (1) in dem mindestens einen Wirtsmaterial dispergiert ist.

12. Lichtemittierendes Material nach Anspruch **11,** wobei das Wirtsmaterial ein anorganisches Material, ein Polymer wie etwa ein Copolymer, ein Block-Copolymer, oder ein Polymer auf Silicium-Basis, ein Harz wie etwa ein Epoxidharz, oder eine Mischung davon umfasst.

13. Lichtemittierendes Material nach Anspruch **11** oder **12,** wobei das Wirtsmaterial eine Wärmeleitfähigkeit bei Standardbedingungen von mindestens 0,1 W/(m.K) aufweist.

14. Träger, der mindestens ein lumineszierendes Partikel (1) nach einem der Ansprüche **1** bis **10** oder ein lichtemittierendes Material nach einem der Ansprüche **11** bis **13** trägt.

15. Träger nach Anspruch **14,** wobei es sich bei dem Träger um einen LED-Chip oder eine Mikro-LED handelt.

16. Optoelektronische Vorrichtung, die mindestens ein lumineszierendes Partikel (1) nach einem der Ansprüche **1** bis **10** oder ein lichtemittierendes Material nach einem der Ansprüche **11** bis **13** umfasst.

## Revendications

1. Particule luminescente (1) comprenant un premier matériau (11),
dans lequel la particule luminescente (1) comprend une pluralité de particules (2) comprenant un second matériau (21) et au moins une nanoparticule (3) dispersée dans ledit second matériau (21) ; dans lequel le premier matériau (11) et le deuxième matériau (21) ont une bande interdite supérieure ou égale à 3 eV, dans lequel la particule luminescente (1) comprenant une pluralité de particules (2) comprenant un second matériau (21) et au moins une nanoparticule (3) dispersée dans ledit second matériau (21); le premier matériau (11) et le second matériau (21) ayant une bande interdite supérieure ou égale à 3 eV, la pluralité de particules (2) étant dispersée dans le premier matériau (11), dans lequel le premier matériau (11) et le second matériau (21) sont choisis dans le groupe constitué de l'oxyde de silicium, l'oxyde d'aluminium, l'oxyde de titane, l'oxyde de fer, l'oxyde de calcium, l'oxyde de magnésium, l'oxyde de zinc, l'oxyde d'étain, l'oxyde de béryllium, l'oxyde de zirconium, l'oxyde de niobium, l'oxyde de cérium, l'oxyde d'iridium, l'oxyde de scandium, l'oxyde de sodium, l'oxyde de baryum, l'oxyde de rhénium, l'oxyde d'arsenic, l'oxyde de tantale, l'oxyde de lithium, l'oxyde de strontium, l'oxyde d'yttrium, l'oxyde d'indium, l'oxyde de molybdène, l'oxyde de technétium, l'oxyde de rhodium, l'oxyde de cobalt, l'oxyde de gallium, l'oxyde d'indium, l'oxyde d'antimoine, l'oxyde de polonium, l'oxyde de sélénium, l'oxyde de lanthane, l'oxyde de praséodyme, l'oxyde de néodyme, l'oxyde de samarium, l'oxyde d'europium, l'oxyde de terbium, l'oxyde de dysprosium, l'oxyde d'erbium, l'oxyde d'holmium, l'oxyde de thulium, l'oxyde d'ytterbium, l'oxyde de lutétium, l'oxyde de gadolinium, le carbure de silicium SiC, le nitrure d'aluminium AlN, le nitrure de gallium GaN, le nitrure de bore BN, les oxydes mixtes, les oxydes mixtes de ceux-ci, ou un mélange de ceux-ci, dans lequel au moins une nanoparticule (3) est une nanoparticule luminescente, et dans lequel le taux de charge de particules (2) dans ladite particule luminescente (1) étant d'au moins 10 %, ledit taux de charge étant le rapport de masse entre la masse de particules (2) comprise dans une particule luminescente (1) et la masse de ladite particule luminescente (1).

2. Particule luminescente (1) selon la revendication **1,** dans laquelle le premier matériau (11) empêche la diffusion d'espèces moléculaires externes ou de fluides (liquides ou gaz) dans ledit premier matériau (11).

3. Particule luminescente (1) selon la revendication **1** ou **2,** dans laquelle le premier matériau (11) a une densité allant de 1 g/cm³ à 10 g/cm³.

4. Particule luminescente (1) selon l'une quelconque des revendications **1** à **3,** dans laquelle le premier matériau (11) a une densité supérieure ou égale à la densité du second matériau (21).

5. Particule luminescente (1) selon l'une quelconque des revendications **1** à **4,** dans laquelle le premier matériau (11) a une conductivité thermique dans des conditions standard d'au moins 0,1 W/(m.K).

6. Particule luminescente (1) selon l'une quelconque des revendications **1** à **5,** dans laquelle au moins une nanoparticule (3) est un nanocristal semi-conducteur.

7. Particule luminescente (1) selon la revendication **6,** dans laquelle le nanocristal semi-conducteur comprend un coeur comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci;
E est choisi dans le groupe constitué de O, S, Se, Te, C, N, P, As, Sb, F, Cl, Br, I, ou un mélange de ceux-ci ; A est choisi dans le groupe constitué de O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ; z et w ne peuvent pas être simultanément égaux à 0.

8. Particule luminescente (1) selon la revendication **6** ou **7,** dans laquelle le nanocristal semi-conducteur comprend au moins une coque comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
E est choisi dans le groupe constitué de O, S, Se, Te, C, N, P, As, Sb, F, Cl, Br, I, ou un mélange de ceux-ci ; A est choisi dans le groupe constitué de O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ; z et w ne peuvent pas être simultanément égaux à 0.

9. Particule luminescente (1) selon l'une quelconque des revendications **6** ou **7,** dans laquelle les nanocristaux semi-conducteurs comprennent au moins une couronne (37) comprenant un matériau de formule MₓN_{y}E_{z}A_{w}, dans laquelle :
M est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
N est choisi dans le groupe constitué de Zn, Cd, Hg, Cu, Ag, Au, Ni, Pd, Pt, Co, Fe, Ru, Os, Mn, Tc, Re, Cr, Mo, W, V, Nd, Ta, Ti, Zr, Hf, Be, Mg, Ca, Sr, Ba, Al, Ga, In, Tl, Si, Ge, Sn, Pb, As, Sb, Bi, Sc, Y, La, Ce, Pr, Nd, Sm, Eu, Gd, Tb, Dy, Ho, Er, Tm, Yb, Cs ou un mélange de ceux-ci ;
E est choisi dans le groupe constitué de O, S, Se, Te, C, N, P, As, Sb, F, Cl, Br, I, ou un mélange de ceux-ci ; A est choisi dans le groupe constitué de O, S, Se, Te, C, N, P, As, Sb, F, Cl, Br, I, ou un mélange de ceux-ci ; et
x, y, z et w sont indépendamment un nombre décimal de 0 à 5 ; x, y, z et w ne sont pas simultanément égaux à 0 ; x et y ne sont pas simultanément égaux à 0 ; z et w ne peuvent pas être simultanément égaux à 0.

10. La particule luminescente (1) selon l'une quelconque des revendications **6** à **9,** dans laquelle le nanocristal semi-conducteur est une nanoplaquette semi-conductrice.

11. Un matériau émetteur de lumière comprenant au moins un matériau hôte et au moins une particule luminescente (1) selon l'une quelconque des revendications **1** à **10,** dans lequel au moins une particule luminescente (1) est dispersée dans au moins un matériau hôte.

12. Le matériau émetteur de lumière selon la revendication **11,** dans lequel le matériau hôte comprend un matériau inorganique, un polymère tel qu'un copolymère, un copolymère bloc ou un polymère à base de silicone, une résine telle qu'une résine époxy ou un mélange de ceux-ci.

13. Matériau émetteur de lumière selon la revendication **11** ou **12,** dans lequel le matériau hôte a une conductivité thermique dans des conditions standard d'au moins 0,1 W/(m.K).

14. Support supportant au moins une particule luminescente (1) selon l'une quelconque des revendications **1** à **10** ou un matériau émetteur de lumière selon l'une quelconque des revendications **11** à **13.**

15. Support selon la revendication **14,** dans lequel le support est une puce DEL ou une DEL microdimensionnée.

16. Dispositif optoélectronique comprenant au moins une particule luminescente (1) selon l'une quelconque des revendications **1** à **10** ou un matériau émetteur de lumière selon l'une quelconque des revendications **11** à **13.**
